# EUROPEAN PATENT APPLICATION

(11) **EP 4 814 932 A1**
(43) Date of publication of application: **30.09.2026**
(21) Application number: 24953507.1
(22) Date of filing: 23.09.2024
(51) Int. Cl.: G09G 3/20

(54) **DISPLAY PANEL AND DISPLAY APPARATUS**

(30) Priority: 09.09.2024 CN 202411259154
(71) Applicant: Wuhan Tianma Microelectronics Co., Ltd., Wuhan, Hubei 430205 (CN)
(72) Inventor: DAI, Hao, Wuhan, Hubei 430205 (CN); ZHANG, Dian, Wuhan, Hubei 430205 (CN); MA, Yangzhao, Wuhan, Hubei 430205 (CN); DUN, Dongliang, Wuhan, Hubei 430205 (CN)
(74) Representative: Völkl Siebenson Patentanwälte - Partnerschaft mbB
(86) International application number: PCT/CN2024/120323
(87) International publication number: WO 2026/051121

(57) **Abstract**

A display panel and a display apparatus. The display panel comprises a plurality of data signal lines (Data), a plurality of first pixel circuit columns (10c) and a plurality of first light-emitting element columns (20c), wherein a plurality of first pixel circuits (10), which are arranged in a first direction (X), are electrically connected to the same data signal line (Data); and the plurality of first pixel circuit columns (10c) comprise the plurality of first pixel circuits (10), which are arranged in the first direction (X); the plurality of first light-emitting element columns (20c) comprise light-emitting elements (20), which are arranged in the first direction (X) and emit light of different colors; two types of light-emitting elements (20), which emit light of different colors, are respectively electrically connected to first pixel circuits (10) located in different first pixel circuit columns (10c); and a plurality of first pixel circuits (10) in the same first pixel circuit column (10c) are electrically connected to a plurality of light-emitting elements (20) of the same color.

## Description

The present application claims priority to Chinese Patent Application No. 202411259154.2 filed with the China National Intellectual Property Administration (CNIPA) on Sep. 9, 2024, the disclosure of which is incorporated herein by reference in its entirety.

### TECHNICAL FIELD

Embodiments of the present application relate to the field of display technology, for example, to a display panel and a display device.

### BACKGROUND

To improve the display effect of a display panel, in the related art, there exists a case where sub-pixels of different colors are arranged in a sub-pixel column, and the sub-pixels of different colors in the sub-pixel column receive data signals transmitted by a same data signal line. This arrangement increases the power consumption of the display controller in the display panel.

### SUMMARY

In view of the above issues, the present application provides a display panel and a display device to reduce the power consumption of the display controller and the display panel while ensuring the display effect.

In a first aspect, embodiments of the present application provide a display panel. The display panel includes multiple data signal lines, multiple first pixel circuits, multiple first pixel circuit columns, and multiple first light-emitting element columns. The multiple data signal lines extend along a first direction and are arranged along a second direction, where the first direction intersects the second direction. Multiple first pixel circuits arranged along the first direction are electrically connected to a same one of the multiple data signal lines. The first pixel circuit column includes multiple first pixel circuits arranged along the first direction. The first light-emitting element column includes two types of light-emitting elements with different emission colors arranged along the first direction, and the two types of light-emitting elements with different emission colors are electrically connected to first pixel circuits located in different first pixel circuit columns, respectively. The multiple first pixel circuits in the same first pixel circuit column are electrically connected to multiple light-emitting elements of the same emission color.

In a second aspect, embodiments of the present application provide a display device. The display device includes the display panel described in the first aspect of the present application.

### BRIEF DESCRIPTION OF DRAWINGS

FIG. 1 is a diagram illustrating the structure of a display panel in the related art according to an embodiment of the present application.
FIG. 2 is a timing diagram of a data signal line in the display panel shown in FIG. 1.
FIG. 3 is a structural diagram of a display panel according to an embodiment of the present application.
FIG. 4 is a structural diagram illustrating some layers of the display panel shown in FIG. 3.
FIG. 5 is a timing diagram of a data signal line in the display panel shown in FIG. 3.
FIG. 6 is a schematic circuit diagram of a first pixel circuit according to an embodiment of the present application.
FIG. 7 is a driving timing diagram of the embodiment shown in FIG. 6.
FIG. 8 is a partially enlarged structural diagram of the display panel shown in FIG. 4.
FIG. 9 is a diagram illustrating the structure of another display panel according to an embodiment of the present application.
FIG. 10 is a sectional structural diagram along the A-A' direction of FIG. 9.
FIG. 11 is a diagram illustrating the structure of another display panel according to an embodiment of the present application.
FIG. 12 is a partially enlarged structural diagram of the display panel shown in FIG. 11.
FIG. 13 is a diagram illustrating the structure of yet another display panel according to an embodiment of the present application.
FIG. 14 is a partially enlarged structural diagram of the display panel shown in FIG. 13.
FIG. 15 is a diagram illustrating the structure of another display panel according to an embodiment of the present application.
FIG. 16 is a partially enlarged structural diagram of the display panel shown in FIG. 15.
FIG. 17 is a diagram illustrating the structure of yet another display panel according to an embodiment of the present application.
FIG. 18 is a diagram illustrating the structure of another display panel according to an embodiment of the present application.
FIG. 19 is a sectional structural diagram of a display panel according to an embodiment of the present application.
FIG. 20 is a diagram illustrating part of the structure of the display panel shown in FIG. 19.
FIG. 21 is a diagram illustrating another part of the structure of the display panel shown in FIG. 19.
FIG. 22 is a diagram illustrating another part of the structure of the display panel shown in FIG. 19.
FIG. 23 is a diagram illustrating another part of the structure of the display panel shown in FIG. 19.
FIG. 24 is a diagram illustrating another part of the structure of the display panel shown in FIG. 19.
FIG. 25 is a diagram illustrating another part of the structure of the display panel shown in FIG. 19.
FIG. 26 is a diagram illustrating another part of the structure of the display panel shown in FIG. 19.
FIG. 27 is a diagram illustrating another part of the structure of the display panel shown in FIG. 19.
FIG. 28 is a diagram illustrating another part of the structure of the display panel shown in FIG. 19.
FIG. 29 is a diagram illustrating the structure of yet another display panel according to an embodiment of the present application.
FIG. 30 is a sectional structural diagram of another display panel according to an embodiment of the present application.
FIG. 31 is a diagram illustrating part of the structure of the display panel shown in FIG. 30.
FIG. 32 is a diagram illustrating another part of the structure of the display panel shown in FIG. 30.
FIG. 33 is a diagram illustrating another part of the structure of the display panel shown in FIG. 30.
FIG. 34 is a diagram illustrating another part of the structure of the display panel shown in FIG. 30.
FIG. 35 is a diagram illustrating another part of the structure of the display panel shown in FIG. 30.
FIG. 36 is a diagram illustrating another part of the structure of the display panel shown in FIG. 30.
FIG. 37 is a diagram illustrating another part of the structure of the display panel shown in FIG. 30.
FIG. 38 is a diagram illustrating another part of the structure of the display panel shown in FIG. 30.
FIG. 39 is a diagram illustrating the structure of a seventh metal layer in a display panel according to an embodiment of the present application.
FIG. 40 is a diagram illustrating the structure of an eighth metal layer in a display panel according to an embodiment of the present application.
FIG. 41 is a diagram illustrating the structure of an anode layer in a display panel according to an embodiment of the present application.
FIG. 42 is a diagram illustrating some layers of a stacked structure of a display panel according to an embodiment of the present application.
FIG. 43 is a diagram illustrating the structure of an anode of a light-emitting element according to an embodiment of the present application.
FIG. 44 is a diagram illustrating the structure of an anode of another light-emitting element according to an embodiment of the present application.
FIG. 45 is a sectional structural diagram of another display panel according to an embodiment of the present application.
FIG. 46 is a sectional structural diagram of yet another display panel according to an embodiment of the present application.
FIG. 47 is a diagram illustrating the structure of another display panel according to an embodiment of the present application.
FIG. 48 is a diagram illustrating the structure of a display device according to an embodiment of the present application.

### DETAILED DESCRIPTION

The present application is described below in conjunction with drawings and embodiments. It is to be understood that the embodiments set forth below are intended to illustrate and not to limit the present application. For ease of description, only part, not all, of structures related to the present application are illustrated in the drawings.

It should be noted that terms such as "having", "comprising", and "including" described in the present application are open-ended. That is, when a module is described as "having", "comprising", and "including" a first element, a second element, and/or a third element, it indicates that the module includes other elements in addition to the first element, the second element, and/or the third element. Additionally, ordinal numbers such as "first", "second", and "third" in the present application are not intended to limit the order but are used to distinguish between multiple parts. In the present application, when layer A and layer B are described as "disposed in the same layer", it means that layer A and layer B are made of the same material and by the same process.

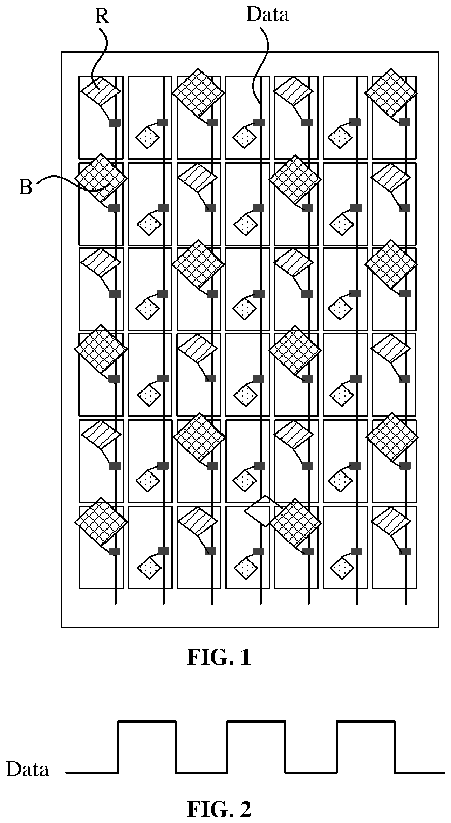

FIG. 1 is a diagram illustrating the structure of a display panel in the related art according to an embodiment of the present application. FIG. 2 is a timing diagram of a data signal line in the display panel shown in FIG. 1. With reference to FIG. 1, in the related art, some sub-pixel columns each include red sub-pixels R and blue sub-pixels B alternately arranged along the column direction, the pixel circuits corresponding to the red sub-pixels R and blue sub-pixels B in the same column are electrically connected to the same data signal line Data, and data signals are provided to the pixel circuits corresponding to the red sub-pixels R and blue sub-pixels B respectively by the same data signal line Data. With reference to FIG. 2, since the red sub-pixels R and blue sub-pixels B require data signals of different voltage levels, the voltage of the data signal on the data signal line Data needs to switch between two different voltage values. As shown in FIG. 2, when an image is displayed, such as a solid-color image of red, blue, or white, the data signal line Data has significant voltage fluctuations, leading to increased power consumption of the display controller (such as the driver chip).

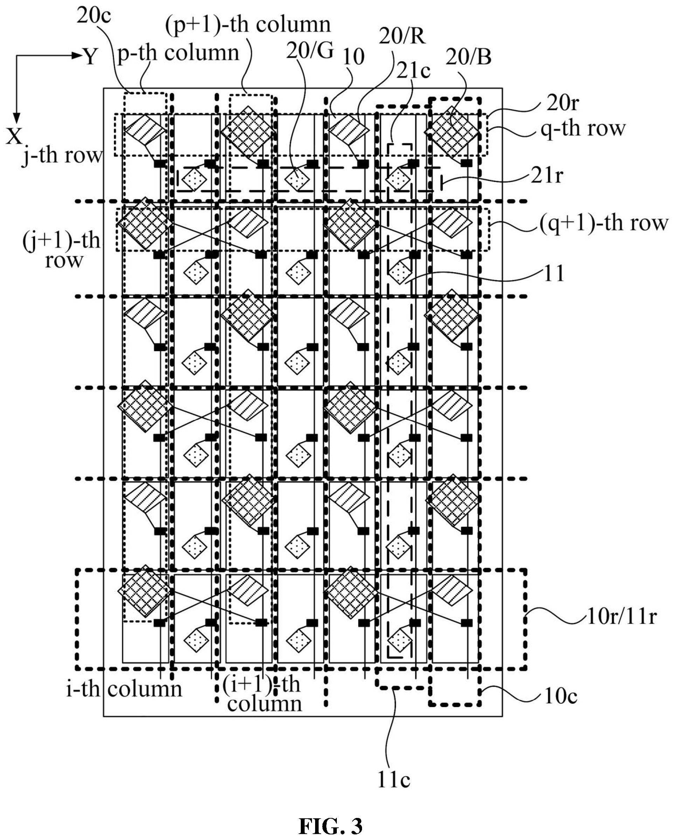

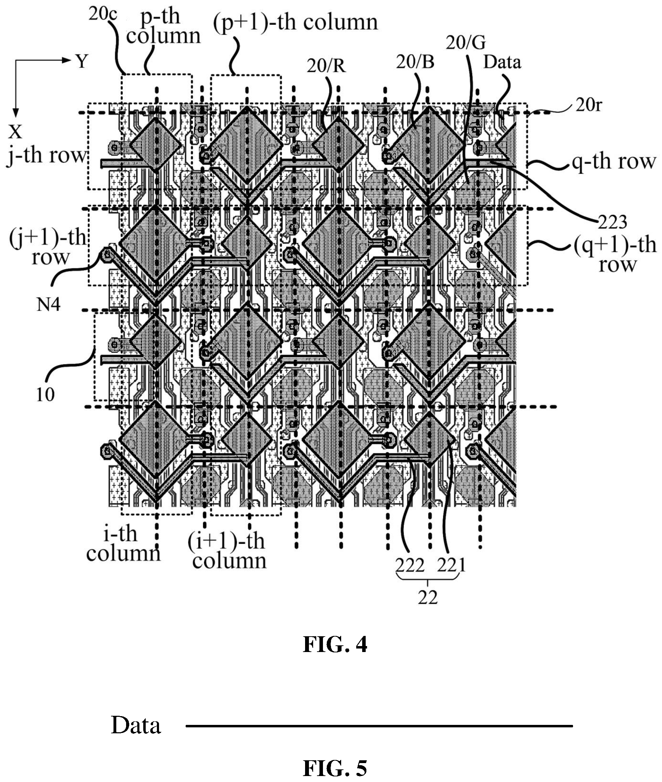

In view of the above disadvantages of the related art, the present application provides a display panel. FIG. 3 is a structural diagram of a display panel according to an embodiment of the present application. FIG. 4 is a structural diagram illustrating some layers of the display panel shown in FIG. 3. With reference to FIG. 3 and FIG. 4, the display panel may include multiple data signal lines Data, multiple first pixel circuits 10, multiple first pixel circuit columns 10c, and multiple first light-emitting element columns 20c. The multiple data signal lines Data extend along a first direction X and are arranged along a second direction Y, where the first direction X intersects the second direction Y. Multiple first pixel circuits 10 arranged along the first direction X are electrically connected to the same data signal line Data. The first pixel circuit column 10c includes multiple first pixel circuits 10 arranged along the first direction X. The first light-emitting element column 20c includes two types of light-emitting elements 20 with different emission colors arranged along the first direction X, and the two types of light-emitting elements 20 with different emission colors are electrically connected to first pixel circuits 10 in different first pixel circuit columns 10c, respectively. The multiple first pixel circuits 10 in the same first pixel circuit column 10c are electrically connected to multiple light-emitting elements 20 of the same emission color.

As shown in FIG. 3 and FIG. 4, the display panel may include multiple data signal lines Data, multiple pixel circuits, and multiple light-emitting elements 20. The multiple pixel circuits include multiple first pixel circuits 10. The multiple first pixel circuits 10 are arranged along the first direction X and the second direction Y to form an array. In FIG. 3, the first direction X may be the column direction, and the second direction Y may be the row direction, but the actual implementation is not limited thereto. In this embodiment, the first direction X is the column direction and the second direction Y is the row direction, for example. Multiple first pixel circuits 10 arranged along the first direction X form a first pixel circuit column 10c, and multiple first pixel circuit columns 10c are arranged along the second direction Y. The data signal line Data is electrically connected to the multiple first pixel circuits 10 arranged along the first direction X, that is, the data signal line Data is connected to the multiple first pixel circuits 10 in the same first pixel circuit column 10c, and the same data signal line Data transmits data signals to the multiple first pixel circuits 10 arranged along the first direction X. FIG. 3 is a schematic diagram of the electrical connections among the data signal lines Data, the first pixel circuits 10, and the light-emitting elements 20, rather than an actual wiring diagram. FIG. 3 shows that a data signal line Data connects to light-emitting elements 20 of a single color through a column of first pixel circuits 10.

With continued reference to FIG. 3 and FIG. 4, the pixel circuits are electrically connected to the light-emitting elements 20 to drive the light-emitting elements 20 to emit light, thereby achieving the display of the display panel. The multiple light-emitting elements 20 at least include light-emitting elements 20 of two colors. The light-emitting elements 20 may be organic light-emitting diodes. Multiple light-emitting elements 20 arranged along the first direction X form the first light-emitting element column 20c, and multiple first light-emitting element columns 20c are arranged along the second direction Y. The first light-emitting element column 20c includes at least light-emitting elements 20 of two colors, that is, the multiple light-emitting elements 20 arranged along the first direction X include light-emitting elements 20 of different colors. In FIG. 3, diamond-shaped patterns with different fill patterns represent light-emitting elements 20 of different colors. In embodiments of the present application, it is set forth that light-emitting elements 20 of different colors in the same first light-emitting element column 20c are electrically connected to first pixel circuits 10 in different first pixel circuit columns 10c, and the multiple first pixel circuits 10 in the same first pixel circuit column 10c are electrically connected to multiple light-emitting elements 20 of the same color. In other words, the first pixel circuits 10 in the same column connect to light-emitting elements 20 of the same color, and the light-emitting elements 20 connected to the first pixel circuits 10 in the same column are located in different first light-emitting element columns 20c. Along the thickness direction of the display panel, the first pixel circuit columns 10c may overlap with the first light-emitting element columns 20c, that is, the first pixel circuit columns 10c overlap with at least two types of light-emitting elements 20 of different emission colors.

With this arrangement, the multiple first pixel circuits 10 connected to the same data signal line Data are connected to the light-emitting elements 20 of the same color in different first light-emitting element columns 20c. The data signal line Data provides data signals to the multiple light-emitting elements 20 of the same color located in different first light-emitting element columns 20c through the multiple first pixel circuits 10 arranged along the first direction X.

FIG. 5 is a timing diagram of a data signal line in the display panel shown in FIG. 3. With reference to FIG. 3 to FIG. 5, since the same data signal line Data is connected to light-emitting elements 20 of the same color, the data signal line Data transmits data signals for light-emitting elements 20 of a single color. That is, the data signal line Data may only need to transmit a stable data signal, or in other words, the same data signal line Data does not need to provide data signals with varying voltage values, and no voltage switching issue for data signals exists on the data signal line Data. This resolves the issue of high power consumption of the display controller (such as the driver chip) in the related art, achieving the purpose of reducing the power consumption of the display controller and thereby reducing the overall power consumption of the display panel. According to tests, the power consumption of the display controller can be reduced by approximately 25% by using the solution in the embodiments of the present application. Additionally, since the same data signal line Data does not need to transmit varying data signals, the issue of coupling between switching data signals and other signals can be avoided, ensuring the stability of signal transmission within the display panel.

Exemplarily, the first light-emitting element column 20c may include red light-emitting elements and blue light-emitting elements arranged along the first direction X. The red light-emitting elements and blue light-emitting elements arranged along the first direction X are connected to first pixel circuits 10 in different columns, or in other words, the red light-emitting elements and blue light-emitting elements connected to the first pixel circuits 10 in the same column are located in different first light-emitting element columns 20c. The arrangement of light-emitting elements 20 of different colors is more uniform, which helps improve color deviation and aliasing phenomena, enhancing the display effect of the display panel.

In the embodiment shown in FIG. 3 and FIG. 4, the two types of light-emitting elements 20 with different emission colors are electrically connected to first pixel circuits 10 in two first pixel circuit columns 10c, respectively. That is, multiple light-emitting elements 20 of one color in the same first light-emitting element column 20c are electrically connected to multiple first pixel circuits 10 in one first pixel circuit column 10c, and multiple light-emitting elements 20 of another color are electrically connected to multiple first pixel circuits 10 in another first pixel circuit column 10c, but the implementation is not limited thereto. In other embodiments, multiple light-emitting elements 20 of one color in the same first light-emitting element column 20c may be configured to be electrically connected to first pixel circuits 10 in two or more first pixel circuit columns 10c, and multiple light-emitting elements 20 of another color in the same first light-emitting element column 20c may be electrically connected to first pixel circuits 10 in another two or more first pixel circuit columns 10c, provided that the light-emitting elements 20 connected to the first pixel circuits 10 in the same column are of the same color, which is not limited in the embodiments of the present application.

It should be noted that in FIG. 3 and FIG. 4, the thicker dashed lines extending along the first direction may be understood as the approximate positions of the boundaries between two adjacent pixel circuit columns, and the thicker dashed lines extending along the second direction may be understood as the approximate positions of the boundaries between two adjacent pixel circuit rows.

The display panel according to the embodiments of the present application includes multiple data signal lines, multiple first pixel circuit columns, and multiple first light-emitting element columns. Multiple first pixel circuits arranged along the first direction are electrically connected to the same data signal line. Multiple first pixel circuit columns each include multiple first pixel circuits arranged along the first direction, and multiple first light-emitting element columns each include light-emitting elements of different emission colors arranged along the first direction. Two types of light-emitting elements with different emission colors are electrically connected to first pixel circuits in different first pixel circuit columns, and the multiple first pixel circuits in the same first pixel circuit column are electrically connected to multiple light-emitting elements of the same color. With the above solution, multiple first pixel circuits connected to the same data signal line are electrically connected to light-emitting elements of the same color in different first light-emitting element columns, and a data signal line may transmit only the data signals for light-emitting elements of a corresponding color. In this manner, the data signals transmitted on the data signal line are stable, and no voltage switching issue for data signals exists on the data signal line, thereby reducing the power consumption of the display controller and the display panel.

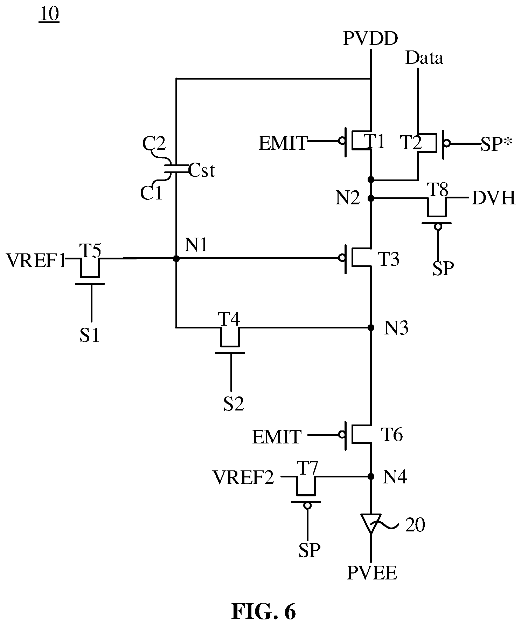

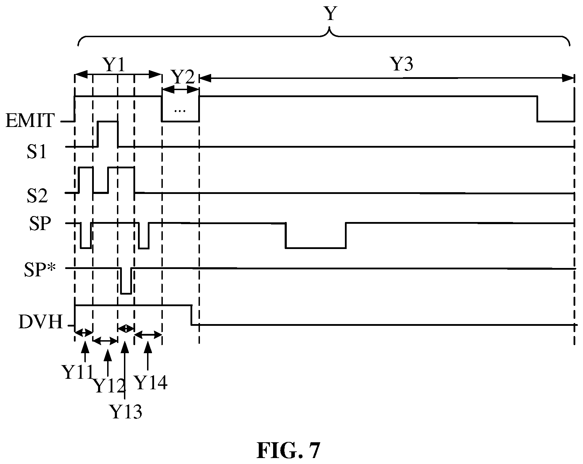

Additionally, in the embodiments of the present application, the connection between the light-emitting element in the first light-emitting element column 20c and the first pixel circuit 10 may refer to the connection between the light-emitting element in the first light-emitting element column 20c and a node of the first pixel circuit 10. FIG. 6 is a schematic circuit diagram of a first pixel circuit according to an embodiment of the present application. FIG. 7 is a driving timing diagram of the embodiment shown in FIG. 6. The configuration of the first pixel circuit 10 may vary. FIG. 6 uses an 8T1C pixel circuit as an example for illustration, where "T" represents a transistor and "C" represents a capacitor. Embodiments of the present application only use this as an example for illustration, and other pixel circuits, such as "6T1C" or "7T1C" pixel circuits, are within the scope of the technical solutions according to embodiments of the present application.

Exemplarily, as shown in FIG. 6 and FIG. 7, the pixel circuit may include a first light emission control transistor T1, a data writing transistor T2, a driving transistor T3, a threshold compensation transistor T4, an initialization transistor T5, a second light emission control transistor T6, a reset transistor T7, and a storage capacitor Cst. The pixel circuit in FIG. 6 also includes a bias transistor T8. For the operation of the pixel circuit, reference is made to FIG. 6 and FIG. 7 for illustration. A first scan signal line S1 may control the turn-on or turn-off of the initialization transistor T5 of the pixel circuit and reset the gate potential of the driving transistor T3 when the initialization transistor T5 is turned on, that is, S1 transmits the initialization signal from an initialization signal line VREF1 to the initialization transistor T5 and resets a connection node (first node N1) of the driving transistor T3, the initialization transistor T5, the threshold compensation transistor T4, and the storage capacitor Cst. A third scan signal line SP* controls the turn-on and turn-off of the data writing transistor T2 of the pixel circuit and writes the data signal from the data signal line Data to the gate of the driving transistor T3 when the data writing transistor T2 is turned on. A second scan signal line S2 may control the turn-on and turn-off of the threshold compensation transistor T4 and compensate for the threshold voltage of the driving transistor T3 when the threshold compensation transistor T4 is turned on. In addition, a fourth scan signal line SP controls the turn-on and turn-off of the reset transistor T7 and resets the anode of the light-emitting element connected to the pixel circuit when the reset transistor T7 is turned on, that is, the fourth scan signal line SP transmits the reset signal from a reset signal line VREF2 to the anode of the light-emitting element. A light emission control signal line EMIT controls the turn-on and turn-off of the first light emission control transistor T1 and the second light emission control transistor T6, and when the first light emission control transistor T1 and the second light emission control transistor T6 are controlled to be turned on, the power signal from a power signal line PVDD is transmitted to the light-emitting element, thereby achieving the display and light emission of the light-emitting element. With reference to FIG. 6, the pixel circuit also includes a bias transistor T8, and the fourth scan signal line SP controls the turn-on and turn-off of the bias transistor T8 and performs bias adjustment on the driving transistor T3 when the bias transistor T8 is turned on, that is, the SP transmits the bias signal from a bias voltage signal line DVH to the bias transistor T8 and performs bias adjustment on a connection node (second node N2) of the driving transistor T3, the first light emission control transistor T1, and the data writing transistor T2, ensuring the operational stability of the driving transistor T3. It can be understood that the bias transistor T8 may also be electrically connected to a third node N3 (the connection node of the driving transistor T3, the second light emission control transistor T6, and the threshold compensation transistor T4); alternatively, the bias transistor T8 is electrically connected to both the second node N2 and the third node N3. The bias signal of the bias voltage signal line DVH includes an enabling level and a non-enabling level. The enabling level can turn on the bias transistor T8; the non-enabling level can turn off (or cut off) the bias transistor T8. By providing the bias transistor T8, the brightness of the first frame during display can be improved, preventing the brightness of the first frame from being too low, and thereby ensuring good consistency of the display effect of images. Additionally, in the case of low-frequency driving, leakage current is more pronounced. The bias transistor T8 is controlled to be turned on and is used for writing the bias voltage to the source and/or the drain of the driving transistor T3 so that the bias state of the driving transistor T3 can be maintained consistent with the bias state at the time of writing the data voltage. In this manner, the stability of the operational state of the driving transistor T3 is improved, low-frequency flicker is reduced, and the display effect of the display panel is enhanced.

Exemplarily, with continued reference to FIGS. 6 and 7, the initialization transistor T5 and the threshold compensation transistor T4 in the pixel circuit are N-type transistors and the remaining transistors are P-type transistors, for example. The enabling level can turn on a transistor. The non-enabling level can turn off (or cut off) a transistor. The non-enabling level of the light emission control signal EMIT is a high level, and the enabling level of EMIT is a low level. The enabling level of the signals transmitted by the first scan signal line S1 and the second scan signal line S2 is a high level, and the non-enabling level of the signals transmitted by S1 and S2 is a low level. The enabling level of the signals transmitted by the fourth scan signal line SP and the third scan signal line SP* is a low level, and the non-enabling level of the signals transmitted by SP and SP* is a high level. In a driving cycle Y of the pixel circuit, the gate signal transmitted by the light emission control signal line EMIT includes multiple non-enabling level phases and multiple enabling level phases, and the multiple non-enabling level phases and multiple enabling level phases are alternately arranged. When the light emission control signal line EMIT is at a non- enabling level, the first light emission control transistor T1 and the second light emission control transistor T6 are cut off, and when the light emission control signal line EMIT is at an enabling level, the first light emission control transistor T1 and the second light emission control transistor T6 are turned on.

The driving cycle Y of the pixel circuit includes a data writing phase Y1, a light emission phase Y2, and a light emission holding phase Y3, where the data writing phase Y1 includes one non-enabling level phase of the light emission control signal EMIT, the light emission phase Y2 includes one enabling level phase of the light emission control signal EMIT, and in the light emission holding phase Y3, the light emission control signal EMIT includes multiple non-enabling level phases and at least one enabling level phase (in FIG. 7, one enabling level phase is used as an example for description). In addition, in the data writing phase Y1 and the light emission phase Y2, the level of the bias voltage signal line DVH may be the same as or different from the level of the bias voltage signal line DVH in the light emission holding phase Y3 (as illustrated in FIG. 7).

The data writing phase Y1 includes a first bias adjustment phase Y11. In the first bias adjustment phase Y11, the signal transmitted by the fourth scan signal line SP includes at least one low-level period, and during this period, the signal transmitted by the second scan signal line S2 includes at least one high-level period. In other words, in the first bias adjustment phase Y11, at least the bias transistor T8 and the threshold compensation transistor T4 are turned on, and the bias signal of the bias voltage signal line DVH is transmitted to the driving transistor T3 through the bias transistor T8, and further transmitted to the gate of the driving transistor T3 through the threshold compensation transistor T4. That is, in the first bias adjustment phase Y11, the bias signal may perform bias adjustment on the first node N1, the second node N2, and the third node N3. The data writing phase Y1 also includes an initialization and second bias adjustment phase Y12. In the initialization and second bias adjustment phase Y12, the signal transmitted by the second scan signal line S2 includes at least one high-level period, and the signal transmitted by the second scan signal line S2 includes at least one high-level period. In other words, in the initialization and second bias adjustment phase Y12, the initialization transistor T5 is turned on, and later the threshold compensation transistor T4 is also turned on. The initialization signal line VREF1 may adjust the gate of the driving transistor T3 through the initialization transistor T5, and the initialization signal line VREF1 may also adjust the third node N3 through the initialization transistor T5 and the threshold compensation transistor T4.

The data writing phase Y1 also includes a data signal writing phase Y13. In the data signal writing phase Y13, the signal transmitted by the second scan signal line S2 includes a high-level period, and the signal transmitted by the third scan signal line SP* includes at least one low-level period. In other words, in the data signal writing phase Y13, the data writing transistor T2 and the threshold compensation transistor T4 are turned on, and the data signal may be transmitted to the gate of the driving transistor T3 through the data writing transistor T2 and the threshold compensation transistor T4. The data writing phase Y1 also includes a third bias adjustment phase Y14. In the third bias adjustment phase Y14, the signal transmitted by the fourth scan signal line SP includes at least one low-level period, and in this period, bias adjustment may be performed on the second node N2 again through the bias transistor T8.

If the driving cycle Y of the pixel circuit is a low-frequency cycle, the driving cycle Y includes the data writing phase Y1, the light emission phase Y2, and the light emission holding phase Y3. If the driving cycle Y of the pixel circuit is a high-frequency cycle, the driving cycle Y includes the data writing phase Y1 and the light emission phase Y2.

Optionally, the types of transistors in the pixel circuit are diverse. For example, the transistors may all be low temperature poly-silicon (Low Temperature Poly-Silicon, LTPS) transistors or may all be indium gallium zinc oxide (Indium Gallium Zinc Oxide, IGZO) transistors, or some may be LTPS transistors and others may be IGZO transistors. LTPS transistors have advantages such as high switching speed, high carrier mobility, and low power consumption, while IGZO transistors have advantages such as low leakage current. A low temperature polycrystalline oxide (Low Temperature Polycrystalline Oxide, LTPO) display panel, which combines LTPO and IGZO, not only has the advantages of LTPS display panels, such as high resolution, high response speed, high brightness, and high aperture ratio, but also has the advantage of low leakage current from IGZO. Exemplarily, the first light emission control transistor T1, the data writing transistor T2, the driving transistor T3, the second light emission control transistor T6, and the reset transistor T7 may be PMOS transistors; at least one of the threshold compensation transistor T4 and the initialization transistor T5 may be a PMOS transistor or an NMOS transistor. In embodiments of the present application, both the threshold compensation transistor T4 and the initialization transistor T5 are NMOS transistors, only for example. Based on the type of display panel, embodiments of the present application do not limit the type of the transistors, which can be adapted to actual manufacture needs.

Additionally, the threshold compensation transistor T4 and the initialization transistor T5 may be single-gate transistors or double-gate transistors. When double-gate transistors are used, leakage current of the transistors can be reduced, improving the display effect of the display panel. In the present application, both the threshold compensation transistor T4 and the initialization transistor T5 are top-bottom double-gate transistors, only for example.

As shown in FIG. 6, the reset transistor T7 and the second light emission control transistor T6 are connected to the anode of the light-emitting element, and the connection node of the reset transistor T7, the second light emission control transistor T6, and the anode of the light-emitting element is a fourth node N4. The pixel circuit is connected to the anode of the light-emitting element through the fourth node N4. The connection node of the light-emitting element 20 and the first pixel circuit 10 shown in FIG. 4 is the fourth node N4. The anode of the light-emitting element 20 is connected to the fourth node N4 of the corresponding first pixel circuit 10.

In FIG. 3 and FIG. 4, not the entire structure of the first pixel circuit 10 is shown, and the first pixel circuit 10 is represented by the fourth node N4 of the first pixel circuit 10. Both the first pixel circuit columns 10c and the first pixel circuit rows 10r are divided based on the fourth node N4.

Optionally, with continued reference to FIG. 3 and FIG. 4, in feasible embodiments, the display panel also includes multiple first pixel circuit rows 10r and multiple first light-emitting element rows 20r. The first pixel circuit row 10r includes multiple first pixel circuits 10 arranged along the second direction Y. The first light-emitting element column 20c includes light-emitting elements R of a first color and light-emitting elements B of a second color alternately arranged along the first direction X, and the first light-emitting element row 20r includes light-emitting elements R of the first color and light-emitting elements B of the second color alternately arranged along the second direction Y. The light-emitting elements R of the first color and the light-emitting elements B of the second color have different emission colors. The multiple first pixel circuits 10 in the same first pixel circuit column 10c are electrically connected to light-emitting elements R of the first color in at least two first light-emitting element columns 20c adjacent to each other along the second direction Y, or are electrically connected to light-emitting elements B of the second color in at least two first light-emitting element columns 20c adjacent to each other along the second direction Y. The multiple first pixel circuits 10 in the same first pixel circuit row 10r are electrically connected to multiple light-emitting elements 20 in the same first light-emitting element row 20r.

As shown in FIG. 3 and FIG. 4, the multiple first pixel circuits 10 arranged along the second direction Y form the first pixel circuit row 10r, and multiple first pixel circuit rows 10r are arranged along the first direction X. Light-emitting elements 20 of different emission colors at least include a light-emitting element of the first color R and a light-emitting element B of the second color. In the first light-emitting element column 20c, the light-emitting elements R of the first color and the light-emitting elements B of the second color are alternately arranged. In the first light-emitting element row 20r, the light-emitting elements R of the first color and the light-emitting elements B of the second color are alternately arranged. That is, along the first direction X and the second direction Y, a light-emitting element B of the second color is disposed between any two adjacent light-emitting elements R of the first color, and a light-emitting element B of the second color is disposed between any two adjacent light-emitting elements R of the first color. This ensures a uniform arrangement of the light-emitting elements R of the first color and light-emitting elements B of the second color in the display panel, improving color mixing effects.

As shown in FIG. 3 and FIG. 4, the multiple first pixel circuits 10 in the same first pixel circuit column 10c may be configured to be electrically connected to light-emitting elements 20 of the same color in at least two first light-emitting element columns 20c adjacent to each other along the second direction Y. That is, the light-emitting elements 20 of the same emission color connected to the multiple first pixel circuits 10 arranged along the first direction X are located in at least two adjacent first light-emitting element columns 20c. Thus, the multiple light-emitting elements 20 of the same color in the at least two adjacent first light-emitting element columns 20c are driven by the same first pixel circuit column 10c. The distance along the second direction Y between the light-emitting elements 20 connected to the first pixel circuits 10 is short, which can reduce the length of the connection lines between the first pixel circuits 10 and the light-emitting elements 20 in different columns and lower wiring complexity. Additionally, in this embodiment, the multiple first pixel circuits 10 arranged along the second direction Y are connected to the multiple light-emitting elements in the same first light-emitting element row 20r. That is, the multiple first pixel circuits 10 in the same first pixel circuit row 10r are electrically connected to the light-emitting elements 20 of different colors in the corresponding first light-emitting element row 20r, respectively, so that the multiple first pixel circuits 10 in the first pixel circuit row 10r drive the multiple light-emitting elements 20 in the corresponding first light-emitting element row 20r.

With reference to FIG. 3 and FIG. 4, when the first light-emitting element column 20c includes light-emitting elements R of the first color and light-emitting elements B of the second color and the first light-emitting element row 20r includes light-emitting elements R of the first color and light-emitting elements B of the second color, multiple first pixel circuits 10 in some first pixel circuit columns 10c are connected to light-emitting elements R of the first color in adjacent different first light-emitting element columns 20c, and multiple first pixel circuits 10 in some other first pixel circuit columns 10c are connected to light-emitting elements B of the second color in the adjacent different first light-emitting element columns 20c. That is, in the same first light-emitting element column 20c, the multiple light-emitting elements R of the first color are electrically connected to first pixel circuits 10 in one first pixel circuit column 10c, and the multiple light-emitting elements B are electrically connected to first pixel circuits 10 in another first pixel circuit column 10c. Some of multiple first pixel circuits 10 arranged along the second direction Y (that is, first pixel circuits 10 in the same row) are connected to light-emitting elements R of the first color, and some other first pixel circuits 10 of the multiple first pixel circuits 10 are connected to light-emitting elements B of the second color.

Exemplarily, in the embodiment shown in FIG. 3 and FIG. 4, along the direction from left to right as shown in the figures, the 1^{st} first pixel circuit column 10c is connected to multiple light-emitting elements R of the first color in the 1^{st} first light-emitting element column 20c and multiple light-emitting elements R of the first color in the 2^{nd} first light-emitting element column 20c, and the 2^{nd} first pixel circuit column 10c is connected to multiple light-emitting elements B of the second color in the 1^{st} first light-emitting element column 20c and multiple light-emitting elements B of the second color in the 2^{nd} first light-emitting element column 20c.

With continued reference to FIG. 3, the display panel also includes multiple second pixel circuit columns 11c and multiple second pixel circuit rows 11r. The second pixel circuit column 11c includes multiple second pixel circuits 11 arranged along the first direction X, and the second pixel circuit row 11r includes multiple second pixel circuits 11 arranged along the second direction Y. The second pixel circuit column 11c is electrically connected to the same data signal line Data. The display panel also includes multiple second light-emitting element columns 21c and multiple second light-emitting element rows 21r. The second light-emitting element column 21c includes multiple light-emitting elements G of a third color arranged along the first direction X, and the second light-emitting element row 21r includes multiple light-emitting elements G of the third color arranged along the second direction Y. The emission color of the light-emitting elements G of the third color is different from the emission colors of the light-emitting elements R of the first color and the light-emitting elements B of the second color. The multiple second pixel circuits 11 in the same second pixel circuit column 11c are electrically connected to the multiple light-emitting elements G of the third color in the same second light-emitting element column 21c, and the multiple second pixel circuits 11 in the same second pixel circuit row 11r are electrically connected to the multiple light-emitting elements G of the third color in the same second light-emitting element row 21r.

As shown in FIG. 3 and FIG. 4, the pixel circuits also include second pixel circuits 11 that may be arranged along the first direction X and the second direction Y to form an array. Multiple second pixel circuits 11 arranged along the first direction X form a second pixel circuit column 11c, and multiple second pixel circuit columns 11c are arranged along the second direction Y. Multiple second pixel circuits 11 arranged along the second direction Y form a second pixel circuit row 11r, and multiple second pixel circuit rows 11r are arranged along the first direction X. A data signal line Data is connected to the multiple second pixel circuits 11 in the same second pixel circuit column 11c, and the same data signal line Data transmits data signals to the multiple second pixel circuits 11 arranged along the first direction X.

With continued reference to FIG. 3 and FIG. 4, the light-emitting elements also include light-emitting elements G of the third color. Multiple third color light-emitting elements G arranged along the first direction X form a second light-emitting element column 21c, and multiple second light-emitting element columns 21c are arranged along the second direction Y. Multiple light-emitting elements G of the third color arranged along the second direction Y form a second light-emitting element row 21r, and multiple second light-emitting element rows 21r are arranged along the second direction Y. When the light-emitting elements R of the first color are red light-emitting elements and the light-emitting elements B of the second color are blue light-emitting elements, the light-emitting elements G of the third color may be green light-emitting elements, and the combination of red, blue, and green light-emitting elements achieves full-color display.

The second pixel circuit columns 11c may be set corresponding to the second light-emitting element columns 21c, and the multiple second pixel circuits 11 in the same second pixel circuit column 11c are electrically connected to the multiple light-emitting elements G of the third color in the same second light-emitting element column 21c. The data signal line Data connected to the second pixel circuit column 11c may transmit only the data signals corresponding to the light-emitting elements G of the third color, and no voltage switching exists on the data signal line Data. The second pixel circuit rows 11r may be set corresponding to the second light-emitting element rows 21r so that the multiple second pixel circuits 11 in the second pixel circuit row 11r drive the multiple light-emitting elements 20 in the corresponding second light-emitting element row 21r.

With continued reference to FIG. 3, the first pixel circuits 10 and the second pixel circuits 11 are alternately arranged in the same pixel circuit row. In a row of pixel circuits, the pixel circuits driving the first light-emitting elements are first pixel circuits, forming a first pixel circuit row, and the pixel circuits driving the second light-emitting elements are second pixel circuits, forming a second pixel circuit row. The first pixel circuit columns 10c and the second pixel circuit columns 11c are alternately arranged in the second direction, that is, a second pixel circuit column 11c is disposed between two adjacent first pixel circuit columns 10c, and a first pixel circuit column 10c is disposed between two adjacent second pixel circuit columns 11c. The two adjacent first pixel circuit columns 10c mentioned above may be understood as two first pixel circuit columns 10c separated by a second pixel circuit column 11c, rather than two directly adjacent pixel circuit columns.

Optionally, with continued reference to FIG. 4, along the first direction X, the first light-emitting element rows 20r and the second light-emitting element rows 21r are alternately arranged; along the second direction Y, the first light-emitting element columns 20c and the second light-emitting element columns 21c are alternately arranged.

As shown in FIG. 4, the first light-emitting element rows 20r and the second light-emitting element rows 21r are alternately arranged along the first direction X, that is, a second light-emitting element row 21r is disposed between two adjacent first light-emitting element rows 20r, making the arrangement of sub-pixels of different colors relatively uniform and improving color mixing effects. The first light-emitting element columns 20c and the second light-emitting element columns 21c are alternately arranged along the first direction X, that is, red-blue light-emitting element columns and green light-emitting element columns are alternately arranged along the second direction Y, ensuring uniform mixing of red, green, and blue light and guaranteeing image display effects. In embodiments of the present application, it is defined that light-emitting elements 20 in at least two adjacent first light-emitting element columns 20c do not include light-emitting elements 20 in the second light-emitting element columns 21c.

Optionally, with continued reference to FIG. 3 and FIG. 4, in some embodiments, a second light-emitting element column 21c may also be arranged between two adjacent first light-emitting element columns 20c. The second light-emitting element column 21c includes multiple light-emitting elements 2 of the same color arranged along the first direction X, and the emission color of the light-emitting elements 2 in the second light-emitting element column 21c is different from the emission color of the light-emitting elements 2 in the first light-emitting element columns 20c. For example, the second light-emitting element column 21c may include multiple light-emitting elements G of the third color arranged along the first direction X, so that the arrangement of light-emitting elements 2 of different colors is more uniform, to improve color deviation.

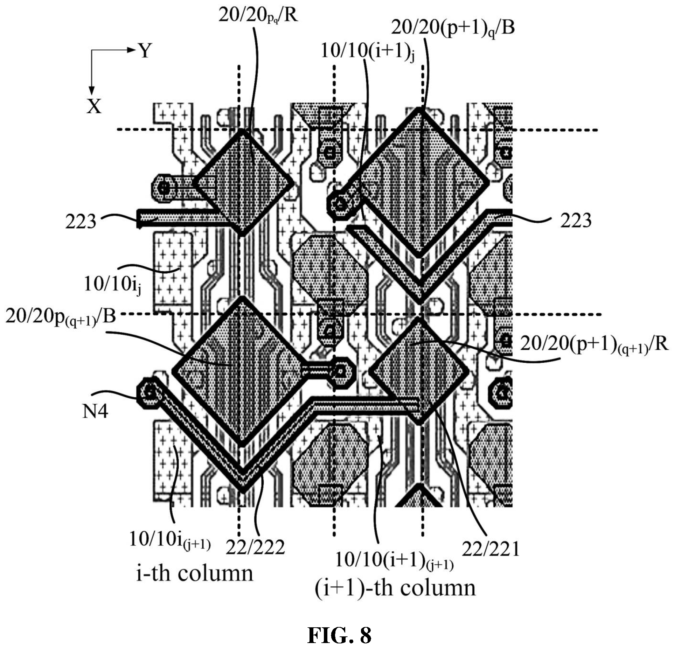

FIG. 8 is a partially enlarged structural diagram of the display panel shown in FIG. 4. With reference to FIG. 3, FIG. 4, and FIG. 8, at least some adjacent first pixel circuit column group 100 and second pixel circuit column group 101 include an i-th first pixel circuit column 10c and an (i+1)-th first pixel circuit column 10c. At least one pair of adjacent first pixel circuits 10 in the i-th first pixel circuit column 10c include an iⱼ-th first pixel circuit 10iⱼ and an i₍ⱼ₊₁₎-th first pixel circuit 10i₍ⱼ₊₁₎. At least one pair of adjacent first pixel circuits 10 in the (i+1)-th first pixel circuit column 10c include an (i+1)ⱼ-th first pixel circuit 10(i+1)ⱼ and an (i+1)₍ⱼ₊₁₎-th first pixel circuit 10(i+1)_{(j+1).} At least one pair of adjacent first light-emitting element columns 20c include a p-th first light-emitting element column 20c and a (p+1)-th first light-emitting element column 20c. At least one pair of adjacent light-emitting elements in the p-th first light-emitting element column 20c include a p_{q}-th light-emitting element 20p_{q} and a p_{(q+1)}-th light-emitting element 20p_{(q+1)}. At least one pair of adjacent light-emitting elements in the (p+1)-th first light-emitting element column 20c include a (p+1)_{q}-th light-emitting element 20(p+1)_{q} and a (p+1)_{(q+1)}-th light-emitting element 20(p+1)_{(q+1).} i, j, p, and q are all positive integers. The iⱼ-th first pixel circuit 10iⱼ is electrically connected to the p_{q}-th light-emitting element 20p_{q}, the i₍ⱼ₊₁₎-th first pixel circuit 10i₍ⱼ₊₁₎ is electrically connected to the (p+1)_{(q+1)}-th light-emitting element 20(p+1)_{(q+1)}; the (i+1)ⱼ-th first pixel circuit 10(i+1)ⱼ is electrically connected to the (p+1)_{q}-th light-emitting element 20(p+1)_{q}; and the (i+1)₍ⱼ₊₁₎-th first pixel circuit 10(i+1)₍ⱼ₊₁₎ is electrically connected to the p_{(q+1)}-th light-emitting element 20p_{(q+1)}.

As shown in FIG. 3 and FIG. 4, the first pixel circuit column 10c in the first pixel circuit column group 100 may be the i-th first pixel circuit column 10c, and the first pixel circuit column 10c in the second pixel circuit column group 101 adjacent to the first pixel circuit column group 100 may be the (i+1)-th first pixel circuit column 10c. In the i-th first pixel circuit column 10c, two adjacent first pixel circuits 10 are the iⱼ-th first pixel circuit 10iⱼ and the i₍ⱼ₊₁₎-th first pixel circuit 10i₍ⱼ₊₁₎, respectively. In the (i+1)-th first pixel circuit column 10c, two adjacent first pixel circuits 10 are the (i+1)ⱼ-th first pixel circuit 10(i+1)ⱼ and the (i+1)₍ⱼ₊₁₎-th first pixel circuit 10(i+1)₍ⱼ₊₁₎, respectively. The values of i and j are not limited and may be equal or unequal. It should be understood that i corresponds to a the first pixel circuit column 10c, and j corresponds to a first pixel circuit row 10r. The value of i may be less than the total number of the first pixel circuit columns 10c, and the value of j may be less than the total number of the first pixel circuit rows 10r.

The two adjacent first light-emitting element columns 20c may be the p-th first light-emitting element column 20c and the (p+1)-th first light-emitting element column 20c. In the p-th first light-emitting element column 20c, two adjacent light-emitting elements may be the p_{q}-th light-emitting element 20p_{q} and the p_{(q+1)}-th light-emitting element 20p_{(q+1)}. In the (p+1)-th first light-emitting element column 20c, two adjacent light-emitting elements may be the (p+1)_{q}-th light-emitting element 20(p+1)_{q} and the (p+1)_{(q+1)}-th light-emitting element 20(p+1)_{(q+1)}. The p_{q}-th light-emitting element 20p_{q} and the (p+1)_{(q+1)}-th light-emitting element (p+1)_{(q+1)} may be light-emitting elements R of the first color, and the p_{(q+1)}-th light-emitting element 20p_{(q+1)} and the (p+1)_{q}-th light-emitting element 20(p+1)_{q} may be light-emitting elements B of the second color. The values of p and q are not limited and may be equal or unequal. p corresponds to a first light-emitting element column 20c, and q corresponds to a first light-emitting element row 20r. The value of p may be less than the total number of the first light-emitting element columns 20c, and the value of q may be less than the total number of the first light-emitting element rows 20r.

Optionally, the i-th first pixel circuit column 10c may refer to an odd-numbered first pixel circuit column 10c of the display panel, and the (i+1)-th first pixel circuit column 10c may refer to an even-numbered first pixel circuit column 10c of the display panel. The j-th first pixel circuit row 10r may refer to an odd-numbered first pixel circuit row 10r of the display panel, and the (j+1)-th first pixel circuit row 10r may refer to an even-numbered first pixel circuit row 10r of the display panel. The p-th first light-emitting element column 20c may refer to an odd-numbered first light-emitting element column 20c of the display panel, and the (p+1)-th first light-emitting element column 20c may refer to an even-numbered first light-emitting element column 20c of the display panel. The q-th first light-emitting element row 20r may refer to an odd-numbered first light-emitting element row 20r of the display panel, and the (q+1)-th first light-emitting element row 20r may refer to an even-numbered first light-emitting element row 20r of the display panel. Alternatively, the i-th first pixel circuit column 10c may refer to an even-numbered first pixel circuit column 10c of the display panel, and the (i+1)-th first pixel circuit column 10c may refer to an odd-numbered first pixel circuit column 10c of the display panel. The j-th first pixel circuit row 10r may refer to an even-numbered first pixel circuit row 10r of the display panel, and the (j+1)-th first pixel circuit row 10r may refer to an even-numbered first pixel circuit row 10r of the display panel. The p-th first light-emitting element column 20c may refer to an even-numbered first light-emitting element column 20c of the display panel, and the (p+1)-th first light-emitting element column 20c may refer to an odd-numbered first light-emitting element column 20c of the display panel. The q-th first light-emitting element row 20r may refer to an even-numbered first light-emitting element row 20r of the display panel, and the (q+1)-th first light-emitting element row 20r may refer to an odd-numbered first light-emitting element row 20r of the display panel. Embodiments of the present application do not limit whether i, j, p, and q are odd or even numbers.

As shown in FIG. 4 and FIG. 8, the j-th first pixel circuit 10 in the i-th column (that is, the iⱼ-th first pixel circuit 10iⱼ) may be electrically connected to the q-th light-emitting element in the p-th column (that is, the p_{q}-th light-emitting element 20p_{q}). The (j+1)-th first pixel circuit 10 in the i-th column (that is, the i₍ⱼ₊₁₎-th first pixel circuit 10i₍ⱼ₊₁₎) may be electrically connected to the (q+1)-th light-emitting element in the (p+1)-th column (that is, the (p+1)_{(q+1)}-th light-emitting element 20(p+1)_{(q+1)}). The j-th first pixel circuit 10 in the (i+1)-th column (that is, the (i+1)ⱼ-th first pixel circuit 10(i+1)ⱼ) may be electrically connected to the q-th light-emitting element in the (p+1)-th column (that is, the (p+1)_{q}-th light-emitting element 20(p+1)_{q}). The (j+1)-th first pixel circuit 10 in the (i+1)-th column (that is, the (i+1)₍ⱼ₊₁₎-th first pixel circuit 10(i+1)₍ⱼ₊₁₎) may be electrically connected to the (q+1)-th light-emitting element in the p-th column (that is, the p_{(q+1)}-th light-emitting element 20p_{(q+1)}). That is, in the i-th first pixel circuit column 10c, some of the first pixel circuits 10 are electrically connected to light-emitting elements R of the first color in the p-th first light-emitting element column 20c, some other first pixel circuits 10 of the first pixel circuits 10 are electrically connected to light-emitting elements R of the first color in the (p+1)-th first light-emitting element column 20c, and the first pixel circuits 10 connected to the light-emitting elements R of the first color in the p-th first light-emitting element column 20c and the first pixel circuits 10 connected to the light-emitting elements R of the first color in the (p+1)-th first light-emitting element column 20c are alternately arranged along the first direction X. In the (i+1)-th first pixel circuit column 10c, some of the first pixel circuits 10 are electrically connected to light-emitting elements B of the second color in the p-th first light-emitting element column 20c, some other first pixel circuits 10 of the first pixel circuits 10 are electrically connected to light-emitting elements B of the second color in the (p+1)-th first light-emitting element column 20c, and the first pixel circuits 10 connected to the light-emitting elements B of the second color in the p-th first light-emitting element column 20c and the first pixel circuits 10 connected to the light-emitting elements B of the second color in the (p+1)-th first light-emitting element column 20c are alternately arranged along the first direction X. The light-emitting elements R of the first color in the p-th first light-emitting element column 20c and the (p+1)-th first light-emitting element column 20c may be electrically connected to the first pixel circuits 10 in the i-th first pixel circuit column 10c, and the light-emitting elements B of the second color in the p-th first light-emitting element column 20c and the (p+1)-th first light-emitting element column 20c may be electrically connected to the first pixel circuits 10 in the (i+1)-th first pixel circuit column 10c.

Exemplarily, i, j, p, and q are all equal to 1, for example. The 1^{st} first pixel circuit 10 in the 1^{st} column may be electrically connected to the 1^{st} first light-emitting element (light-emitting element R of the first color) in the 1^{st} column. The 2^{nd} first pixel circuit 10 in the 1^{st} column may be electrically connected to the 2^{nd} light-emitting element (light-emitting element R of the first color) in the 2^{nd} column. The 1^{st} first pixel circuit 10 in the 2^{nd} column may be electrically connected to the 1^{st} light-emitting element (light-emitting element B of the second color) in the 1^{st} column, and the 2^{nd} first pixel circuit 10 in the 2^{nd} column may be electrically connected to the 2^{nd} light-emitting element (light-emitting element B of the second color) in the 1^{st} column.

It should be noted that the light-emitting elements in the p-th and (p+1)-th columns above are light-emitting elements in adjacent first light-emitting element columns 20c and do not include light-emitting elements in the second light-emitting element columns 21c.

It can be understood that the display panel includes two adjacent first pixel circuit columns (a first pixel circuit column A and a first pixel circuit column B) and two adjacent first light-emitting element columns (a first light-emitting element column A and a first light-emitting element column B). The first pixel circuit columns correspond to the first light-emitting element columns, which can also be understood as the first pixel circuit columns and the first light-emitting element columns overlapping in the thickness direction of the display panel. For example, the first pixel circuit column A overlaps with the first light-emitting element column A, and the first pixel circuit column B overlaps with the first light-emitting element column B. For the first light-emitting element column A, some of the light-emitting elements in the first light-emitting element column A are correspondingly electrically connected to some of the first pixel circuits in the first pixel circuit column A, and some other light-emitting elements of the light-emitting elements in the first light-emitting element column A are electrically connected to some of the first pixel circuits in the first pixel circuit column B. For the first light-emitting element column B, some of the light-emitting elements in the first light-emitting element column B are correspondingly electrically connected to some other first pixel circuits of the first pixel circuits in the first pixel circuit column A, and some other light-emitting elements of the light-emitting elements in the first light-emitting element column B are electrically connected to some other first pixel circuits of the first pixel circuits in the first pixel circuit column B. For example, red light-emitting elements in the first light-emitting element column A may be correspondingly electrically connected to some of the first pixel circuits in the first pixel circuit column A, and blue light-emitting elements in the first light-emitting element column A are electrically connected to some of the first pixel circuits in the first B pixel circuit column. Red light-emitting elements in the first light-emitting element column B may be correspondingly electrically connected to some of the first pixel circuits in the first pixel circuit column A, and blue light-emitting elements in the first light-emitting element column B are electrically connected to some other first pixel circuits of the first pixel circuits in the first pixel circuit column B.

In other words, for one or several first pixel circuit rows, the light-emitting elements thereof are not correspondingly electrically connected to the pixel circuits directly below the light-emitting elements, but are electrically connected to other pixel circuits. As shown in FIG. 3, two adjacent light-emitting elements in a row exchange their corresponding first pixel circuits so that a column of first pixel circuits drives only light-emitting elements of one color.

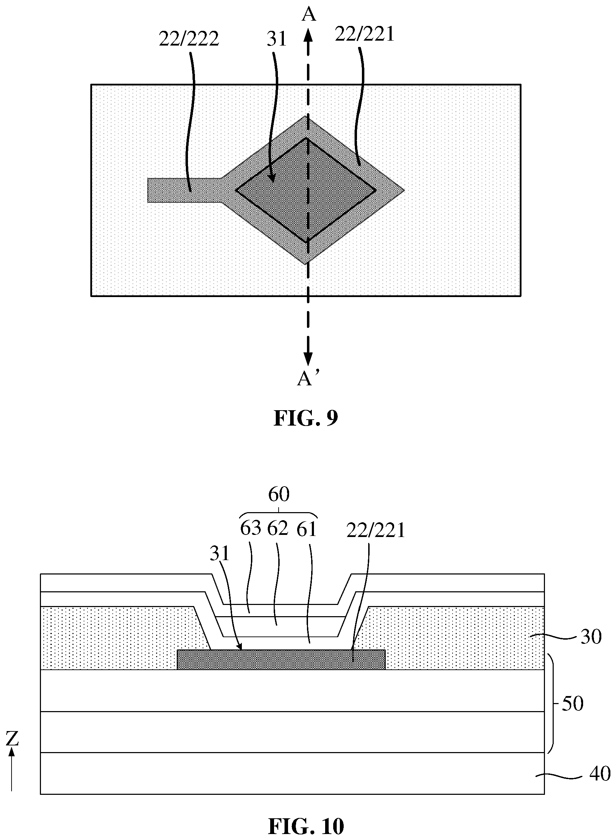

FIG. 9 is a diagram illustrating the structure of another display panel according to an embodiment of the present application. FIG. 10 is a sectional structural diagram along the A-A' direction of FIG. 9. With reference to FIG. 4 and FIG. 8 to FIG. 10, the light-emitting element 20 includes an anode 22, and the anode 22 includes an anode body portion 221 and an anode connection portion 222 connected to each other. The display panel also includes a pixel definition layer 30 and multiple pixel openings 31 in the pixel definition layer 30. Along the thickness direction Z of the display panel, the anode body portion 221 overlaps with a pixel opening 31, and the anode connection portion 222 does not overlap with the pixel opening 31. The i₍ⱼ₊₁₎-th first pixel circuit 10i₍ⱼ₊₁₎ is electrically connected to the anode connection portion 222 of the (p+1)_{(q+1)}-th light-emitting element 20(p+1)_{(q+1)}, and the (i+1)₍ⱼ₊₁₎-th first pixel circuit 10(i+1)₍ⱼ₊₁₎ is electrically connected to the anode connection portion 222 of the p_{(q+1)}-th light-emitting element 20p_{(q+1)}.

FIG. 9 shows only the anode 22 of the light-emitting element 20. The connection between the first pixel circuit 10 and the light-emitting element 20 described in the foregoing embodiments may refer to the connection between the first pixel circuit 10 and the anode 22 of the light-emitting element 20. With reference to FIG. 8, FIG. 9, and FIG. 10, the display panel may include a substrate 40, a pixel circuit layer 50, a pixel definition layer 30, and a display function layer 60. The pixel circuit layer 50 is disposed on a side of the substrate 40, and the first pixel circuits, data signal lines, and the anode 22 of the light-emitting element 20 may be located in the pixel circuit layer 50. The pixel definition layer 30 is located on the side of the pixel circuit layer 50 away from the substrate 40 and may be located on the side of the layer where the anode 22 is located away from the substrate 40. The pixel circuit layer 50 includes multiple pixel openings 31 disposed corresponding to anodes 22 respectively. Along the thickness direction Z of the display panel, a pixel opening 31 overlaps with the anode 22 of the light-emitting element 20, and the anode 22 may be exposed at the pixel opening 31. The display function layer 60 may include a hole layer 61, a light-emitting layer 62, and an electron layer 63 stacked in sequence, but is not limited thereto. The above display function layer 60 is at least located in the pixel opening 31. The side of the display function layer 60 away from the layer where the anode is located may also include a cathode layer (not shown in the figures). The cathode layer may be disposed as a whole layer or include multiple individually disposed cathodes. The cathode layer is configured to provide electrons to the display function layer 60, and the anode is configured to provide holes to the display function layer 60, where the holes and electrons combine to emit light.

With continued reference to FIG. 4 and FIG. 8 to FIG. 10, the anode 22 may include an anode body portion 221 and an anode connection portion 222 that are connected to each other. The anode body portion 221 overlaps with the pixel opening 31 along the thickness direction Z of the display panel, and the anode connection portion 222 does not overlap with the pixel opening 31. The anode body portion 221 is electrically connected to the corresponding first pixel circuit 10 through the anode connection portion 222, thereby achieving the electrical connection between the light-emitting element and the pixel circuit.

Exemplarily, as shown in FIG. 8 and FIG. 9, the iⱼ-th first pixel circuit 10iⱼ is electrically connected to the anode connection portion 222 of the p_{q}-th light-emitting element 20p_{q}, the i₍ⱼ₊₁₎-th first pixel circuit 10i₍ⱼ₊₁₎ is electrically connected to the anode connection portion 222 of the (p+1)_{(q+1)}-th light-emitting element 20(p+1)_{(q+1)}, the (i+1)ⱼ-th first pixel circuit 10(i+1)ⱼ is electrically connected to the anode connection portion 222 of the (p+1)_{q}-th light-emitting element 20(p+1)_{q}, and the (i+1)₍ⱼ₊₁₎-th first pixel circuit 10(i+1)₍ⱼ₊₁₎ is electrically connected to the anode connection portion 222 of the p_{(q+1)}-th light-emitting element 20p_{(q+1)}.

Optionally, as shown in FIG. 4 and FIG. 8, based on the arrangement of pixel circuits and light-emitting elements in the display panel, when i equals p and j equals q, the distance between the orthographic projection of the anode body portion 221 of the p_{q}-th light-emitting element 20p_{q} on the plane of the substrate 40 and the orthographic projection of the iⱼ-th first pixel circuit 10iⱼ on the plane of the substrate 40 (the distance between the two projections along the second direction Y) is less than the distance between the orthographic projection of the anode body portion 221 of the (p+1)_{(q+1)}-th light-emitting element 20(p+1)_{(q+1)} on the plane and the orthographic projection of the i₍ⱼ₊₁₎-th first pixel circuit 10i₍ⱼ₊₁₎ on the plane (the distance between the two projections along the second direction Y). Therefore, the extension length of the orthographic projection of the anode connection portion 222 of the p_{q}-th light-emitting element 20p_{q} on the plane of the substrate 40 may be set to be less than the extension length of the orthographic projection of the anode connection portion 222 of the (p+1)_{(q+1)}-th light-emitting element 20(p+1)_{(q+1)} on the plane of the substrate 40.

It should be noted that as shown in FIG. 9 and FIG. 10, the area of the orthographic projection of the pixel opening 31 on the plane of the substrate 40 may be smaller than the area of the orthographic projection of the anode 22 on the plane. That is, along the thickness direction Z of the display panel, the anode 22 may cover the pixel opening 31. In this arrangement, the projection of the anode 22 overlaps with that of the pixel opening 31, and the part of the anode 22 that is similar in shape to the pixel opening 31 is referred to as the anode body portion 221. In other words, when orthographically projected on the plane of the substrate 40, the part whose edges surround the pixel opening 31 and extend parallel to the pixel opening 31 may be referred to as the anode body portion 221. The anode connection portion 222 generally refers to the part connected to the anode body portion 221 and having a width significantly smaller than that of the anode body portion 221. The anode shown in the figures is substantially diamond-shaped, for example. The regular diamond-shaped part may be referred to as the anode body portion 221, and the part connected to the diamond edge and extending outward from the diamond edge is the anode connection portion 222.

The relative positional relationship between the anode body portion 221 and the anode connection portion 222 may be designed by those skilled in the art as needed, and embodiments of the present application do not impose limitations on this. Several different designs for the anode connection portion 222 are introduced below in conjunction with some embodiments.

Exemplarily, with continued reference to FIG. 4 and FIG. 9, in some embodiments, the anode connection portion 222 of the (p+1)_{q}-th light-emitting element 20(p+1)_{q} is located on a side of the anode body portion 221 of the light-emitting element 20(p+1)_{q} close to the (i+1)-th first pixel circuit column 10c, and the anode connection portion 222 of the p_{(q+1)}-th light-emitting element 20p_{(q+1)} is located on a side of the anode body portion 221 of the light-emitting element 20p_{(q+1)} close to the (i+1)-th the first pixel circuit column 10c.

As described in the foregoing embodiments, the (p+1)_{q}-th light-emitting element 20(p+1)_{q} and the p_{(q+1)}-th light-emitting element 20p_{(q+1)} may be light-emitting elements B of the second color. The light-emitting elements B of the second color in the p-th first light-emitting element column 20c and the (p+1)-th first light-emitting element column 20c may be electrically connected to the first pixel circuits 10 in the (i+1)-th first pixel circuit column 10c. The anode body portions 221 of the light-emitting elements B of the second color in the p-th first light-emitting element column 20c and the (p+1)-th first light-emitting element column 20c may be located on two sides of the (i+1)-th first pixel circuit column 10c along the second direction Y. In other words, the anode body portions 221 of the light-emitting elements B of the second color in the p-th first light-emitting element column 20c and the (p+1)-th first light-emitting element column 20c are located on the left and right sides of multiple fourth nodes N4 in the (i+1)-th first pixel circuit column 10c.

On this basis, as shown in FIG. 4 and FIG. 9, in this embodiment, the anode connection portion 222 of the q-th light-emitting element in the (p+1)-th column (that is, the (p+1)_{q}-th light-emitting element 20(p+1)_{q}) may be disposed on a side of the anode body portion 221 of the light-emitting element 20(p+1)_{q} close to the (i+1)-th first pixel circuit column 10c, and the anode connection portion 222 of the (q+1)-th light-emitting element in the p-th column (that is, the p_{(q+1)}-th light-emitting element 20p_{(q+1)}) may be disposed on a side of the anode body portion 221 of the light-emitting element 20p_{(q+1)} close to the (i+1)-th first pixel circuit column 10c. Thus, the anode connection portion 222 of the light-emitting element B of the second color in the p-th first light-emitting element column 20c extends toward the (p+1)-th first light-emitting element column 20c and connects to the fourth node N4 of the first pixel circuit 10 in the (i+1)-th first pixel circuit column 10c. The anode connection portion 222 of the light-emitting element B of the second color in the (p+1)-th first light-emitting element column 20c extends toward the p-th first light-emitting element column 20c and connects to the fourth node N4 of the first pixel circuit 10 in the (i+1)-th first pixel circuit column 10c. With this arrangement, the distance along the second direction Y between the (p+1)_{q}-th light-emitting element 20(p+1)_{q} and the fourth node N4 of the (i+1)ⱼ-th first pixel circuit 10(i+1)ⱼ to which the light-emitting element 20(p+1)_{q} is connected is relatively short, and the distance along the second direction Y between the p_{(q+1)}-th light-emitting element 20p_{(q+1)} and the fourth node N4 of the (i+1)₍ⱼ₊₁₎-th first pixel circuit 10(i+1)₍ⱼ₊₁₎ to which the light-emitting element 20p_{(q+1)} is connected is relatively short. This can reduce the length of the anode connection portion 222 of the light-emitting element and facilitate the connection between the light-emitting element and the corresponding first pixel circuit 10.

For example, as shown in FIG. 4, along the direction from left to right in the figure, the anode connection portion 222 of the 1^{st} first light-emitting element in the 2^{nd} column is located on a side of its anode body portion 221 close to the 2^{nd} first pixel circuit column 10c and extends toward the 1^{st} first pixel circuit 10 in the 2^{nd} column; the anode connection portion 222 of the 2^{nd} light-emitting element in the 1^{st} column is located on a side of its anode body portion 221 close to the 2^{nd} first pixel circuit column 10c and extends toward the 2^{nd} first pixel circuit 10 in the 2^{nd} column.

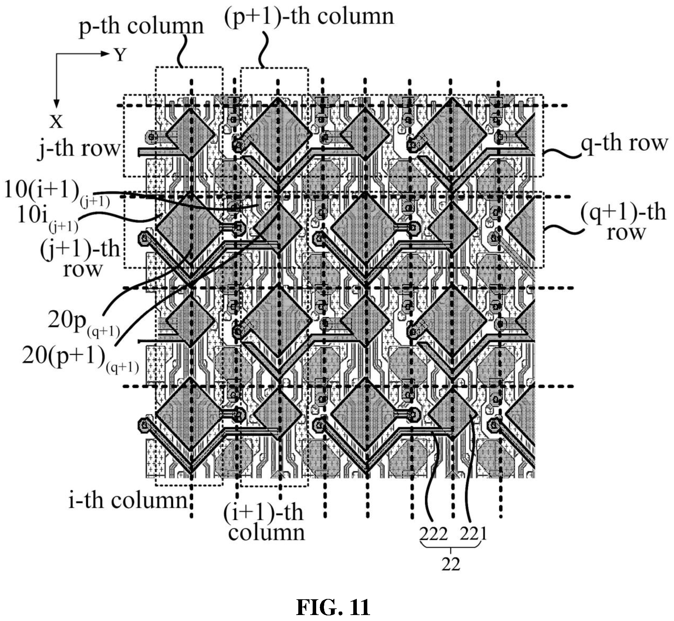

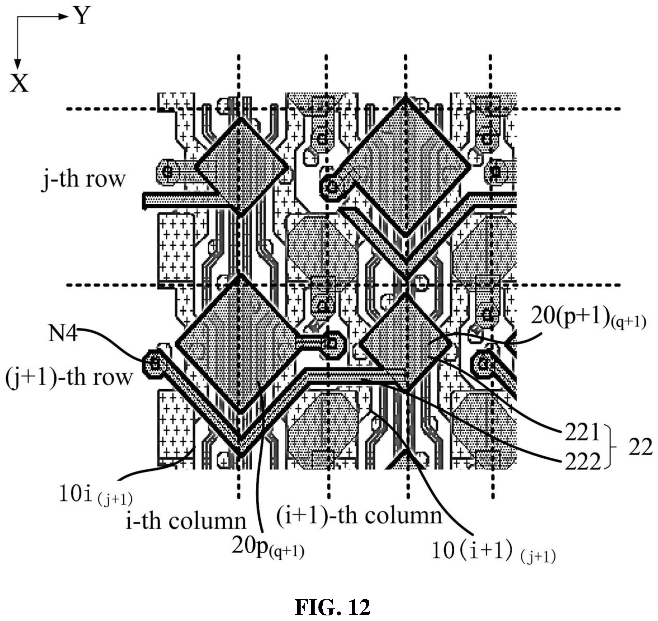

Exemplarily, FIG. 11 is a diagram illustrating the structure of another display panel according to an embodiment of the present application, and FIG. 12 is a partially enlarged structural diagram of the display panel shown in FIG. 11. With reference to FIG. 11 and FIG. 12, the anode connection portion 222 of the (p+1)_{(q+1)}-th light-emitting element 20(p+1)_{(q+1)} is located on a side of the anode body portion 221 of the light-emitting element 20(p+1)_{(q+1)} close to the i-th first pixel circuit column 10c, and the anode connection portion 222 of the p_{(q+1)}-th light-emitting element 20p_{(q+1)} is located on a side of the anode body portion 221 of the light-emitting element 20p_{(q+1)} close to the (i+1)-th first pixel circuit column 10c.

Both the p_{(q+1)}-th light-emitting element 20p_{(q+1)} and the (p+1)_{(q+1)}-th light-emitting element 20(p+1)_{(q+1)} are located in the p-th first light-emitting element column 20r and are two adjacent light-emitting elements 20 in the p-th first light-emitting element column 20r. In the embodiments shown in FIG. 11 and FIG. 12, the light-emitting elements B of the second color in the first light-emitting element column 20c may be the same as those in the embodiments shown in FIG. 4 and FIG. 8 and will not be repeated here. As shown in FIG. 11 and FIG. 12, it is defined by this embodiment that the anode connection portion 222 of the light-emitting element R of the first color in the (p+1)-th first light-emitting element column 20c is located on a side of its anode body portion 221 close to the i-th first pixel circuit column 10c. That is, the anode connection portion 222 of the (p+1)_{(q+1)}-th light-emitting element 20(p+1)_{(q+1)} is located on a side of the anode body portion 221 of the light-emitting element 20(p+1)_{(q+1)} close to the i-th first pixel circuit column 10c. The anode connection portion 222 of the (p+1)_{(q+1)}-th light-emitting element 20(p+1)_{(q+1)} extends toward the i₍ⱼ₊₁₎-th first pixel circuit 10i₍ⱼ₊₁₎ and connects to the fourth node N4 of the i₍ⱼ₊₁₎-th first pixel circuit 10i₍ⱼ₊₁₎.

With this arrangement, the anode connection portion 222 of the (p+1)_{(q+1)}-th light-emitting element 20(p+1)_{(q+1)} and the anode connection portion 222 of the p_{(q+1)}-th light-emitting element 20p_{(q+1)} are disposed facing each other, and the distance along the second direction Y between the light-emitting element 20 and the fourth node N4 of the corresponding first pixel circuit 10 is relatively short, thereby reducing the length of the connection lines between the light-emitting elements of different colors in the p-th first light-emitting element column 20c and the corresponding first pixel circuits 10.

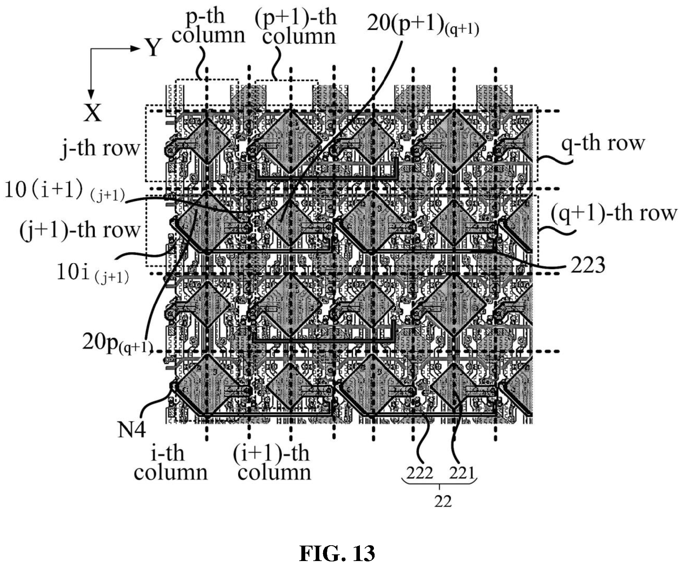

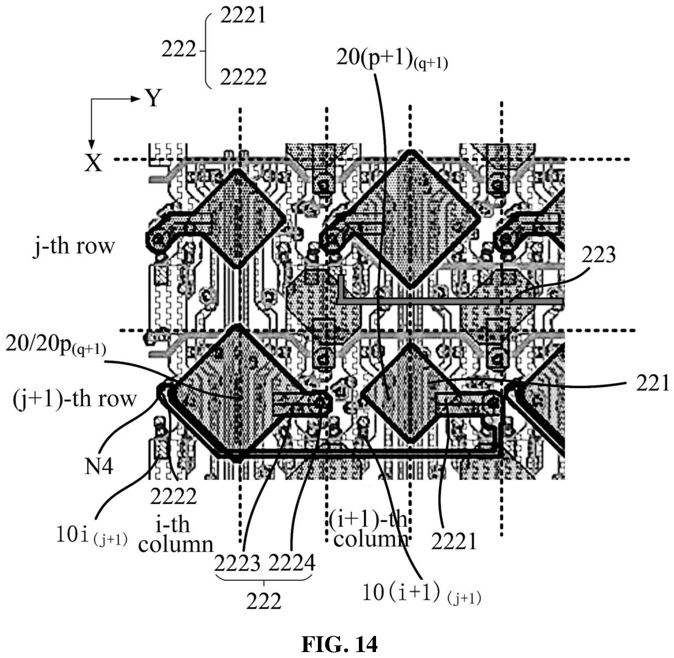

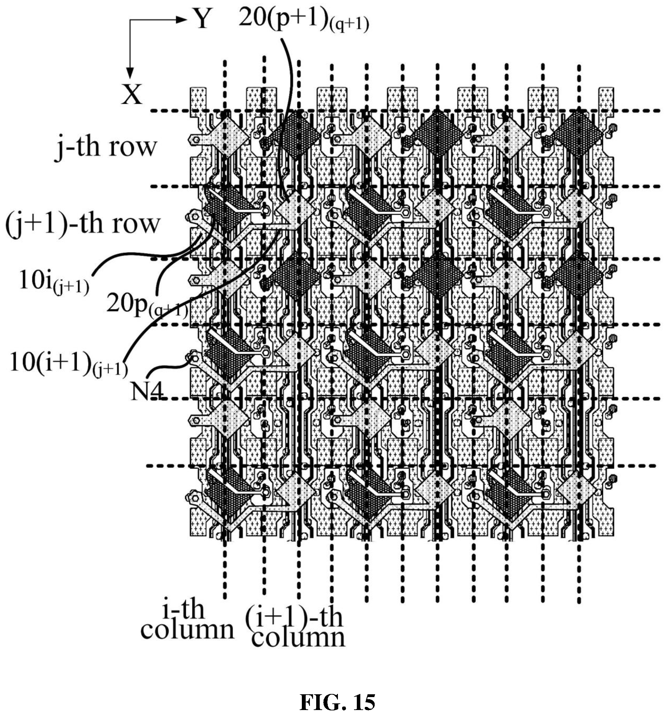

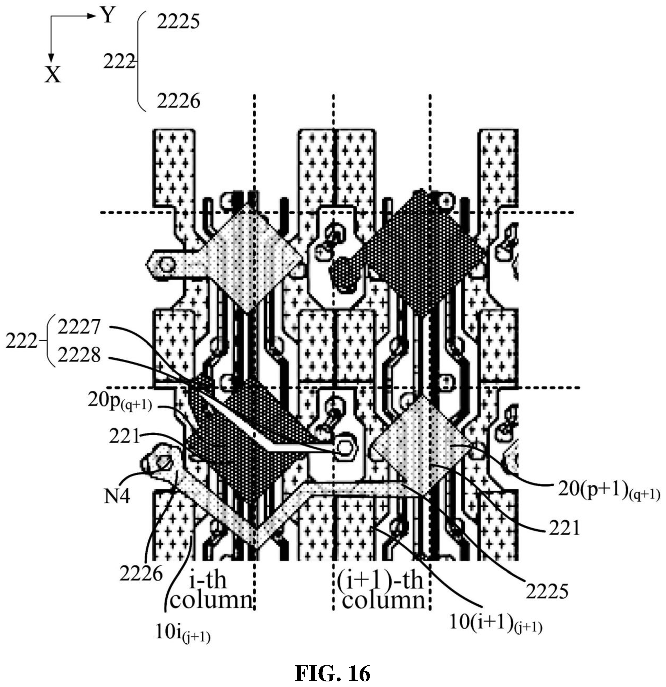

FIG. 13 is a diagram illustrating the structure of yet another display panel according to an embodiment of the present application. FIG. 14 is a partially enlarged structural diagram of the display panel shown in FIG. 13. FIG. 15 is a diagram illustrating the structure of another display panel according to an embodiment of the present application. FIG. 16 is a partially enlarged structural diagram of the display panel shown in FIG. 15. With reference to FIG. 13 and FIG. 16, in feasible embodiments, as shown in FIG. 13 and FIG. 14, the anode connection portion 222 of the (p+1)_{(q+1)}-th light-emitting element 20(p+1)_{(q+1)} includes a first end portion 2221 connected to the anode body portion 221 of the light-emitting element 20(p+1)_{(q+1)} and a second end portion 2222 connected to the first pixel circuit 10. The first end portion 2221 is located on a side of the anode body portion 221 of the light-emitting element 20(p+1)_{(q+1)} away from the i-th first pixel circuit column 10c. The (i+1)₍ⱼ₊₁₎-th first pixel circuit 10(i+1)₍ⱼ₊₁₎ is electrically connected to the anode connection portion 222 of the p_{(q+1)}-th light-emitting element 20p_{(q+1)}. The anode connection portion 222 of the p_{(q+1)}-th light-emitting element 20p_{(q+1)} includes a third end portion 2223 connected to the anode body portion 221 of the light-emitting element 20p_{(q+1)} and a fourth end portion 2224 connected to the first pixel circuit 10, and the third end portion 2223 is located on a side of the anode body portion 221 of the light-emitting element 20p_{(q+1)} close to the (i+1)-th first pixel circuit column 10c. Alternatively, as shown in FIG. 15 and FIG. 16, the anode connection portion 222 of the (p+1)_{(q+1)}-th light-emitting element 20(p+1)_{(q+1)} includes a fifth end portion 2225 connected to the anode body portion 221 of the light-emitting element 20(p+1)_{(q+1)} and a sixth end portion 2226 connected to the first pixel circuit 10, and the fifth end portion 2225 is located on a side of the anode body portion 221 of the light-emitting element 20(p+1)_{(q+1)} close to the i-th first pixel circuit column 10c. The (i+1)₍ⱼ₊₁₎-th first pixel circuit 10(i+1)₍ⱼ₊₁₎ is electrically connected to the anode connection portion 222 of the p_{(q+1)}-th light-emitting element 20p_{(q+1)}, the anode connection portion 222 of the p_{(q+1)}-th light-emitting element 20p_{(q+1)} includes a seventh end portion 2227 connected to the anode body portion 221 of the light-emitting element 20p_{(q+1)} and an eighth end portion 2228 connected to the first pixel circuit 10, and the seventh end portion 2227 is located on a side of the anode body portion 221 of the light-emitting element 20p_{(q+1)} away from the (i+1)-th first pixel circuit column 10c.

As described in the foregoing embodiments, the light-emitting elements R of the first color in the (p+1)-th first light-emitting element column 20c are connected to the first pixel circuits 10 in the i-th first pixel circuit column 10c. For example, the (p+1)_{(q+1)}-th light-emitting element 20(p+1)_{(q+1)} is connected to the i₍ⱼ₊₁₎-th first pixel circuit 10i₍ⱼ₊₁₎, and the anode connection portion 222 of the (p+1)_{(q+1)}-th light-emitting element 20(p+1)_{(q+1)} may extend as a whole along the second direction Y to connect to the fourth node N4 of the i₍ⱼ₊₁₎-th first pixel circuit 10i₍ⱼ₊₁₎.

In the embodiments shown in FIG. 13 and FIG. 14, the anode connection portion 222 of the (p+1)_{(q+1)}-th light-emitting element 20(p+1)_{(q+1)} includes a first end portion 2221 and a second end portion 2222. The first end portion 2221 is close to the anode body portion 221 of the (p+1)_{(q+1})-th light-emitting element 20(p+1)_{(q+1)} in a direction within the plane of the substrate 40 and is connected to the anode body portion 221. The second end portion 2222 extends toward the fourth node N4 of the i₍ⱼ₊₁₎-th first pixel circuit 10i₍ⱼ₊₁₎ and connects to the fourth node N4. The first end portion 2221 is located on a side of the anode body portion 221 away from the i-th first pixel circuit column 10c, that is, the first end portion 2221 is located on a side of the anode body portion 221 away from the p_{(q+1)}-th light-emitting element 20p_{(q+1)}. This can be interpreted as the following: the anode connection portion 222 of the (p+1)_{(q+1)}-th light-emitting element 20(p+1)_{(q+1)} first extends a certain length through the first end portion 2221 away from the i-th first pixel circuit column 10c and then connects to the fourth node N4 through the second end portion 2222. The anode connection portion 222 of the p_{(q+1)}-th light-emitting element 20p_{(q+1)} includes a third end portion 2223 and a fourth end portion 2224. The third end portion 2223 is close to the anode body portion 221 of the p_{(q+1)}-th light-emitting element 20p_{(q+1)} in a direction within the plane of the substrate 40 and connects to the anode body portion 221. The fourth end portion 2224 extends toward the fourth node N4 of the (i+1)₍ⱼ₊₁₎-th first pixel circuit 10(i+1)₍ⱼ₊₁₎ and connects to the fourth node N4. The third end portion 2223 and the fourth end portion 2224 may collectively be located on a side of the anode body portion 221 close to the (i+1)-th first pixel circuit column 10c.

With the arrangement shown in FIG. 13 and FIG. 14, the connection end portion of the anode connection portion 222 of the p_{(q+1)}-th light-emitting element 20p_{(q+1)} close to the anode body portion 221 and the connection end portion of the anode connection portion 222 of the (p+1)_{(q+1)}-th light-emitting element 20(p+1)_{(q+1)} close to the anode body portion 221 are respectively located on the same side of their respective anode body portions 221 (such as the right side in the figures). That is, in the light-emitting element R of the first color and the light-emitting element B of the second color adjacent to each other along the second direction Y, parts of the anode connection portions 222 close to their respective anode body portions 221 have the same orientation. This arrangement can avoid the issue of increased wiring difficulty due to limited space when the first end portion 2221 of the (p+1)_{(q+1)}-th light-emitting element 20(p+1)_{(q+1)} and the second end portion 2222 of the p_{(q+1)}-th light-emitting element 20p_{(q+1)} are disposed between the anode body portions 221 of the (p+1)_{(q+1)}-th light-emitting element 20(p+1)_{(q+1)} and p_{(q+1)}-th light-emitting element 20p_{(q+1)}, ensuring that both the first end portion 2221 and the second end portion 2222 have a larger wiring space.

In the embodiments shown in FIG. 15 and FIG. 16, the anode connection portion 222 of the (p+1)_{(q+1)}-th light-emitting element 20(p+1)_{(q+1)} includes a fifth end portion 2225 and a sixth end portion 2226. The fifth end portion 2225 is close to the anode body portion 221 of the (p+1)_{(q+1)}-th light-emitting element 20(p+1)_{(q+1)} in a direction within the plane of the substrate 40 and connects to the anode body portion 221. The sixth end portion 2226 extends toward the fourth node N4 of the i₍ⱼ₊₁₎-th first pixel circuit 10i₍ⱼ₊₁₎ and connects to the fourth node N4. The fifth end portion 2225 is located on a side of the anode body portion 221 close to the i-th first pixel circuit column 10c, that is, the fifth end portion 2225 is located on a side of the anode body portion 221 close to the p_{(q+1)}-th light-emitting element 20p_{(q+1)}. This can be interpreted as the following: the anode connection portion 222 of the (p+1)_{(q+1)}-th light-emitting element 20(p+1)_{(q+1)} first extends a certain length through the fifth end portion 2225 toward the i-th first pixel circuit column 10c and then connects to the fourth node N4 through the sixth end portion 2226. The anode connection portion 222 of the p_{(q+1)}-th light-emitting element 20p_{(q+1)} includes a seventh end portion 2227 and an eighth end portion 2228. The seventh end portion 2227 is close to the anode body portion 221 in a direction within the plane of the substrate 40 and connects to the anode body portion 221. The eighth end portion 2228 extends toward the fourth node N4 of the (i+1)₍ⱼ₊₁₎-th first pixel circuit 10(i+1)₍ⱼ₊₁₎ and connects to the fourth node N4. The seventh end portion 2227 may be located on a side of the anode body portion 221 away from the (i+1)-th first pixel circuit column 10c, that is, the seventh end portion 2227 is located on a side of the anode body portion 221 away from the (p+1)_{(q+1)}-th light-emitting element 20(p+1)_{(q+1)}. One end of the eighth end portion 2228 connects to the seventh end portion 2227, and another end of the eighth end portion 2228 extends toward the (i+1)₍ⱼ₊₁₎-th first pixel circuit 10(i+1)₍ⱼ₊₁₎ and connects to the fourth node N4.

With the arrangement shown in FIG. 15 and FIG. 16, the connection end portion of the anode connection portion 222 of the p_{(q+1)}-th light-emitting element 20p_{(q+1)} close to the anode body portion 221 and the connection end portion of the anode connection portion 222 of the (p+1)_{(q+1)}-th light-emitting element 20(p+1)_{(q+1)} close to the anode body portion 221 are respectively located on the same side of their respective anode body portions 221 (such as the left side in the figure). In the light-emitting element R of the first color and the light-emitting element B of the second color adjacent to each other along the second direction Y, parts of the anode connection portions 222 close to their respective anode body portions 221 have the same orientation. This arrangement can also ensure that both the first end portion 2221 and the second end portion 2222 have a larger wiring space. Additionally, in the embodiments shown in FIG. 15 and FIG. 16, the extension lengths of the anode connection portions 222 of the light-emitting element R of the first color and the light-emitting element B of the second color in the (p+1)-th first light-emitting element column 20c along the second direction Y are approximately the same. For example, both the extension lengths are greater than or equal to the extension length of the anode body portion 221 of the light-emitting element B of the second color along the second direction Y. This arrangement ensures that the lengths of connection lines between the light-emitting elements of different colors in the same first light-emitting element column 20c and the corresponding first pixel circuits 10 are consistent, resulting in approximately same impedances on the signal lines.

In the embodiments shown in FIG. 4, FIG. 8, and FIG. 11 to FIG. 16, the anodes 22 of the multiple light-emitting elements R of the first color in the q-th first light-emitting element row 20r and the corresponding first pixel circuits 10 may be connected in the same manner, and the anodes 22 of the multiple light-emitting elements B of the second color in the q-th first light-emitting element row 20r and the corresponding first pixel circuits 10 may be connected in the same manner, which are both the same as in the related art. It is not required to change the connection manner between the light-emitting elements R of the first color and the light-emitting elements B of the second color in the q-th first light-emitting element row 20r and the corresponding first pixel circuits 10, which can simplify the manufacturing process.

With combined reference to FIG. 4, FIG. 8, and FIG. 11 to FIG. 16, the display panel also includes a substrate 40 and a dummy connection structure 223. The orthographic projection of the dummy connection structure 223 on the plane of the substrate 40 is located on a side of the orthographic projection of the anode body portion 221 of the p_{q}-th light-emitting element 20p_{q} on the plane of the substrate 40; and/or, the orthographic projection of the dummy connection structure 223 on the plane of the substrate 40 is located on a side of the orthographic projection of the anode body portion 221 of the (p+1)_{q}-th light-emitting element 20(p+1)_{q} on the plane of the substrate 40.

With continued reference to the embodiments shown in FIG. 3, FIG. 4, FIG. 8, and FIG. 11 to FIG. 16, the light-emitting elements 20 in different columns of the q-th first light-emitting element row 20r are connected to the first pixel circuits 10 in different columns of the j-th first pixel circuit row 10r, respectively. When q = j and p = i, the distance between the light-emitting elements 20 in the q-th first light-emitting element row 20r and the correspondingly connected first pixel circuits 10 in a direction within the plane of the substrate 40 is relatively short, and the overall extension length of the anode connection portion 222 in the q-th first light-emitting element row 20r is relatively short. The light-emitting elements 20 in at least some columns of the (q+1)-th first light-emitting element row 20r need to connect to the first pixel circuits 10 in an adjacent column. For example, the (p+1)_{(q+1)}-th light-emitting element 20(p+1)_{(q+1)} connects to the i₍ⱼ₊₁₎-th first pixel circuit 10i₍ⱼ₊₁₎, resulting in a relatively long overall extension length of the anode connection portion 222 in the (q+1)-th first light-emitting element row 20r.

When differences exist in the length of the anode connection portion 222 between odd-numbered and even-numbered rows, it may lead to differences in the wiring impedance (alternatively referred to as RC Loading) between pixels in odd-numbered and even-numbered rows, as well as differences in the light reflectance of the anode connection portion, thereby affecting signal transmission and causing visual effect issues. In view of this, embodiments of the present application propose that a dummy connection structure 223 may be further provided in the display panel, and the orthographic projection of the dummy connection structure 223 on the plane of the substrate 40 may be close to the q-th first light-emitting element row 20r.

Exemplarily, in some embodiments, as shown in FIG. 3, FIG. 4, FIG. 8, FIG. 11, and FIG. 12, the orthographic projection of the dummy connection structure 223 on the plane of the substrate is located on a side of the orthographic projection of the anode body portion 221 of the p_{q}-th light-emitting element 20p_{q} on the plane of the substrate, thereby improving the consistency of the wiring impedance between pixels in odd-numbered and even-numbered rows, ensuring that the light reflectance of the anode connection portion 222 in odd-numbered and even-numbered rows is approximately the same, and avoiding uneven display effects in the display panel.

Exemplarily, in some other embodiments, the orthographic projection of the dummy connection structure 223 on the plane of the substrate may be set to be located on a side of the orthographic projection of the anode body portion 221 of the (p+1)_{q}-th light-emitting element 20(p+1)_{q} on the plane of the substrate. This embodiment is not shown in the figures of the present application, and can be obtained by adaptive adjustments on the embodiments shown in FIG. 4, FIG. 8, FIG. 11, and FIG. 12.

Exemplarily, in some other embodiments, the orthographic projection of the dummy connection structure 223 on the plane of the substrate may be set to be located on a side of the orthographic projection of the anode body portion 221 of the p_{q}-th light-emitting element 20p_{q} on the plane of the substrate, and the orthographic projection of the dummy connection structure 223 on the plane of the substrate is located on a side of the orthographic projection of the anode body portion 221 of the (p+1)_{q}-th light-emitting element 20(p+1)_{q} on the plane of the substrate. The above solution is not detailed in the embodiments of the present application, and can be obtained by adaptive adjustments on the foregoing embodiments.

With reference to FIG. 13, there is a gap between the orthographic projection of the anode body portion of the p_{q}-th light-emitting element on the plane of the substrate and the orthographic projection of the dummy connection structure 223 on the plane of the substrate; and/or there is a gap between the orthographic projection of the anode body portion of the (p+1)_{q}-th light-emitting element on the plane of the substrate and the orthographic projection of the dummy connection structure 223 on the plane of the substrate.

The presence of the gap between the orthographic projection of the anode body portion of the p_{q}-th light-emitting element on the plane of the substrate and the orthographic projection of the dummy connection structure 223 on the plane of the substrate can be understood as the anode body portion of the p_{q}-th light-emitting element being insulated from the dummy connection structure 223. The presence of the gap between the orthographic projection of the anode body portion of the (p+1)_{q}-th light-emitting element on the plane of the substrate and the orthographic projection of the dummy connection structure 223 on the plane of the substrate can be understood as the anode body portion of the (p+1)_{q}-th light-emitting element being insulated from the dummy connection structure 223. In this case, the arrangement of the dummy connection structure 223 can ensure that the distribution density or coverage area of metal structures is the same for different rows of pixel circuits. In this way,, it is ensured that the light transmittance and reflectance are the same or approximately the same for different rows of pixel circuits, thereby ensuring that the light transmission effect and visual effect of the display panel are uniform or approximately uniform.

With reference to FIG. 4 and FIG. 11, the anode body portion of the p_{q}-th light-emitting element is electrically connected to the dummy connection structure 223; and/or the anode body portion of the (p+1)_{q}-th light-emitting element is electrically connected to the dummy connection structure 223.

The anode body portion of the p_{q}-th light-emitting element is electrically connected to the dummy connection structure 223, while the dummy connection structure 223 is not electrically connected to the first pixel circuit, avoiding display anomalies due to the same anode connecting to two first pixel circuits. Moreover, the anode body portion of the (p+1)_{q}-th light-emitting element is electrically connected to the dummy connection structure 223, while the dummy connection structure 223 is not electrically connected to the first pixel circuit, avoiding display anomalies due to the same anode connecting to two first pixel circuits. The electrical connection between the anode body portion of the p_{q}-th light-emitting element and the dummy connection structure 223, and/or the electrical connection between the anode body portion of the (p+1)_{q}-th light-emitting element and the dummy connection structure 223 can ensure that the distribution density or coverage area of metal structures is the same for different rows of pixel circuits, ensuring that the light transmittance and reflectance are identical or approximately identical for different rows of pixel circuits and that the light transmission effect and visual effect of the display panel are uniform or approximately uniform. Moreover, it is ensured that the wiring impedance (alternatively referred to as RC Loading) of the anode connection portions in the anodes of light-emitting elements of the same color at different positions is consistent or approximately consistent, ensuring that the display effects of light-emitting elements of the same color at different positions are consistent or approximately consistent, avoiding display differences among light-emitting elements of the same color at different positions, and ensuring good overall display uniformity of the display panel.

The shape of the dummy connection structure 223 is approximately same as the shape of the anode connection portion 222. The dummy connection structure 223 has a length L1 and a width D1, and the anode connection portion 222 has a length L2 and a width D2, where |L1 - L2|/L1 ≤ 20%, and |D1 - D2|/D1 ≤ 20%. As shown in FIG. 4 and FIG. 9 to FIG. 12, the dummy connection structure 223 may be set to have the same or approximately same shape, length, and width as the anode connection portion 222, further improving the consistency of wiring impedance between pixels in odd-numbered and even-numbered rows.

Optionally, with continued reference to FIG. 4, FIG. 8, FIG. 11, and FIG. 12, the dummy connection structure 223 and the anode connection portion 222 are staggered with each other in the first direction X and/or the second direction Y.

As shown in FIG. 4, FIG. 8, FIG. 11, and FIG. 12, the extension length of the anode connection portion 222 of the (p+1)_{(q+1)}-th light-emitting element 20(p+1)_{(q+1)} (light-emitting element R of the first color) is relatively long. To balance the impedance of this anode connection portion 222, the dummy connection structure 223 may be configured to overlap with the light-emitting element R of the first color in the q-th first light-emitting element row 20r, or there is a gap between the dummy connection structure 223 and the light-emitting element R of the first color in the q-th first light-emitting element row 20r. The dummy connection structure 223 and the anode connection portion 222 are located in different first light-emitting element rows 20r, so they are staggered with each other along the second direction Y.

Based on the solution where the light-emitting elements R of the first color and the light-emitting elements B of the second color are alternately arranged along both the first direction X and the second direction Y, in the q-th first light-emitting element row 20r, the light-emitting element R of the first color closer to the (p+1)_{(q+1)}-th light-emitting element 20(p+1)_{(q+1)} is the (p+2)_{q}-th light-emitting element (the light-emitting element in the (p+2)-th row and q-th column in the figure). Therefore, the dummy connection structure 223 may be configured to overlap with the orthographic projection of the (p+2)_{q}-th light-emitting element, and have shape, length, and width identical to those of the anode connection portion 222 of the (p+1)_{(q+1)}-th light-emitting element 20(p+1)_{(q+1)}. Since the (p+2)_{q}-th light-emitting element and the (p+1)_{(q+1)}-th light-emitting element 20(p+1)_{(q+1)} are staggered with each other along the first direction X, the dummy connection structure 223 and the anode connection portion 222 are staggered with each other along the first direction X. In this manner, the distribution of the dummy connection structure 223 and the anode connection portion 222 within the display panel is relatively uniform, improving impedance consistency while ensuring display effects.

In other words, there is a gap between the orthographic projections of two adjacent anode connection portions 222 on the substrate. Along the first direction, the orthographic projection of the dummy connection structure 223 on the substrate overlaps with the gap; or along the first direction, the orthographic projection of the dummy connection structure 223 on the substrate is located between the orthographic projections of two adjacent anode connection portions 222 on the substrate.

Optionally, in some embodiments, the dummy connection structure 223 and the anode connection portion 222 are disposed in the same layer. In this manner, the dummy connection structure 223 and the anode connection portion 222 can be prepared in the same manufacturing process, which not only simplifies the manufacturing process but also ensures the accuracy of the positions of the formed dummy connection structure 223 and anode connection portion 222, thereby ensuring the impedance balancing effect of the dummy connection structure 223 on the anode connection portion 222.

In summary, the foregoing embodiments, the first pixel circuit column group 100 includes one first pixel circuit column 10c and the second pixel circuit column group 101 includes one first pixel circuit column 10c, for example. It can be understood that the first pixel circuit column group 100 may alternatively include at least two first pixel circuit columns 10c and the second pixel circuit column group 101 may also include at least two first pixel circuit columns 10c. This case is described below.

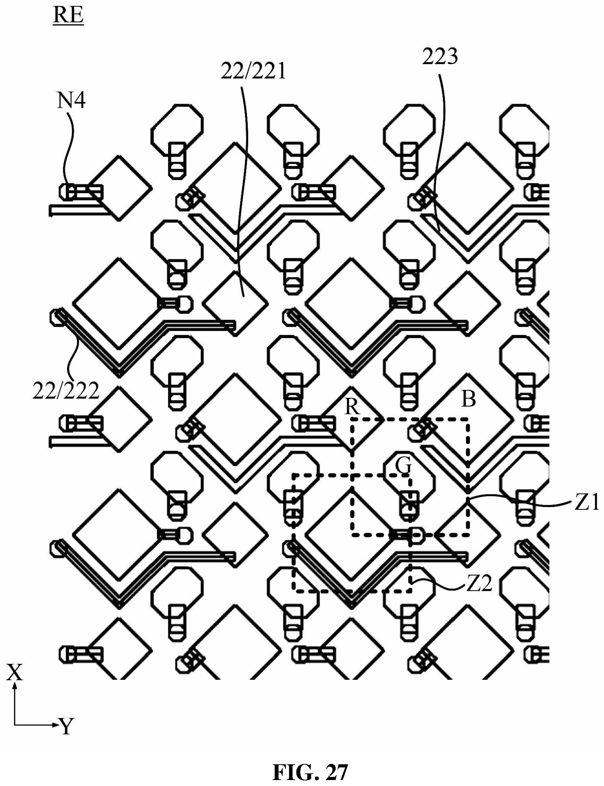

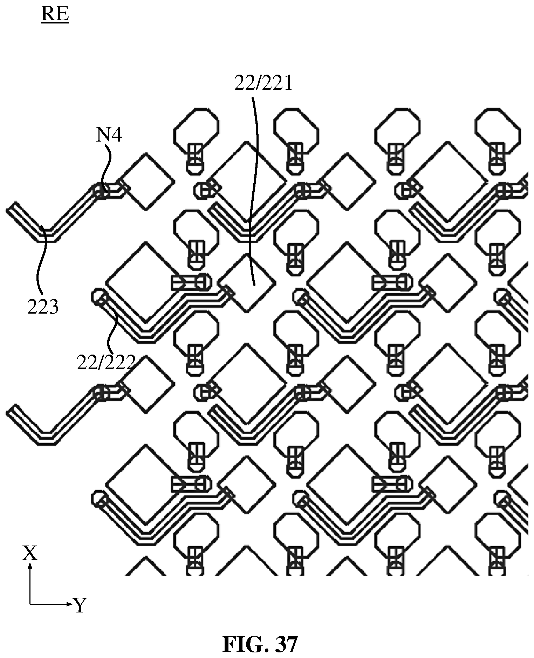

In some embodiments, as shown in FIG. 27 and FIG. 37, the dummy connection structure 223 and the anode body portion are disposed in the same layer.

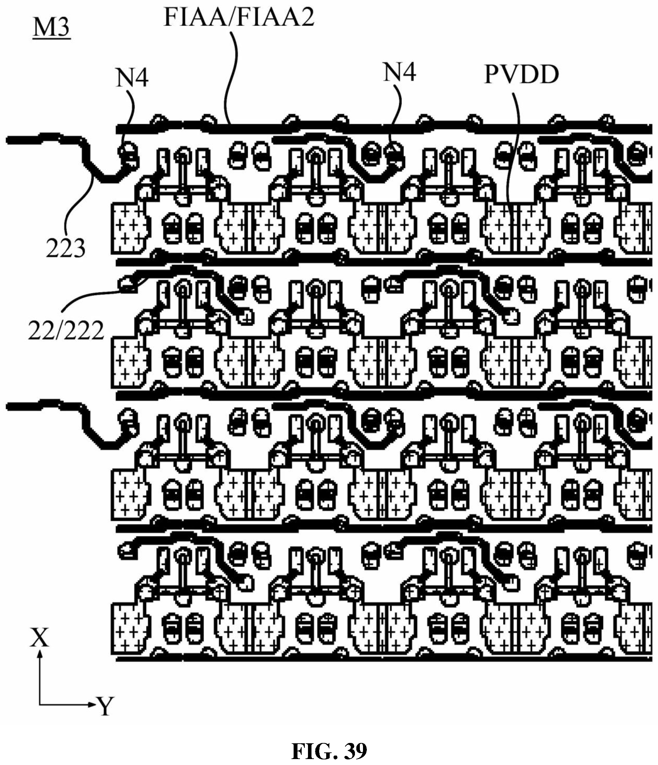

In some other embodiments, as shown in FIG. 39, FIG. 41, and FIG. 42, the dummy connection structure 223 and the anode body portion are disposed in different layers.

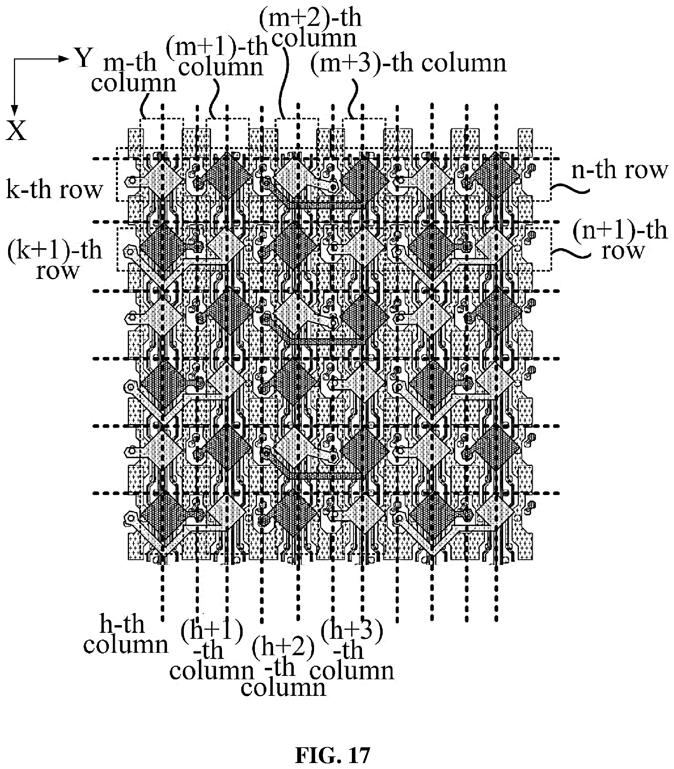

FIG. 17 is a diagram illustrating the structure of yet another display panel according to an embodiment of the present application. With continued reference to FIG. 17, at least some adjacent first pixel circuit column group 100 and second pixel circuit column group 101 include an h-th first pixel circuit column 10c, an (h+1)-th first pixel circuit column 10c, an (h+2)-th first pixel circuit column 10c, and an (h+3)-th first pixel circuit column 10c. At least one pair of adjacent first pixel circuits 10 in the h-th first pixel circuit column 10c include an hₖ-th first pixel circuit 10 and an h₍ₖ₊₁₎-th first pixel circuit 10, at least one pair of adjacent first pixel circuits 10 in the (h+1)-th first pixel circuit column 10c include an (h+1)ₖ-th first pixel circuit 10 and an (h+1)₍ₖ₊₁₎-th first pixel circuit 10, at least one pair of adjacent first pixel circuits 10 in the (h+2)-th first pixel circuit column 10c include an (h+2)ₖ-th first pixel circuit 10 and an (h+2)₍ₖ₊₁₎-th first pixel circuit 10, and at least one pair of adjacent first pixel circuits 10 in the (h+3)-th first pixel circuit column 10c include an (h+3)ₖ-th first pixel circuit 10 and an (h+3)₍ₖ₊₁₎-th first pixel circuit 10. At least one group of four adjacent first light-emitting element columns 20c include an m-th first light-emitting element column 20c, an (m+1)-th first light-emitting element column 20c, an (m+2)-th first light-emitting element column 20c, and an (m+3)-th first light-emitting element column 20c. At least one pair of adjacent light-emitting elements in the m-th first light-emitting element column 20c include an mₙ-th light-emitting element and an m₍ₙ₊₁₎-th light-emitting element, at least one pair of adjacent light-emitting elements in the (m+1)-th first light-emitting element column 20c include an (m+1)ₙ-th light-emitting element and an (m+1)₍ₙ₊₁₎-th light-emitting element, at least one pair of adjacent light-emitting elements in the (m+2)-th first light-emitting element column 20c include an (m+2)ₙ-th light-emitting element and an (m+2)₍ₙ₊₁₎-th light-emitting element, and at least one pair of adjacent light-emitting elements in the (m+3)-th first light-emitting element column 20c include an (m+3)ₙ-th light-emitting element and an (m+3)₍ₙ₊₁₎-th light-emitting element. h, k, m, and n are all positive integers. The hₖ-th first pixel circuit 10 is electrically connected to the mₙ-th light-emitting element, the h₍ₖ₊₁₎-th first pixel circuit 10 is electrically connected to the (m+1)₍ₙ₊₁₎-th light-emitting element, the (h+1)ₖ-th first pixel circuit 10 is electrically connected to the (m+1)ₙ-th light-emitting element, the (h+1)₍ₖ₊₁₎-th first pixel circuit 10 is electrically connected to the m₍ₙ₊₁₎-th light-emitting element, the (h+2)ₖ-th first pixel circuit 10 is electrically connected to the (m+3)ₙ-th light-emitting element, the (h+2)₍ₖ₊₁₎-th first pixel circuit 10 is electrically connected to the (m+2)₍ₙ₊₁₎-th light-emitting element, the (h+3)ₖ-th first pixel circuit 10 is electrically connected to the (m+2)ₙ-th light-emitting element, and the (h+3)₍ₖ₊₁₎-th first pixel circuit 10 is electrically connected to the (m+3)₍ₙ₊₁₎-th light-emitting element.

As shown in FIG. 17, FIG. the h-th first pixel circuit column 10c, the (h+1)-th first pixel circuit column 10c, the (h+2)-th first pixel circuit column 10c, and the (h+3)-th first pixel circuit column 10c are arranged along the second direction Y to form a repeating unit. The two adjacent first pixel circuits in the h-th first pixel circuit column 10c are the hₖ-th first pixel circuit 10 and the h₍ₖ₊₁₎-th first pixel circuit 10, respectively. The two adjacent first pixel circuits in the (h+1)-th first pixel circuit column 10c are the (h+1)ₖ-th first pixel circuit 10 and the (h+1)₍ₖ₊₁₎-th first pixel circuit 10, respectively. The two adjacent first pixel circuits in the (h+2)-th first pixel circuit column 10c are the (h+2)ₖ-th first pixel circuit 10 and the (h+2)₍ₖ₊₁₎-th first pixel circuit 10, respectively. The two adjacent first pixel circuits in the (h+3)-th first pixel circuit column 10c are the (h+3)ₖ-th first pixel circuit 10 and the (h+3)₍ₖ₊₁₎-th first pixel circuit 10, respectively. The values of h and k are not limited and may be equal or different. It can be understood that h corresponds to a first pixel circuit column 10c, and k corresponds to a first pixel circuit row 10r, h may be less than the total number of the first pixel circuit columns 10c, and k may be less than the total number of the first pixel circuit rows 10r.

The four adjacent first light-emitting element columns 20c may be the m-th first light-emitting element column 20c, the (m+1)-th first light-emitting element column 20c, the (m+2)-th first light-emitting element column 20c, and the (m+3)-th first light-emitting element column 20c. The two adjacent light-emitting elements in the m-th first light-emitting element column 20c may be the mₙ-th light-emitting element and the m₍ₙ₊₁)-th light-emitting element. The two adjacent light-emitting elements in the (m+1)-th first light-emitting element column 20c may be the (m+1)ₙ-th light-emitting element and the (m+1)₍ₙ₊₁₎-th light-emitting element. The two adjacent light-emitting elements in the (m+2)-th first light-emitting element column 20c may be the (m+2)ₙ-th light-emitting element and the (m+2)₍ₙ₊₁₎-th light-emitting element. The two adjacent light-emitting elements in the (m+3)-th first light-emitting element column 20c may be the (m+3)ₙ-th light-emitting element and the (m+3)₍ₙ₊₁₎-th light-emitting element. The values of m and n are not limited and may be equal or different. It can be understood that m corresponds to a first light-emitting element column 20c, n corresponds to a first light-emitting element row 20r, m may be less than the total number of first light-emitting element columns 20c, and n may be less than the total number of first light-emitting element rows 20r.

Optionally, the h-th first pixel circuit column 10c and the (h+2)-th first pixel circuit column 10c may refer to the odd-numbered (or even-numbered) first pixel circuit columns of the display panel; the (h+1)-th column pixel circuit column 10c and the (h+3)-th first pixel circuit column 10c may refer to the even-numbered (or odd-numbered) first pixel circuit columns of the display panel. The k-th first pixel circuit row 10r may refer to the odd-numbered (or even-numbered) first pixel circuit rows of the display panel, and the (k+1)-th row may refer to the even-numbered (or odd-numbered) first pixel circuit rows of the display panel. The m-th first light-emitting element column 20c and the (m+2)-th first light-emitting element column 20c may refer to the odd-numbered (or even-numbered) first light-emitting element columns 20c of the display panel. The (m+1)-th first light-emitting element column 20c and the (m+3)-th first light-emitting element column 20c may refer to the even-numbered (or odd-numbered) first light-emitting element columns 20c of the display panel. The n-th row may refer to the odd-numbered (or even-numbered) first light-emitting element row 20r of the display panel. The (n+1)-th row may refer to the even-numbered (or odd-numbered) first light-emitting element row 20r of the display panel.

As shown in FIG. 17, the k-th first pixel circuit 10 in the h-th column (that is, the hₖ-th first pixel circuit 10) may be electrically connected to the n-th light-emitting element in the m-th column, (that is, the mₙ-th light-emitting element); the (k+1)-th first pixel circuit 10 in the h-th column (that is, the h₍ₖ₊₁₎-th first pixel circuit 10) may be electrically connected to the (n+1)-th light-emitting element in the (m+1)-th column (that is, the (m+1)₍ₙ₊₁₎-th light-emitting element); the k-th first pixel circuit 10 in the (h+1)-th column (that is, the (h+1)ₖ-th first pixel circuit 10) may be electrically connected to the n-th light-emitting element in the (m+1)-th column (that is, the (m+1)ₙ-th light-emitting element); the (k+1)-th first pixel circuit 10 in the (h+1)-th column (that is, the (h+1)₍ₖ₊₁₎-th first pixel circuit 10) may be electrically connected to the (n+1)-th light-emitting element in the m-th column (that is, the m₍ₙ₊₁₎-th light-emitting element); the k-th first pixel circuit 10 in the (h+2)-th column (that is, the (h+2)ₖ-th first pixel circuit 10) may be electrically connected to n-th light-emitting element in the (m+3)-th column (that is, the (m+3)ₙ-th light-emitting element); the (k+1)-th first pixel circuit 10 in the (h+2)-th column (that is, the (h+2)₍ₖ₊₁₎-th first pixel circuit 10) may be electrically connected to the (n+1)-th light-emitting element in the (m+2)-th column (that is, the (m+2)₍ₙ₊₁₎-th light-emitting element); the k-th first pixel circuit 10 in the (h+3)-th column (that is, the (h+3)ₖ-th first pixel circuit 10) may be electrically connected to the n-th light-emitting element in the (m+2)-th column (that is, the (m+2)ₙ-th light-emitting element); and the (k+1)-th first pixel circuit 10 in the (h+3)-th column (that is, the (h+3)₍ₖ₊₁₎-th first pixel circuit 10) may be electrically connected to the (n+1)-th light-emitting element in the (m+3)-th column (that is, the (m+3)₍ₙ₊₁₎-th light-emitting element).

To explain, in the h-th first pixel circuit column 10c, some of the first pixel circuits 10 are electrically connected to the light-emitting elements R of the first color in the m-th first light-emitting element column, and some other first pixel circuits of the first pixel circuits 10 are electrically connected to the light-emitting elements R of the first color in the (m+1)-th first light-emitting element column. Moreover, the first pixel circuits 10 connected to the light-emitting elements R of the first color in the m-th first light-emitting element column 20c and the first pixel circuits 10 connected to the light-emitting elements R of the first color in the (m+1)-th first light-emitting element column 20c are alternately arranged along the first direction X. In the (h+1)-th first pixel circuit column 10c, some of the first pixel circuits 10 are electrically connected to the light-emitting elements B of the second color in the m-th first light-emitting element column 20c, and some other first pixel circuits of the first pixel circuits 10 are electrically connected to the light-emitting elements B of the second color in the (m+1)-th first light-emitting element column 20c. Moreover, the first pixel circuits 10 connected to the light-emitting elements B of the second color in the m-th first light-emitting element column 20c and the first pixel circuits 10 connected to the light-emitting elements B of the second color in the (m+1)-th first light-emitting element column 20c are alternately arranged along the first direction X. The light-emitting elements R of the first color in the m-th first light-emitting element column 20c and the (m+1)-th first light-emitting element column 20c may be electrically connected to the first pixel circuits 10 in the h-th first pixel circuit column 10c. The light-emitting elements B of the second color in the m-th first light-emitting element column 20c and the (m+1)-th first light-emitting element column 20c may be electrically connected to the first pixel circuits 10 in the (h+1)-th first pixel circuit column 10c.

In the (h+2)-th first pixel circuit column 10c, some of the first pixel circuits 10 are electrically connected to the light-emitting elements B of the second color in the (m+2)-th first light-emitting element column, and some other first pixel circuits of the first pixel circuits 10 are electrically connected to the light-emitting elements B of the second color in the (m+3)-th first light-emitting element column. Moreover, the first pixel circuits 10 connected to the light-emitting elements B of the second color in the (m+3)-th first light-emitting element column 20c and the first pixel circuits 10 connected to the light-emitting elements B of the second color in the (m+2)-th first light-emitting element column are alternately arranged along the first direction X. In the (h+3)-th first pixel circuit column 10c, some of the first pixel circuits 10 are electrically connected to the light-emitting elements R of the first color in the (m+2)-th first light-emitting element column, and some other first pixel circuits of the first pixel circuits 10 are electrically connected to the light-emitting elements R of the first color in the (m+3)-th first light-emitting element column. Moreover, the first pixel circuits 10 connected to the light-emitting elements R of the first color in the (m+2)-th first light-emitting element column 20c and the first pixel circuits 10 connected to the light-emitting elements R of the first color in the (m+3)-th first light-emitting element column are alternately arranged along the first direction X. The light-emitting elements B of the second color in the (m+2)-th first light-emitting element column 20c and the (m+3)-th first light-emitting element column 20c may be electrically connected to the first pixel circuits 10 in the (h+2)-th first pixel circuit column 10c. The light-emitting elements R of the first color in the (m+2)-th first light-emitting element column 20c and the (m+3)-th first light-emitting element column 20c may be electrically connected to the first pixel circuits 10 in the (h+3)-th first pixel circuit column 10c.

Exemplarily, h, k, m, and n are all equal to 1, for example. The 1^{st} first pixel circuit 10 in the 1^{st} column may be electrically connected to the 1^{st} light-emitting element in the 1^{st} column (light-emitting element R of the first color). The 2^{nd} first pixel circuit 10 in the 1^{st} column may be electrically connected to the 2^{nd} light-emitting element in the 2^{nd} column (light-emitting element R of the first color). The 1^{st} first pixel circuit 10 in the 2^{nd} column may be electrically connected to the 1^{st} light-emitting element in the 2^{nd} column (light-emitting element B of the second color). The 2^{nd} first pixel circuit 10 in the 2^{nd} column may be electrically connected to the 2^{nd} light-emitting element in the 1^{st} column (light-emitting element B of the second color). The 1^{st} first pixel circuit 10 in the 3^{rd} column may be electrically connected to the 1^{st} light-emitting element in the 4^{th} column (light-emitting element B of the second color). The 2^{nd} first pixel circuit 10 in the 3^{rd} column may be electrically connected to the 2^{nd} light-emitting element in the 3^{rd} column (light-emitting element B of the second color). The 1^{st} first pixel circuit 10 in the 4^{th} column may be electrically connected to the 1^{st} light-emitting element in the 3^{rd} column (light-emitting element R of the first color). The 2^{nd} first pixel circuit 10 in the 4^{th} column may be electrically connected to the 2^{nd} light-emitting element in the 4^{th} column (light-emitting element R of the first color).

It should be noted that the light-emitting elements in the m-th column, (m+1)-th column, (m+2)-th column, and (m+3)-th column described above are light-emitting elements in adjacent first light-emitting element columns 20c, excluding the light-emitting elements in the second light-emitting element column (not shown in the figures).

Optionally, with continued reference to FIG. 9, FIG. 10, and FIG. 17, the light-emitting element 20 includes an anode 22, and the anode 22 includes an anode body portion 221 and an anode connection portion 222 connected to each other. The display panel also includes a pixel definition layer 30 and multiple pixel openings 31 in the pixel definition layer 30. Along the thickness direction of the display panel, the anode body portion 221 overlaps with a pixel opening 31, and the anode connection portion 222 does not overlap with the pixel opening 31. The h₍ₖ₊₁₎-th first pixel circuit 10 is electrically connected to the anode connection portion 222 of the (m+1)₍ₙ₊₁₎-th light-emitting element, and the (h+2)ₖ-th first pixel circuit 10 is electrically connected to the anode connection portion 222 of the (m+3)ₙ-th light-emitting element.

The configuration of the pixel definition layer 30 is the same as in the foregoing embodiments, and the relative positional relationships respectively of the anode body portion 221 and the anode connection portion 222 with respect to the pixel opening 31 are also the same as in the foregoing embodiments, which will not be repeated here. Similar to the foregoing embodiments, in this embodiment, the anode body portion 221 is electrically connected to the corresponding first pixel circuit 10 through the anode connection portion 222, thereby achieving the electrical connection between the light-emitting element and the pixel circuit.

Exemplarily, the hₖ-th first pixel circuit 10 is electrically connected to the anode connection portion 222 of the mₙ-th light-emitting element, the h₍ₖ₊₁₎-th first pixel circuit 10 is electrically connected to the anode connection portion 222 of the (m+1)₍ₙ₊₁₎-th light-emitting element, the (h+1)ₖ-th first pixel circuit 10 is electrically connected to the anode connection portion 222 of the (m+1)ₙ-th light-emitting element, the (h+1)₍ₖ₊₁₎-th first pixel circuit 10 is electrically connected to the anode connection portion 222 of the m₍ₙ₊₁₎-th light-emitting element, the (h+2)ₖ-th first pixel circuit 10 is electrically connected to the anode connection portion 222 of the (m+3)ₙ-th light-emitting element, the (h+2)₍ₖ₊₁₎-th first pixel circuit 10 is electrically connected to the anode connection portion 222 of the (m+2)₍ₙ₊₁₎-th light-emitting element, the (h+3)ₖ-th first pixel circuit 10 is electrically connected to the anode connection portion 222 of the (m+2)ₙ-th light-emitting element, and the (h+3)₍ₖ₊₁₎-th first pixel circuit 10 is electrically connected to the anode connection portion 222 of the (m+3)₍ₙ₊₁₎-th light-emitting element.

In the embodiment shown in FIG. 17, the corresponding connection relationships between the light-emitting elements in the m-th and (m+1)-th columns and the first pixel circuits 10 in the h-th and (h+1)-th columns are the same as the corresponding connection relationships between the light-emitting elements in the p-th and (p+1)-th columns and the first pixel circuits 10 in the i-th and (j+1)-th columns in the foregoing embodiments. Accordingly, the configuration of the anode connection portions 222 of the light-emitting elements in the m-th and (m+1)-th columns, the configuration of the fourth node N4 of the first pixel circuits 10 in the h-th and (h+1)-th columns, and the connection manner between the anode connection portion 222 and the fourth node N4 may refer to the descriptions of the corresponding embodiments in FIG. 4 and FIG. 11 to FIG. 16. The difference in the embodiment shown in FIG. 17 lies in the configuration of the anode connection portions 222 of the light-emitting elements in the (m+2)-th and (m+3)-th columns and the configuration of the fourth node N4 of the first pixel circuits 10 in the (h+2)-th and (h+3)-th columns.

As shown in FIG. 17, when h, k, m, and n are equal to each other, when orthographically projected on the plane of the substrate 40, the distance between the anode body portion 221 of the (m+2)ₙ-th light-emitting element and the fourth node N4 of the (h+3)ₖ-th first pixel circuit 10 (the distance between their projections along the second direction Y) is smaller than the distance between the anode body portion 221 of the (m+3)ₙ-th light-emitting element and the fourth node N4 of the (h+2)ₖ-th first pixel circuit 10 (the distance between their projections along the second direction Y). Therefore, the extension length of the orthographic projection of the anode connection portion 222 of the (m+2)ₙ-th light-emitting element on the plane of the substrate 40 may be set to be smaller than the extension length of the orthographic projection of the anode connection portion 222 of the (m+3)ₙ-th light-emitting element on the plane of the substrate 40.

Additionally, the anode connection portion 222 of the (m+2)ₙ-th light-emitting element may be located on a side of its anode body portion 221 away from the (h+2)-th first pixel circuit column 10c, and the anode connection portion 222 of the (m+3)ₙ-th light-emitting element may be located on a side of its anode body portion 221 close to the (h+2)-th first pixel circuit column 10c, that is, the anode connection portions 222 of these two light-emitting elements may be disposed facing each other. The anode connection portion 222 of the (m+2)₍ₙ₊₁₎-th light-emitting element may be located on a side of its anode body portion 221 close to the (h+2)-th first pixel circuit column 10c, and the anode connection portion 222 of the (m+3)₍ₙ₊₁₎-th light-emitting element may be located on a side of its anode body portion 221 close to the (h+3)-th first pixel circuit column 10c, that is, the anode connection portions 222 of these two light-emitting elements may be located on the same side of their respective anode body portions 221.

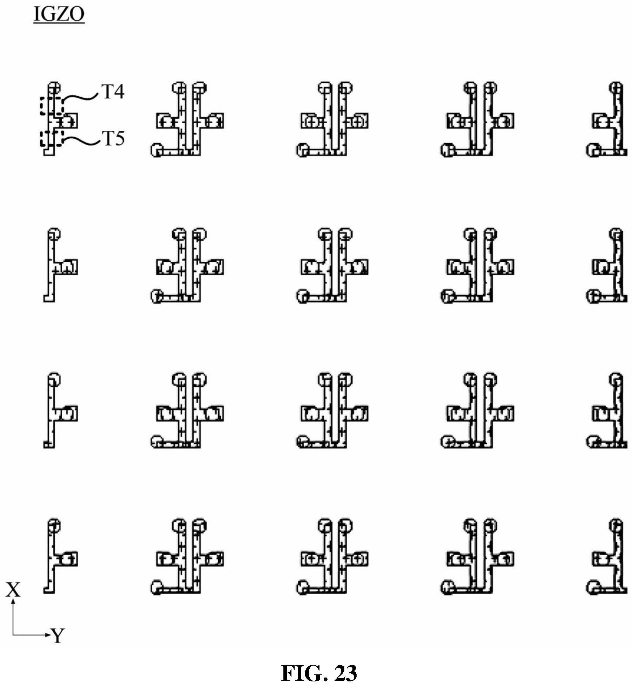

It should be noted that in the embodiment shown in FIG. 17, anode connection portions 222 are provided in both the odd-numbered and even-numbered first light-emitting element rows 20r, resulting in a relatively uniform distribution of the anode connection portions 222. In this case, the dummy connection structure 223 may not be disposed, in order to reduce the number of wirings (as shown in FIG. 17). Alternatively, dummy connection structures 223 may be disposed on two sides of at least some of the anode connection portions 222 along the first direction X and/or the second direction Y (not shown in FIG. 23) such that the anode connection portions 222 and the dummy connection structures 223 overlap with each other along the first direction X and/or the second direction Y, further ensuring in-plane impedance consistency.

Optionally, in embodiments of the present application, the anode connection portion 222 and the anode body portion 221 are disposed in the same layer. Alternatively, the display panel also includes a substrate 40, and the layer where the anode connection portion 222 is located is between the layer where the anode body portion 221 is located and the layer where the substrate 40 is located.

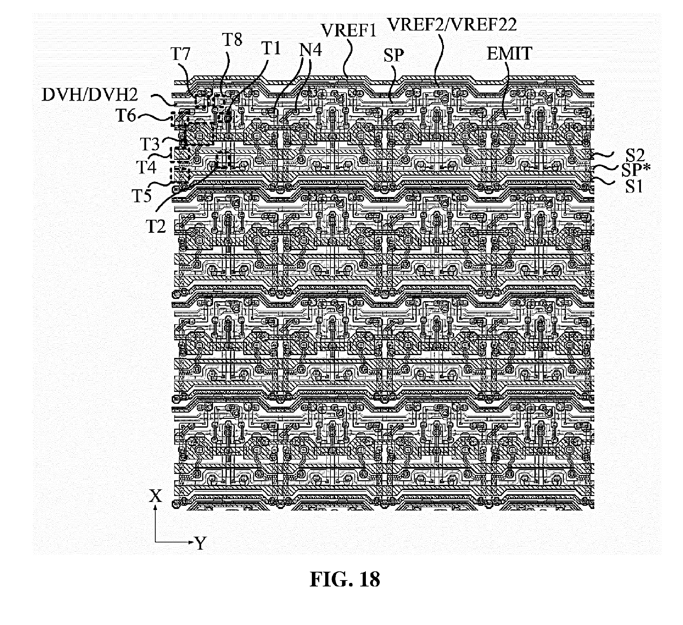

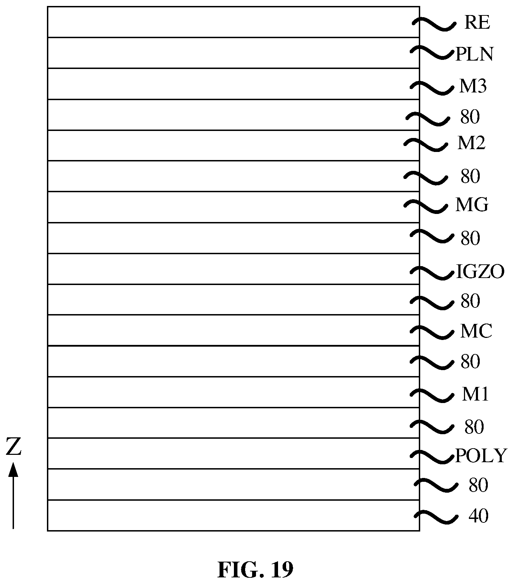

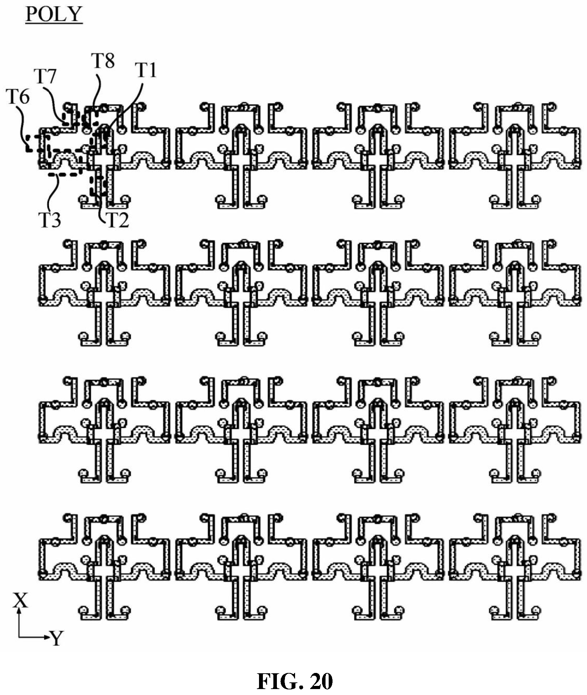

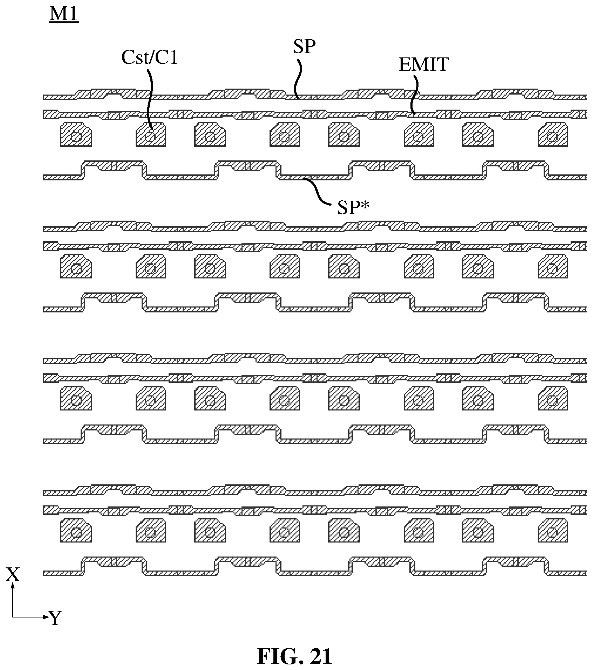

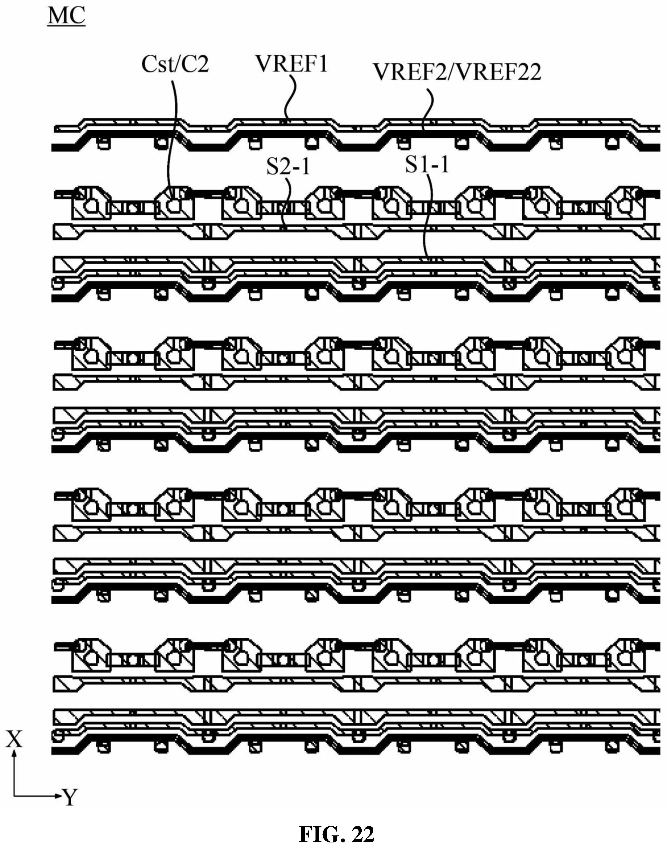

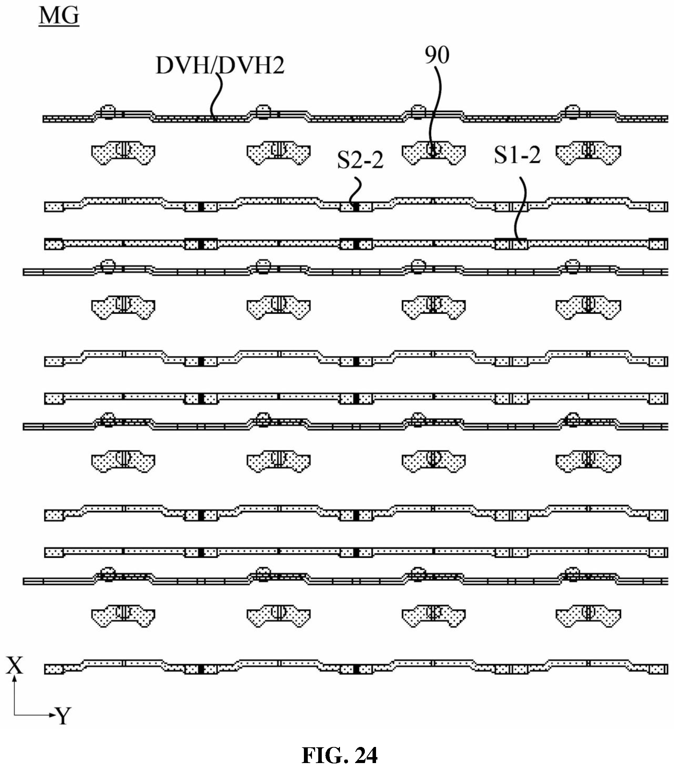

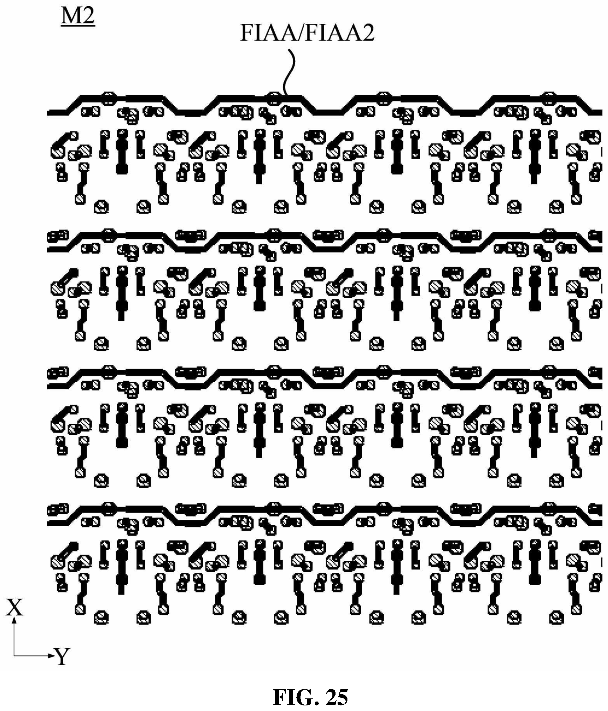

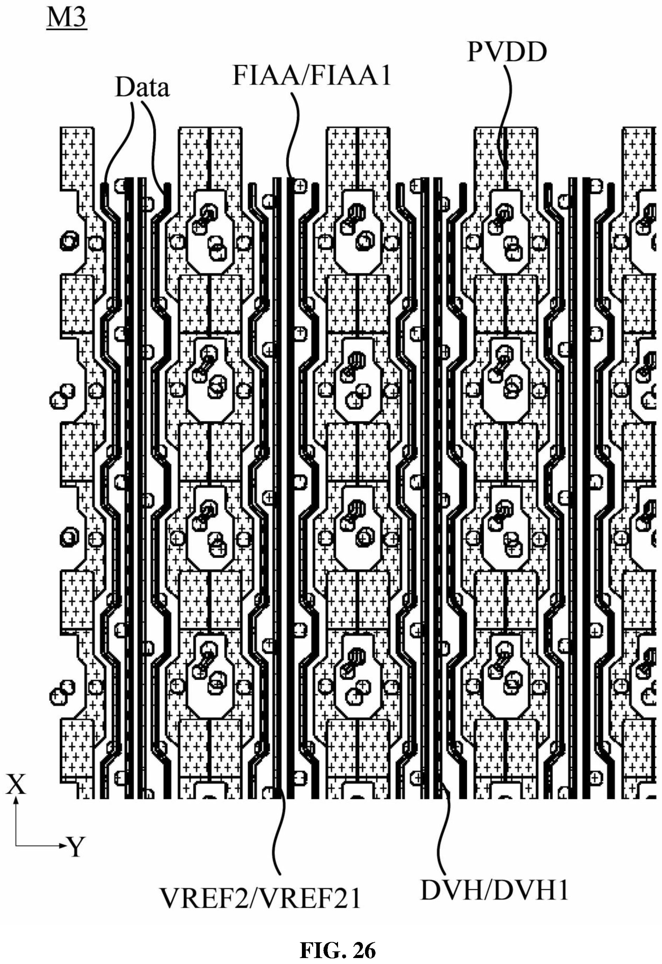

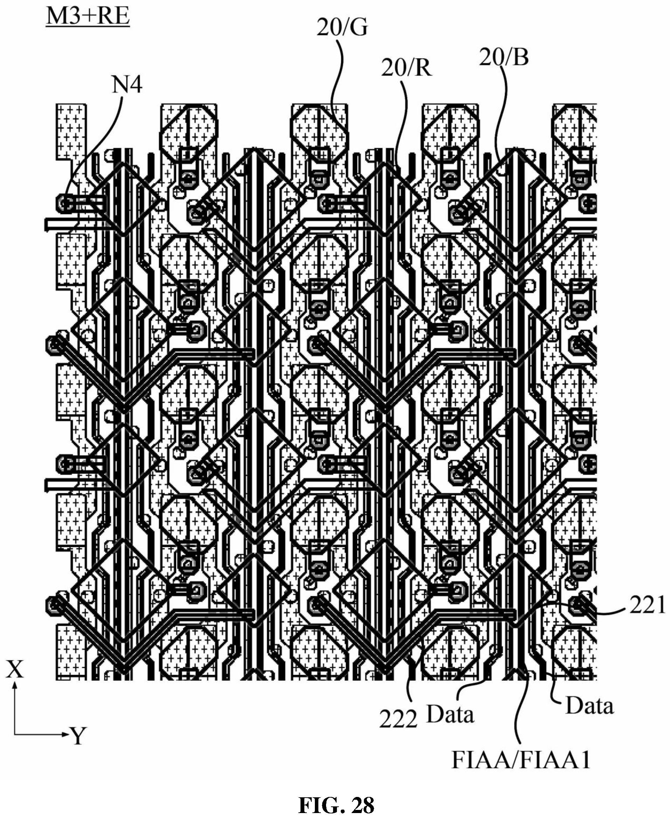

FIG. 18 is a diagram illustrating the structure of another display panel according to an embodiment of the present application. FIG. 19 is a sectional structural diagram of a display panel according to an embodiment of the present application. FIG. 20 is a diagram illustrating part of the structure of the display panel shown in FIG. 19. FIG. 21 is a diagram illustrating another part of the structure of the display panel shown in FIG. 19. FIG. 22 is a diagram illustrating another part of the structure of the display panel shown in FIG. 19. FIG. 23 is a diagram illustrating another part of the structure of the display panel shown in FIG. 19. FIG. 24 is a diagram illustrating another part of the structure of the display panel shown in FIG. 19. FIG. 25 is a diagram illustrating another part of the structure of the display panel shown in FIG. 19. FIG. 26 is a diagram illustrating another part of the structure of the display panel shown in FIG. 19. FIG. 27 is a diagram illustrating another part of the structure of the display panel shown in FIG. 19. FIG. 28 is a diagram illustrating another part of the structure of the display panel shown in FIG. 19. The display panel is formed by multiple staked layers . FIG. 18 shows a top view of some of the stacked layers of the display panel. FIG. 19 shows a overall sectional view of the layers of the display panel. FIGS. 20 to 27 show different layers in the display panel from top to bottom.

With reference to FIG. 18 to FIG. 28, the display panel is an LTPO display panel, for example. Along the thickness direction Z of the display panel, the display panel may include a buffer layer 70, a first semiconductor layer POLY, a first metal layer M1, a second metal layer MC, a second semiconductor layer IGZO, a fifth metal layer MG, a third metal layer M2, a fourth metal layer M3, a planarization layer PLN, and an anode layer, which are disposed on one side of the substrate 40. An insulating layer 80 may be disposed between any two adjacent conductive layers. The third metal layer M2 may be understood as a first source-drain electrode layer. The fourth metal layer M3 may be understood as a second source-drain electrode layer. The anode layer RE may be understood as a layer where the anode body portion 221 is located. The layered configuration of the display panel may be adapted to actual production needs, such as by adding or removing some layers, which is not limited in embodiments of the present application. FIG. 20 is a diagram illustrating the structure of the first semiconductor layer POLY in FIG. 19. FIG. 21 is a diagram illustrating the structure of the first metal layer M1 in FIG. 19. FIG. 22 is a diagram illustrating the structure of the second metal layer MC in FIG. 19. FIG. 23 is a diagram illustrating the structure of the second semiconductor layer IGZO in FIG. 19. FIG. 24 is a diagram illustrating the structure of the fifth metal layer MG in FIG. 19. FIG. 25 is a diagram illustrating the structure of the third metal layer M2 in FIG. 19. FIG. 26 is a diagram illustrating the structure of the fourth metal layer M3 in FIG. 19. FIG. 27 is a diagram illustrating the structure of the anode layer RE in FIG. 19. FIG. 28 is a diagram illustrating the stacked structure of the fourth metal layer M3 and the anode layer RE. To clearly illustrate the multi-layer stacked structure, FIG. 18 does not show all layers, but only illustrates the first semiconductor layer POLY, the first metal layer M1, the second metal layer MC, and the third metal layer M2, while other layer structures may be referenced from the corresponding single-layer diagrams.

With reference to FIG. 6, FIG. 7, and FIG. 18 to FIG. 28, the fourth node N4 of the first pixel circuit 10 connects to the second light emission control transistor T6, the reset transistor T7, and the anode 22 of the light-emitting element 20. The connection region of the second light emission control transistor T6 and the reset transistor T7 may be connected to the anode 22 of the light-emitting element through connection crossover lines in the third metal layer M2 and the fourth metal layer M3, and the fourth node N4 may be the wiring structure at the position where the connection region overlaps with the projections of the third metal layer M2 and the fourth metal layer M3. In this embodiment, the anode connection portion 222 may be disposed in the same layer as the anode body portion 221, both located in the anode layer RE.

As shown in FIG. 6, FIG. 7, and FIG. 18 to FIG. 28, the active layers of the first light emission control transistor T1, the data writing transistor T2, the driving transistor T3, the second light emission control transistor T6, and the reset transistor T7 may be located in the first semiconductor layer POLY, while the active layers of the threshold compensation transistor T4 and the initialization transistor T5 may be located in the second semiconductor layer IGZO. The first metal layer M1 may include a first plate C1 of the storage capacitor Cst, the third scan signal line SP*, and the fourth scan signal line SP. The second metal layer MC may include the first plate C1 of the storage capacitor Cst, the first scan signal line S1-1 extending along the second direction Y, the second scan signal line S2-1, the initialization signal line VREF1, and the reset signal line VREF2. The part of the first scan signal line S1-1 overlapping with the initialization transistor T5 also serves as the bottom gate of the initialization transistor T5. The part of the second scan signal line S2-1 overlapping with the threshold compensation transistor T4 also serves as the bottom gate of the threshold compensation transistor T4. The fifth metal layer MG may include the bias voltage signal line DVH, the first scan signal line S1-2, the second scan signal line S2-2, and part of a shielding structure 90. The part of the first scan signal line S1-2 overlapping with the initialization transistor T5 also serves as the top gate of the initialization transistor T5. The part of the second scan signal line S2-2 overlapping with the threshold compensation transistor T4 also serves as the top gate of the threshold compensation transistor T4. The shielding structure may be located between signal lines with signal switching and the first node and may be configured to be electrically connected to a fixed potential, thereby preventing the switching of other signals from affecting the potential of the first node. The third metal layer M2 may include a data auxiliary line FIAA extending along the second direction Y and some connection crossover lines. A fourth metal layer M3 may be provided between the third metal layer M2 and the planarization layer PLN. The fourth metal layer M3 may include the power signal line PVDD, the data signal line Data, the data auxiliary line FIAA, which extend along the first direction X, and some connection crossover line. The data auxiliary line FIAA may be configured to connect the data signal line Data and the display controller. The connection region of the reset transistor T7 and the second light emission control transistor T6 and some connection crossover line (the connection crossover lines in the third metal layer M2 and the fourth metal layer M3) whose projections overlap with the connection region may be the fourth node N4.

At least one of the initialization signal line VREF1, the reset signal line VREF2, and the bias voltage signal line DVH may have a grid-like structure. That is, at least one of the initialization signal line VREF1, the reset signal line VREF2, and the bias voltage signal line DVH may include at least two layer structures with different extension directions. The grid-like structure can reduce signal loss during transmission and improve the accuracy of signal transmission. With reference to FIG. 18, FIG. 22, FIG. 24, and FIG. 26, the initialization signal line VREF1 may be a single-layer structure located in the second metal layer MC. The reset signal line VREF2 may include two layers. The reset signal line VREF2 may include a first reset signal line VREF21 and a second reset signal line VREF22. The first reset signal line VREF21 extends along the first direction and may be located in the fourth metal layer M3. The second reset signal line VREF22 extends along the second direction and may be located in the second metal layer MC. The bias voltage signal line DVH may include two layers. The bias voltage signal line DVH may include a first bias voltage signal line DVH1 and a second bias voltage signal line DVH2. The first bias voltage signal line DVH1 extends along the first direction and may be located in the fourth metal layer M3. The second bias voltage signal line DVH2 extends along the second direction and may be located in the fifth metal layer MG. Moreover, the first reset signal line VREF21 and the first bias voltage signal line DVH1, both located in the fourth metal layer M3, may be alternately arranged along the second direction.

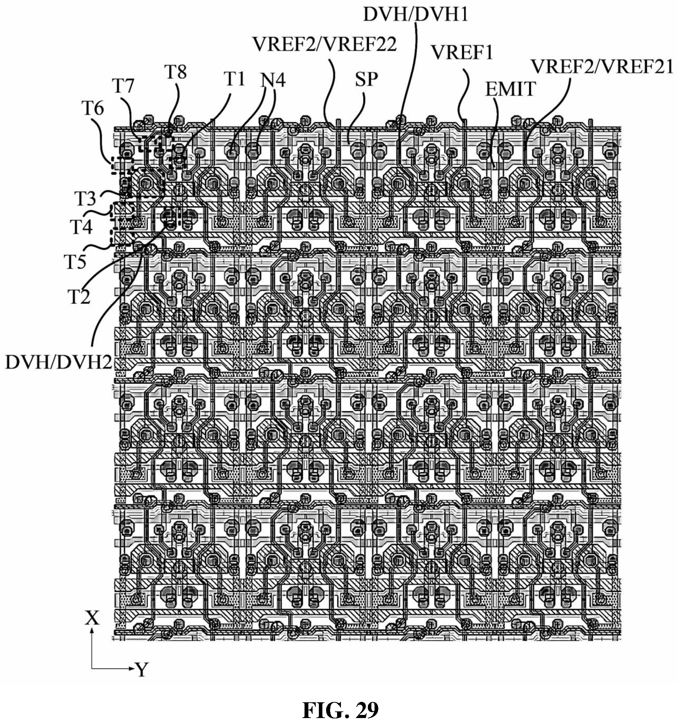

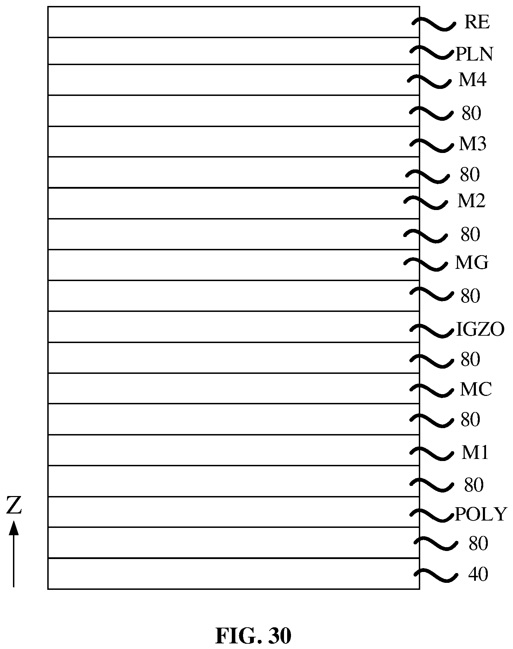

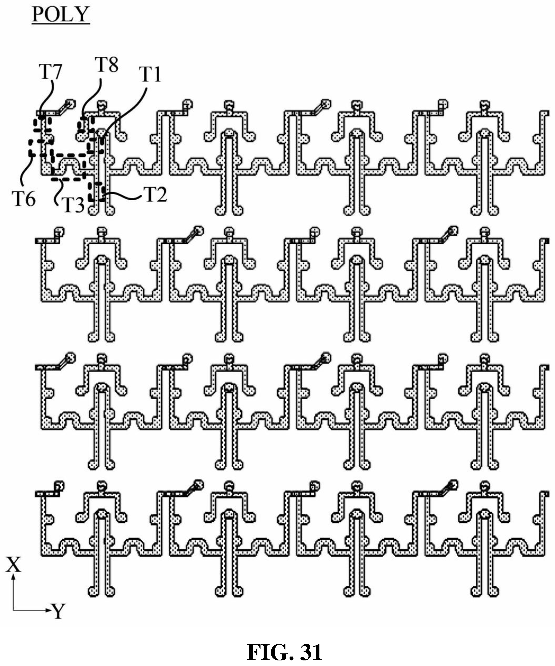

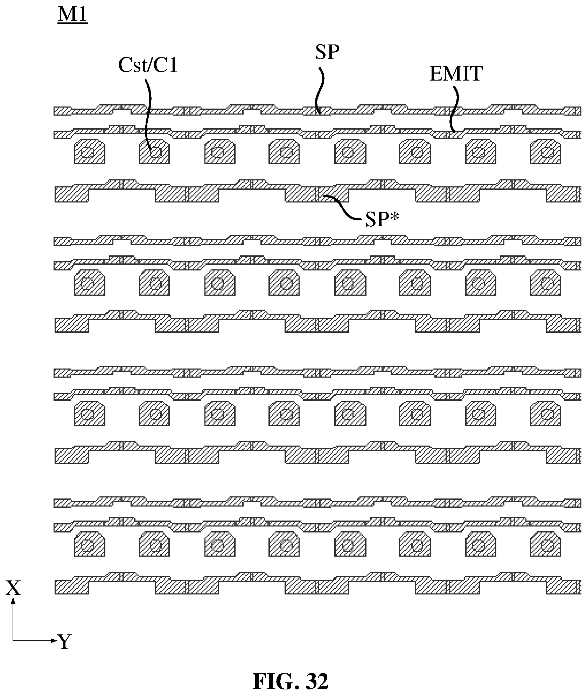

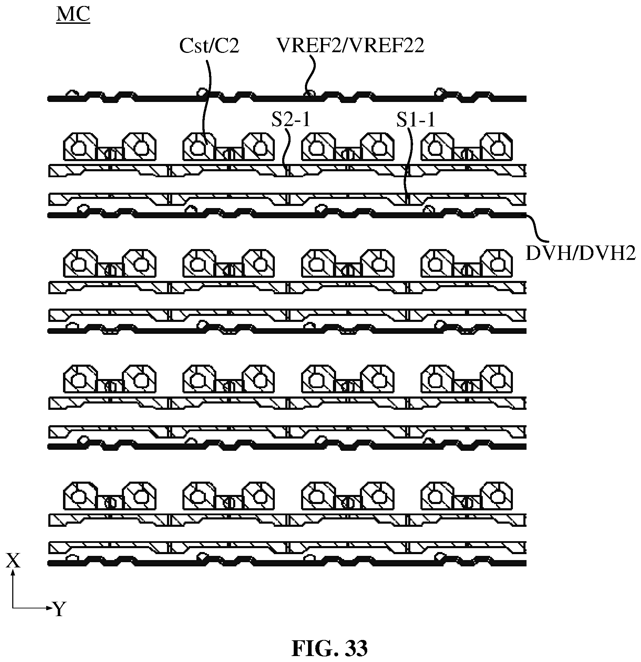

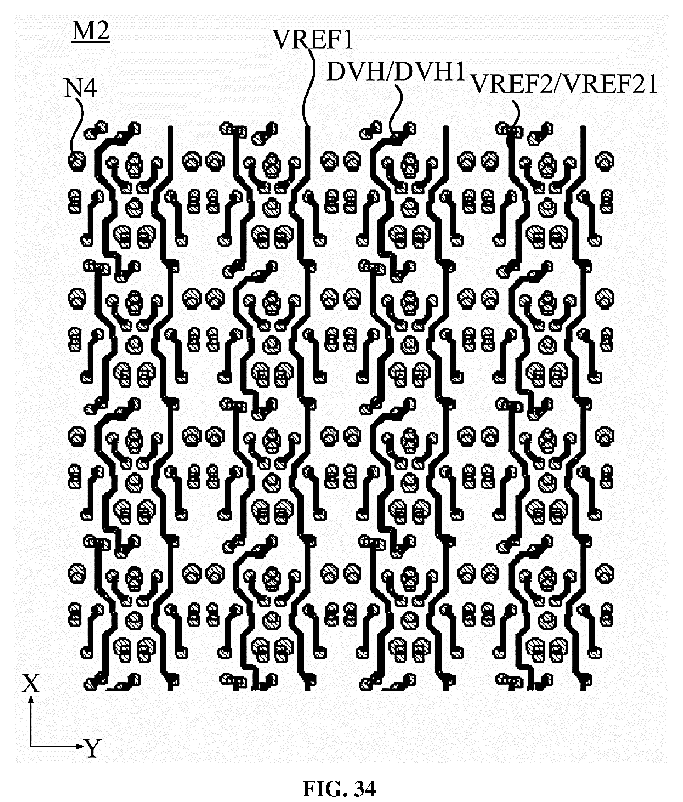

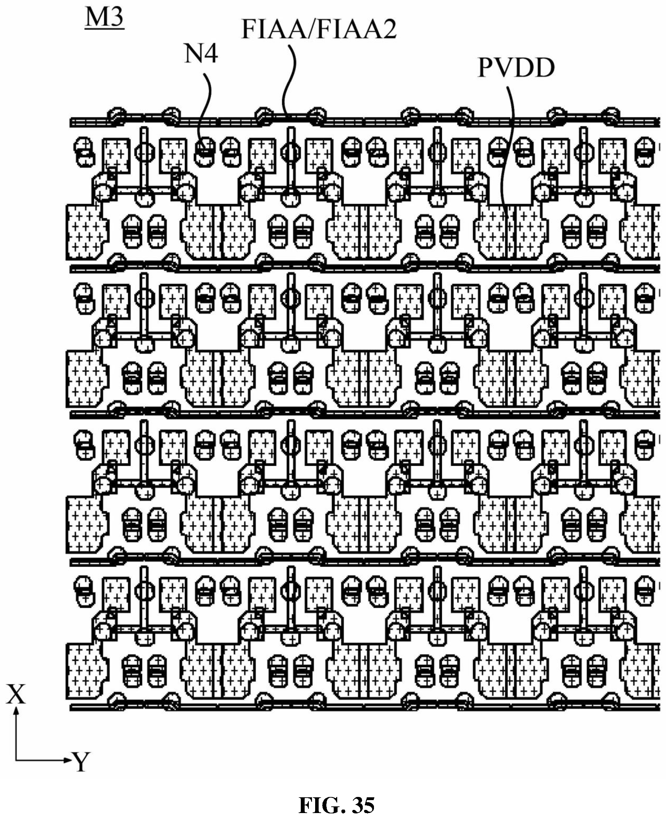

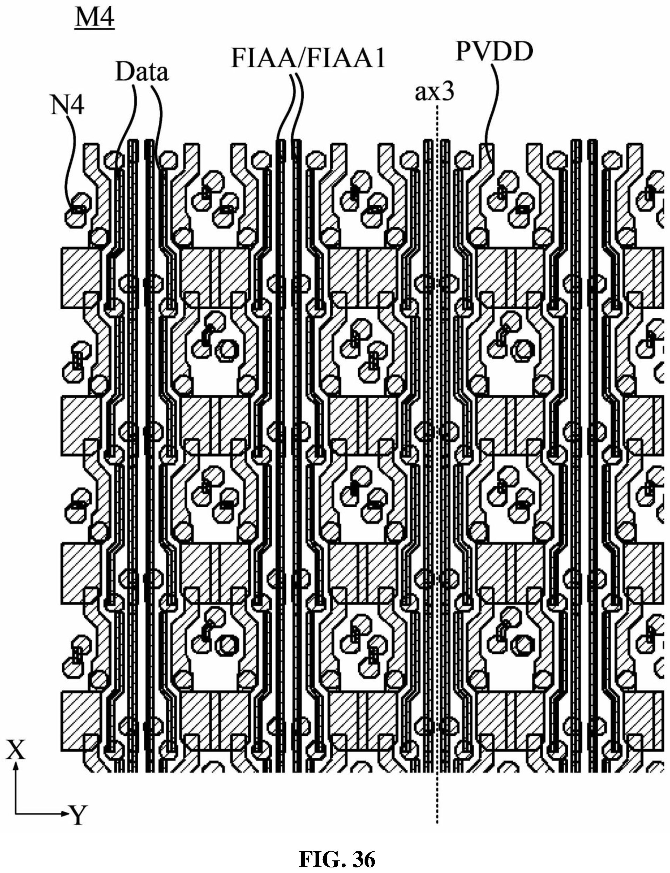

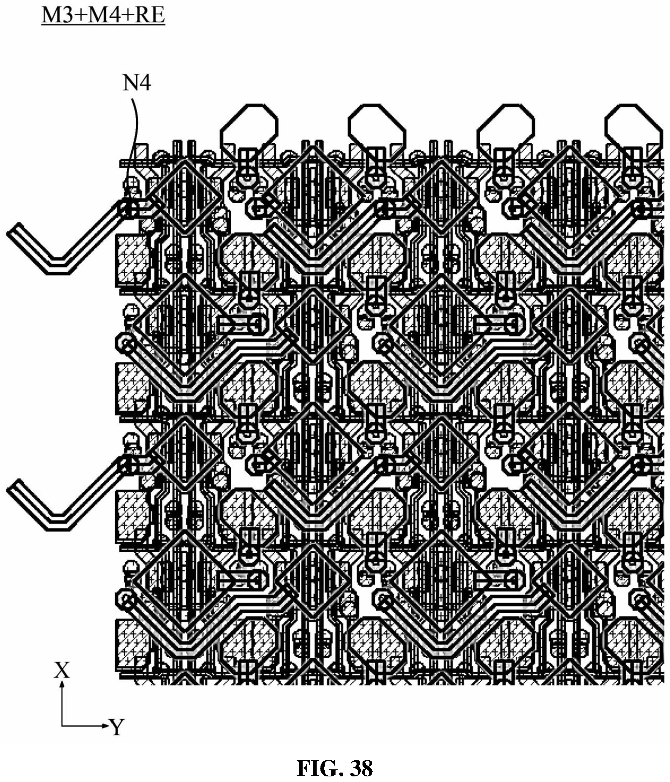

FIG. 29 is a diagram illustrating the structure of yet another display panel according to an embodiment of the present application. FIG. 30 is a sectional structural diagram of another display panel according to an embodiment of the present application. FIG. 31 is a diagram illustrating part of the structure of the display panel shown in FIG. 30. FIG. 32 is a diagram illustrating another part of the structure of the display panel shown in FIG. 30. FIG. 33 is a diagram illustrating another part of the structure of the display panel shown in FIG. 30. FIG. 34 is a diagram illustrating another part of the structure of the display panel shown in FIG. 30. FIG. 35 is a diagram illustrating another part of the structure of the display panel shown in FIG. 30. FIG. 36 is a diagram illustrating another part of the structure of the display panel shown in FIG. 30. FIG. 37 is a diagram illustrating another part of the structure of the display panel shown in FIG. 30. FIG. 38 is a diagram illustrating another part of the structure of the display panel shown in FIG. 30. FIG. 29 shows a top view of some stacked layers of the display panel. FIG. 30 shows an overall sectional view of the layers of the display panel. FIGS. 31 to 38 show different layers in the display panel from top to bottom.

With reference to FIG. 29 to FIG. 40, the LTPO display panel is used as an example again. Along the thickness direction Z of the display panel, the display panel may include a buffer layer 70, a first semiconductor layer POLY, a first metal layer M1, a second metal layer MC, a second semiconductor layer IGZO, a fifth metal layer MG, a third metal layer M2, a fourth metal layer M3, a sixth metal layer M4, a planarization layer PLN, and an anode layer RE, which are disposed on one side of the substrate 40. An insulating layer 80 may be disposed between any two adjacent conductive layers. The third metal layer M2 may be understood as a first source-drain electrode layer. The fourth metal layer M3 may be understood as a second source-drain electrode layer. The sixth metal layer M4 may be understood as a third source-drain metal layer. The layered configuration of the display panel may be adapted to actual production needs, such as by adding or removing some layers, which is not limited in embodiments of the present application. FIG. 31 is a diagram illustrating the structure of the first semiconductor layer POLY in FIG. 30. FIG. 32 is a diagram illustrating the structure of the first metal layer M1 in FIG. 30. FIG. 33 is a diagram illustrating the structure of the second metal layer MC in FIG. 30. FIG. 34 is a diagram illustrating the structure of the third metal layer M2 in FIG. 30. FIG. 35 is a diagram illustrating the structure of the fourth metal layer M3 in FIG. 30. FIG. 36 is a diagram illustrating the structure of the sixth metal layer M4 in FIG. 30. FIG. 37 is a diagram illustrating the structure of the anode layer RE in FIG. 30. FIG. 38 is a diagram illustrating the structure of the fourth metal layer M3, the sixth metal layer M4, and the anode layer RE. To clearly illustrate the multi-layer stacked structure, FIG. 29 does not show all layers, but only illustrates the first semiconductor layer POLY, the first metal layer M1, the second metal layer MC, and the third metal layer M2, while other layer structures may be referenced from the corresponding single-layer diagrams.

The structures of the second semiconductor layer IGZO and the fifth metal layer MG in the display panel shown in FIG. 29 are the same as those in the display panel shown in FIG. 18. The second semiconductor layer IGZO may be referenced to FIG. 23, and the fifth metal layer MG may be referenced from FIG. 24, which is not elaborated herein.

The embodiment shown in FIG. 29 differs from the embodiment shown in FIG. 18 in the layers of the display panel and the wiring between some of the layers. Compared to the display panel shown in FIG. 18, the display panel shown in FIG. 29 includes an additional metal layer between the third metal layer M2 and the anode layer RE. Some of the wirings in the fourth metal layer M3 of FIG. 18 is disposed in the fourth metal layer M3 and the sixth metal layer M4 of FIG. 29, thereby reducing wiring complexity. In the embodiment shown in FIG. 29, the connection region of the second light emission control transistor T6 and the reset transistor T7 may be connected to the anode 22 of the light-emitting element via connection crossover lines in the third metal layer M2, the fourth metal layer M3, and the sixth metal layer M4. The fourth node N4 may be a wiring structure at the position where the connection region overlaps with the projections of the third metal layer M2, the fourth metal layer M3, and the sixth metal layer M4. In this embodiment, the anode connection portion 222 may be disposed in the same layer as the anode body portion 221, both located in the anode layer RE.

In the embodiment shown in FIG. 29, the wiring patterns in the first semiconductor layer POLY, the first metal layer M1, the second semiconductor layer IGZO, and the fifth metal layer MG are the same as those in the embodiment shown in FIG. 18, which will not be repeated here. Only the differences from the foregoing embodiment are described. With reference to FIG. 29 to FIG. 38, in the display panel shown in FIG. 29 to FIG. 38, the second metal layer MC may include the first plate C1 of the storage capacitor Cst, the scan signal line S1-1, the second scan signal line S2-1, and the second reset signal line VREF22, which extend along the second direction Y. The third metal layer M2 may include the initialization signal line VREF1, the first reset signal line VREF21, the first bias voltage signal line DVH1, all extending along the first direction X, and some connection crossover line. The first reset signal lines VREF21 and the second reset signal lines VREF22 are connected to form grids, and the first bias voltage signal lines DVH1 and the second bias voltage signal lines DVH2 are connected to form grids. In the third metal layer M2, the reset signal line VREF2 (first reset signal line VREF21) and the bias voltage signal line DVH (first bias voltage signal line DVH1) are alternately arranged along the first direction X and the second direction Y. The fourth metal layer M3 may include the data auxiliary line FIAA extending along the second direction, the power signal line PVDD, and some connection crossover line. The sixth metal layer M4 may include the power signal line PVDD, the data signal line Data, the data auxiliary line FIAA, all extending along the first direction X, and some connection crossover line .

In the embodiments shown in FIG. 18 and FIG. 28, the anode connection portion 222 connected to the anode is disposed in the same layer as the anode body portion 221. The anode connection portion 222 and the anode body portion 221 may be prepared in the same patterning process, and no additional holes are needed for connection between them. However, it is necessary to ensure that the anode connection portion 222 of one light-emitting element does not connect to the anode (including the anode body portion 221 and the anode connection portion 222) of any other light-emitting element to avoid short circuits between anodes of different light-emitting elements. For example, as shown in FIG. 28 and FIG. 38, the anode connection portions 222 of some light-emitting elements may be arranged to surround part of the anode body portion 221 of an adjacent light-emitting element, to extend towards the fourth node N4 of the first pixel circuit connected to the light-emitting element.

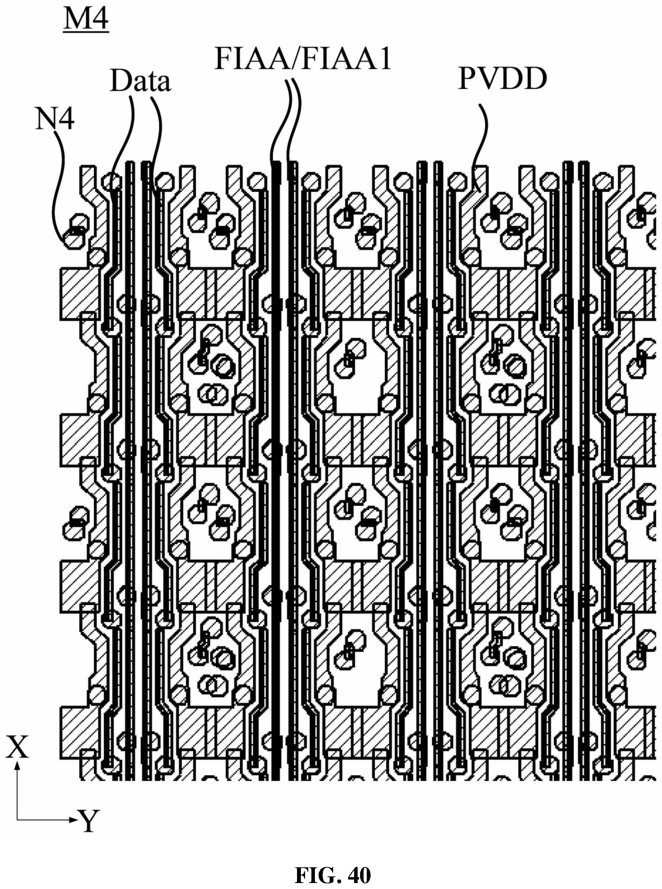

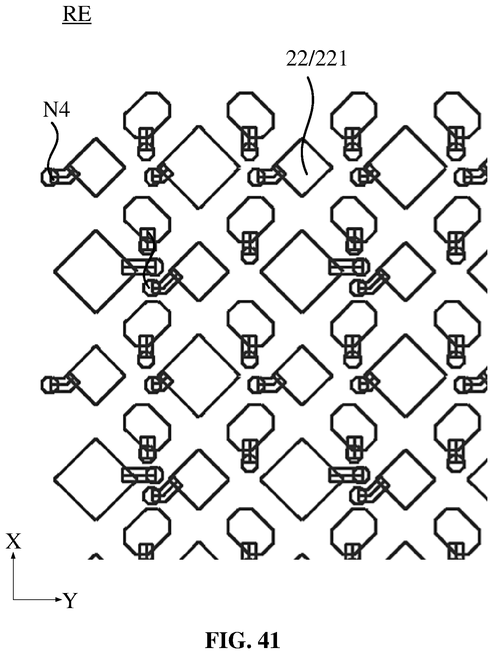

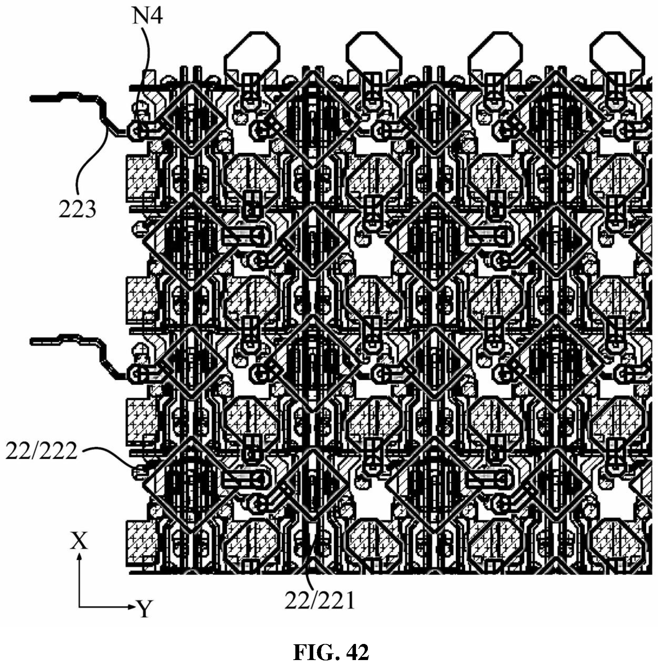

FIG. 39 is a diagram illustrating the structure of a fourth metal layer in a display panel according to an embodiment of the present application. FIG. 40 is a diagram illustrating the structure of a sixth metal layer in a display panel according to an embodiment of the present application. FIG. 41 is a diagram illustrating the structure of an anode layer in a display panel according to an embodiment of the present application. FIG. 42 is a diagram illustrating some layers of a stacked structure of a display panel according to an embodiment of the present application. The overall layered structure of the display panel corresponding to FIG. 39 to FIG. 42 may be the same as in the embodiment shown in FIG. 29. The wiring patterns in the first semiconductor layer POLY, the first metal layer M1, the second metal layer MC, the second semiconductor layer IGZO, the fifth metal layer MG, and the third metal layer M2 may be the same as those in the embodiment shown in FIG. 29, which will not be repeated here.

In the embodiments shown in FIG. 39 to FIG. 42, the anode body portion 221 and the anode connection portion 222 are disposed in different layers. For example, the anode body portion 221 is located in the anode layer RE, and the anode connection portion 222 may be located in at least one metal layer between the first semiconductor layer POLY and the anode layer RE. In the figures, the anode connection portion 222 is located in the fourth metal layer M3, for example. The anode connection portion 222 and the anode body portion 221 are connected through a via. In this way, the anode connection portion 222 may be disposed partially in the same layer as, and connected to, the fourth node N4, which can be prepared in the same patterning process. The layer where the anode connection portion 222 is located is not limited to the above fourth metal layer M3. At least one of the first metal layer M1, the second metal layer MC, the second semiconductor layer IGZO, the fifth metal layer MG, the fourth metal layer M3, and the sixth metal layer M4 may be configured to form the anode connection portion 222.

Optionally, with continued reference to FIG. 29 and FIG. 39 to FIG. 42, the layer where the anode connection portion 222 is located is between the layer where the anode body portion 221 is located and the layer where the substrate is located; along the thickness direction of the display panel, at least part of the anode connection portion 222 overlaps with the anode body portion 221.

As shown in FIG. 29 and FIG. 39 to FIG. 42, when the anode connection portion 222 is located in at least one conductive layer between the anode layer RE and the substrate 40, the orthographic projection of the anode connection portion 222 on the plane of the substrate 40 may be set to overlap with the orthographic projection of the anode body portion 221 on the plane of the substrate 40. In this way, the impact of the anode connection portion 222 on the light transmittance of the display panel can be reduced, thereby ensuring the display effect.

In FIG. 39 to FIG. 42, a dummy connection structure 223 is also illustrated. The arrangement of the dummy connection structure 223 may refer to any of the foregoing embodiments, which will not be repeated here.

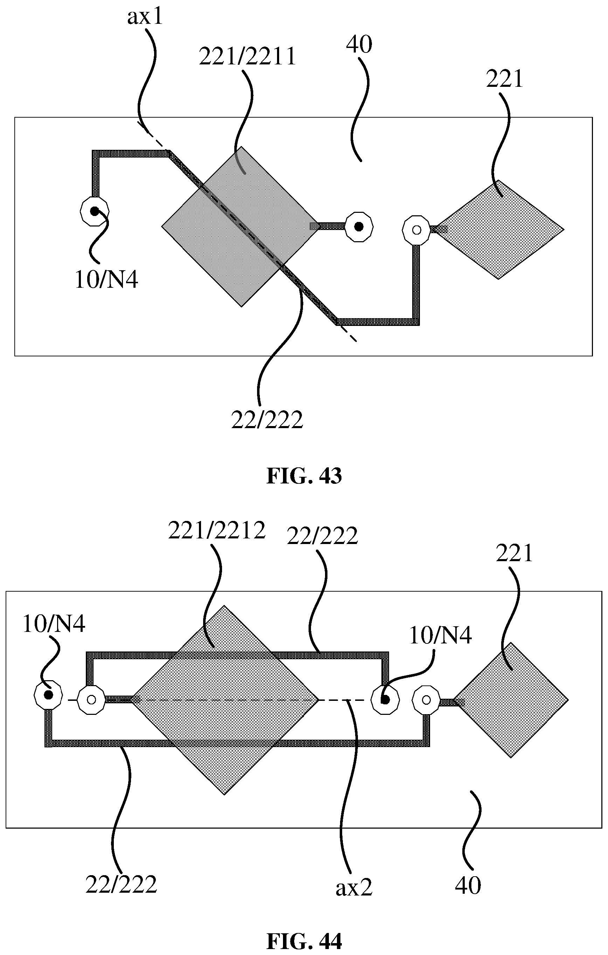

Exemplarily, FIG. 43 is a diagram illustrating the structure of an anode of a light-emitting element according to an embodiment of the present application. With reference to FIG. 43, in some embodiments, along the thickness direction of the display panel, the anode body portion 221 overlapping with the anode connection portion 222 includes a first anode body portion 2211. The first anode body portion 2211 includes a first virtual symmetry axis ax1, and the first anode body portion 2211 is symmetrically arranged with respect to the first virtual symmetry axis ax1. Along the thickness direction of the display panel, one anode connection portion 222 overlaps with the first anode body portion 2211, and the anode connection portion 222 overlaps with the first virtual symmetry axis ax1.

As shown in FIG. 43, the anode body portion 221 includes a first anode body portion 2211, and the orthographic projection of the first anode body portion 2211 on the plane of the substrate 40 is an axisymmetric pattern, symmetric with respect to the first virtual symmetry axis ax1. The extension direction of the first virtual symmetry axis ax1 is not limited. FIG. 43 only shows an example of the extension direction, while the actual implementation is not limited to this. Any symmetry axis of the first anode body portion 2211 may be the first virtual symmetry axis ax1. Along the thickness direction of the display panel, one first anode body portion 2211 overlaps with one anode connection portion 222, and the anode connection portion 222 overlaps with the first virtual symmetry axis ax1 such that the anode connection portion 222 is close to the symmetry axis of the first anode body portion 2211. When orthographically projected on the plane of the substrate 40, the anode connection portion 222 is close to the axis of the first anode body portion 2211 and approximately divides the first anode body portion 2211 into two equal parts. This arrangement ensures that the two parts of the first anode body portion 2211 divided by one anode connection portion 222 have substantially the same area, thereby mitigating the brightness difference between different viewing angles of the light-emitting element overlapping with the anode connection portion 222, avoiding four-direction color shift of the display panel and enhancing the display effect.

Exemplarily, FIG. 44 is a diagram illustrating the structure of an anode of another light-emitting element according to an embodiment of the present application. With reference to FIG. 44, in other embodiments, along the thickness direction of the display panel, the anode body portion 221 overlapping with the anode connection portion 222 includes a second anode body portion 2212;. Along the thickness direction of the display panel, two anode connection portions 222 overlap with the second anode body portion 2212. The second anode body portion 2212 includes a second virtual symmetry axis ax2, and portions of the two anode connection portions 222 overlapping with the second anode body portion 2212 have orthographic projections on the plane of the substrate 40 that are symmetric with respect to the orthographic projection of the second virtual symmetry axis ax2 on the plane of the substrate 40.

As shown in FIG. 44, the anode body portion 221 includes a second anode body portion 2212, and the orthographic projection of the second anode body portion 2212 on the plane of the substrate 40 is an axisymmetric pattern, symmetric with respect to the second virtual symmetry axis ax2. The shapes of the second anode body portion 2212 and the first anode body portion 2211 may be the same or different, and the first virtual symmetry axis ax1 and the second virtual symmetry axis ax2 may extend in the same or different directions. FIG. 44 exemplarily illustrates the first virtual symmetry axis ax1 and the second virtual symmetry axis ax2 extending in different directions, but the actual implementation is not limited thereto. Along the thickness direction of the display panel, one second anode body portion 2212 overlaps with two anode connection portions 222. When orthographically projected on the plane of the substrate 40, the two anode connection portions 222 are symmetric with respect to the second virtual symmetry axis ax2 and approximately divide the second anode body portion 2212 into three equal parts. This arrangement ensures that the three parts of the second anode body portion 2212 divided by the two anode connection portions 222 have substantially the same area, thereby avoiding four-direction color shift in of the display panel.

Optionally, in feasible embodiments, the display panel also includes a light-transmissive hole penetrating at least some of the layers of the display panel, the light-transmissive hole is configured to allow external light to reach a photosensitive element, and along the thickness direction of the display panel, the anode connection portion does not overlap with the light-transmissive hole.

The light-transmissive hole may be located in a region where the under-screen hole of the display panel is located and be configured to accommodate a photosensitive element. The photosensitive element includes, but is not limited to a camera or an infrared sensor. The light-transmissive hole allows external light to pass through for capture by the photosensitive element. In solutions where the display panel is provided with a light-transmissive hole, in arranging the anode connection portion, the anode connection portion is prevented from overlapping with the light-transmissive hole along the thickness direction of the display panel, so that the anode connection portion avoids the light-transmissive hole, preventing the anode connection portion from affecting the light transmittance at the light-transmissive hole, and thereby ensuring the photosensitive performance of the photosensitive element.

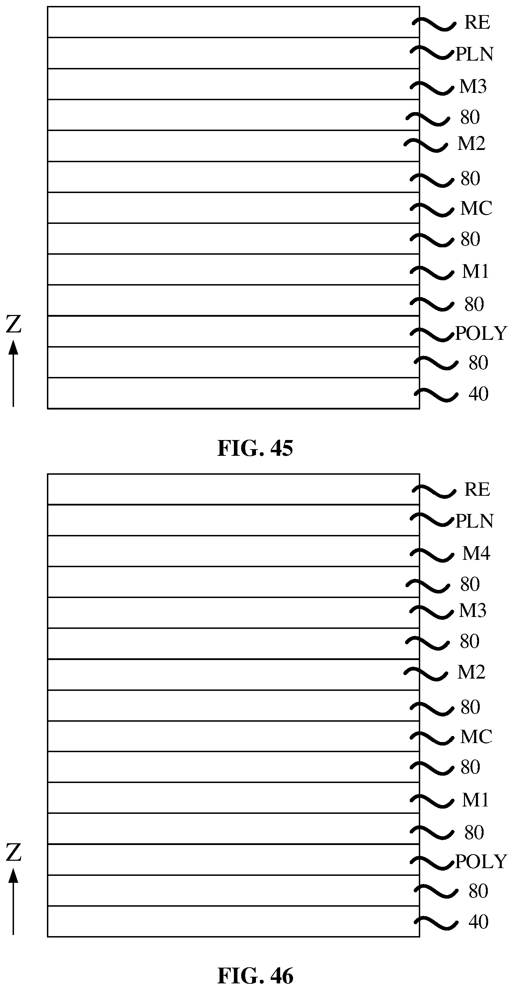

Optionally, FIG. 45 is a sectional structural diagram of another display panel according to an embodiment of the present application. With reference to FIG. 4, FIG. 6, and FIG. 45, in some embodiments, the anode connection portion 222 is located between the layer where the anode body portion 221 is located and the layer where the substrate 40 is located. The first pixel circuit 10 includes at least one transistor (such as T1 to T8 in FIG. 6), and the transistor includes a first active layer. The first pixel circuit 10 also includes a storage capacitor Cst, the storage capacitor Cst includes a first plate C1 and a second plate C2 disposed opposite each other, and the second plate C2 is located on the side of the first plate C1 away from the first active layer. The display panel also includes a first semiconductor layer POLY, a first metal layer M1, a second metal layer MC, and a third metal layer M2. The first active layer is located in the first semiconductor layer POLY, the first plate C1 is located in the first metal layer M1, the second plate C2 is located in the second metal layer MC, and the third metal layer M2 is located on the side of the second metal layer MC away from the first active layer. The anode connection portion 222 is located in at least one of the first metal layer M1, the second metal layer MC, and the third metal layer M2.

In this embodiment, the transistors (for example, including the preceding T1 to T8 transistors) in the first pixel circuit 10 are LTPS transistors, forming an LTPS display panel. In a direction away from the substrate 40, the display panel may include a buffer layer 70, a first semiconductor layer POLY, a first metal layer M1, a second metal layer MC, a third metal layer M2, a fourth metal layer M3, a planarization layer PLN, and an anode layer RE, with an insulating layer 80 disposed between any two adjacent conductive layers. The first active layer of the transistor is located in the first semiconductor layer POLY. The first plate C1 of the storage capacitor Cst, the first scan signal line S1, the second scan signal line S2, the emission control signal line EMIT, and the like may be located in the first metal layer M1, and the overlap between the scan signal line and the active layer of the transistor forms the gate of the transistor. The second plate C2 of the storage capacitor Cst may be formed in the second metal layer MC. The second metal layer MC may also include some of the signal lines and shielding structures extending along the second direction Y, such as the initialization signal line VREF1 and/or the reset signal line VREF2 extending along the second direction Y. The third metal layer M2, as the first source-drain metal layer, may include connection crossover lines between multiple conductive layers. The fourth metal layer M3, as the second source-drain metal layer, may include the power signal line PVDD, the data signal line Data, and the data auxiliary line extending along the first direction X. The arrangement of signal lines in the foregoing metal layers is only exemplary, and the arrangement of signal lines in the metal layers may be adjusted as needed. The anode connection portions 222 of multiple light-emitting elements 22 in the first light-emitting element column 20c may be formed in at least one of the first metal layer M1, the second metal layer MC, and the third metal layer M2, achieving flexible arrangement of the anode connection portion 222.

Optionally, FIG. 46 is a sectional structural diagram of yet another display panel according to an embodiment of the present application. With reference to FIG. 4, FIG. 6, and FIG. 46, in some other embodiments, the anode connection portion 222 is located between the layer where the anode body portion 221 is located and the layer where the substrate 40 is located. The pixel circuit includes at least one transistor, and the transistor includes a first active layer. The pixel circuit also includes a storage capacitor Cst, the storage capacitor Cst includes a first plate C1 and a second plate C2 disposed opposite each other, and the second plate C2 is located on the side of the first plate C1 away from the first active layer. The display panel also includes a first semiconductor layer POLY, a first metal layer M1, a second metal layer MC, a third metal layer M2, and a fourth metal layer M3. The first active layer is located in the first semiconductor layer POLY, the first plate C1 is located in the first metal layer M1, the second plate C2 is located in the second metal layer MC, the third metal layer M2 is located on the side of the second metal layer MC away from the first active layer, and the fourth metal layer M3 is located on the side of the third metal layer M2 away from the first active layer. The anode connection portion 222 is located in at least one of the first metal layer M1, the second metal layer MC, the third metal layer M2, and the fourth metal layer M3.

In this embodiment, the transistors (for example, including the foregoing T1 to T8 transistors) in the first pixel circuit 10 are LTPS transistors, forming an LTPS display panel. In a direction away from the substrate 40, the display panel may include a buffer layer 70, a first semiconductor layer POLY, a first metal layer M1, a second metal layer MC, a third metal layer M2, a fourth metal layer M3, a fifth metal layer M4, a planarization layer PLN, and an anode layer RE, with an insulating layer 80 disposed between any two adjacent conductive layers. The arrangement of signal lines in the first semiconductor layer POLY, the first metal layer M1, the second metal layer MC, and the third metal layer M2 may be the same as or different from that in the embodiment corresponding to FIG. 45, which is not limited by the embodiments of the present application. The fourth metal layer M3 may include some of the power signal lines PVDD, some of the data auxiliary lines, and connection crossover lines between multiple conductive layers. The fifth metal layer M5 may include some other power signal lines PVDD, some other data auxiliary lines FIAA, and data signal lines Data. The arrangement of signal lines in the above-described metal layers is only exemplary, and the arrangement of signal lines in the metal layers may be adjusted as needed. The anode connection portions 222 of multiple light-emitting elements in the first light-emitting element column 20c may be formed in at least one of the first metal layer M1, the second metal layer MC, the third metal layer M2, and the fourth metal layer M3, achieving flexible arrangement of the anode connection portion 222.

Optionally, with continued reference to FIG. 4, FIG. 8, and FIG. 18 to FIG. 28, the anode connection portion 222 is located between the layer where the anode body portion 221 is located and the layer where the substrate 40 is located. The first pixel circuit 10 includes at least one first-type transistor and at least one second-type transistor, the first-type transistor includes a first active layer, and the second-type transistor includes a second active layer and a top gate located on the side of the second active layer away from the first active layer. The first pixel circuit 10 also includes a storage capacitor Cst, the storage capacitor Cst includes a first plate C1 and a second plate C2 disposed opposite each other, and the second plate C2 is located on the side of the first plate C1 away from the first active layer. The display panel also includes a first semiconductor layer POLY, a first metal layer M1, a second metal layer MC, a second semiconductor layer IGZO, a fifth metal layer MG, a third metal layer M2, and a fourth metal layer M3. The first active layer is located in the first semiconductor layer POLY, the first plate C1 is located in the first metal layer M1, the second plate C2 is located in the second metal layer MC, the second active layer is located in the second semiconductor layer IGZO, the top gate is located in the fifth metal layer MG, the third metal layer M2 is located on the side of the fifth metal layer MG away from the first active layer, and the fourth metal layer M3 is located on the side of the third metal layer M2 away from the first semiconductor layer POLY. The anode connection portion 222 is located in at least one of the first metal layer M1, the second metal layer MC, the second semiconductor layer IGZO, the fifth metal layer MG, the third metal layer M2, and the fourth metal layer M3.

As shown in FIG. 4, FIG. 8, and FIG. 18 to FIG. 28, the first-type transistor may refer to the above-described LTPS transistor, and the second-type transistor may refer to the above-described IGZO transistor, thus forming an LTPO display panel. The threshold compensation transistor T4 and the initialization transistor T5 may be second-type transistors, and the first light emission control transistor T1, the data write transistor T2, the driving transistor T3, the second light emission control transistor T6, and the reset transistor T7 may be first-type transistors. The first-type transistor includes a first active layer and a first gate, and the second-type transistor may include a second active layer, a top gate, and a bottom gate. The first gate of the first-type transistor may be located on the side of the first active layer close to the second active layer, forming a top-gate transistor. Alternatively, the first gate is on the side of the first active layer away from the second active layer, forming a bottom-gate transistor. The top gate of the second-type transistor is located on the side of the second active layer away from the first active layer, and the bottom gate is located on the side of the second active layer close to the first active layer. Exemplarily, the first gate may be located in the first metal layer M1, the bottom gate may be located in the second metal layer MC, and the top gate may be located in the fifth metal layer MG. The arrangement in the first metal layer M1, the second metal layer MC, the fifth metal layer MG, the third metal layer M2, and the fourth metal layer M3 is not limited and may refer to FIG. 18 to FIG. 28, which will not be repeated here.

The anode connection portion 222 of the light-emitting element 22 may be formed in at least one of the first metal layer M1, the second metal layer MC, the second semiconductor layer IGZO, the fifth metal layer MG, the third metal layer M2, and the fourth metal layer M3, achieving flexible arrangement of the anode connection portion 222. As shown in FIG. 39, the anode connection portion 222 is disposed in the fourth metal layer M3 as shown in FIG. 39, for example.

Optionally, with reference to FIG. 27, multiple light-emitting elements R of the first color and multiple light-emitting elements B of the second color form a first virtual quadrilateral Z1. The light-emitting element R of the first color is located at the first vertex of the first virtual quadrilateral Z1, the light-emitting element B of the second color is located at the second vertex of the first virtual quadrilateral Z1, and the light-emitting element G of the third color is located inside the first virtual quadrilateral Z1. Multiple light-emitting elements G of the third color form a second virtual quadrilateral Z2 and are located at the vertices of the second virtual quadrilateral Z2, respectively, and the light-emitting element R of the first color or the light-emitting element B of the second color is located inside the second virtual quadrilateral Z2. The light-emitting element R of the first color includes one of a red light-emitting element and a blue light-emitting element, the light-emitting element B of the second color includes the other of the red light-emitting element and the blue light-emitting element, and the light-emitting element G of the third color includes a green light-emitting element.

Multiple light-emitting elements R of the first color and multiple light-emitting elements B of the second color form the first virtual quadrilateral Z1. Two light-emitting elements R of the first color are located at opposite vertices of the first virtual quadrilateral Z1, and two light-emitting elements B of the second color are located at the other two opposite vertices of the first virtual quadrilateral Z1. The light-emitting element G of the third color is disposed inside the first virtual quadrilateral Z1. Multiple light-emitting elements G of the third color may form the second virtual quadrilateral Z2, with either the light-emitting element R of the first color or the light-emitting element B of the second color located inside the second virtual quadrilateral Z2.

The first color, second color, and third color each correspond to a respective one of red, blue, and green. Through the above-described arrangements of light-emitting elements, the rendering effect of the light-emitting elements can be improved, further ensuring the color display effect of the display panel.

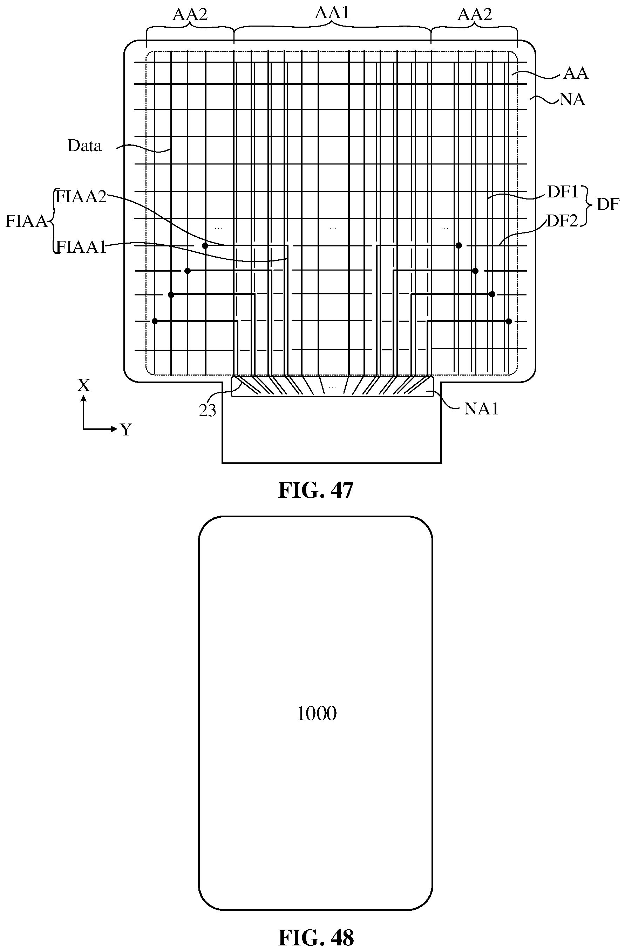

FIG. 47 is a diagram illustrating the structure of another display panel according to an embodiment of the present application. With reference to FIG. 47, the display panel includes a display region AA and a non-display region NA at least partially surrounding the display region AA. The display region AA includes a first display region AA1 and a second display region AA2, and the second display region AA2 is located on at least one side of the first display region AA1 along the second direction Y. Both the first display region AA1 and the second display region AA2 include multiple data signal lines Data. The non-display region NA includes a fan-out region NA1 located on one side of the display region AA along the first direction X, and the fan-out region NA1 includes multiple fan-out lines 23. The display panel also includes a data auxiliary line FIAA at least located in the display region AA, and a data signal line Data located in the second display region AA2 is electrically connected to a fan-out line 23 via the data auxiliary line FIAA.

Light-emitting elements (not shown in the figure), pixel circuits (not shown in the figure), and data signal lines Data may be disposed in the display region AA to achieve the display function of the display panel. The non-display region NA may include a display controller (not shown in the figure), such as a driver chip, connected to the data signal lines Data, which provides data signals to the data signal lines Data to drive the display panel for display functions. The non-display region NA surrounds at least part of the display region AA, and the positions of the display region AA and the non-display region NA are not limited by the embodiments of the present application.

As shown in FIG. 47, in this embodiment, the display region AA may include a first display region AA1 and a second display region AA2. The figure exemplarily illustrates the second display region AA2 located on two sides of the first display region AA1 along the second direction Y, but the actual implementation is not limited thereto. With this configuration, along the orientation shown in FIG. 47, the second display region AA2 is located between the first display region AA1 and the non-display region NA on the left and right sides. Along the second direction Y, the first display region AA1 is closer to the center of the display panel, and the second display region AA2 is closer to the edge of the display panel. The non-display region NA includes a fan-out region NA1 located on one side, for example, the lower side as shown in the figure, of the display region AA along the first direction X. The fan-out region NA1 may include multiple fan-out lines 23 electrically connected to the data signal lines Data, thereby connecting the data signal lines Data to the display controller to ensure stable transmission of data signals.

With continued reference to FIG. 47, multiple data signal lines Data are disposed in both the first display region AA1 and the second display region AA2. The data signal lines Data in the first display region AA1 may be directly electrically connected to the fan-out lines 23, and the data signal lines Data in the second display region AA2 are electrically connected to the fan-out lines 23 via the data auxiliary lines FIAA in the display region AA. In this way, the fan-out lines 23 can be concentrated in the fan-out region NA1 below the first display region AA1, thereby reducing the space occupied by the fan-out lines 23 and the area required for the fan-out region NA1. Moreover, the proportion of the non-display region NA can be effectively reduced, the proportion of the display region AA can be increased, and the display effect of the display panel can be improved, achieving a narrow bezel.

Optionally, with reference to FIG. 18 to FIG. 28 and FIG. 47, the data auxiliary line FIAA includes a first auxiliary segment FIAA1, and the first auxiliary segment FIAA1 extends along the first direction X and is electrically connected to the fan-out line 23. The light-emitting element includes a light-emitting element R of the first color and a light-emitting element B of the second color with different emission colors, and the light-emitting element R of the first color or the light-emitting element B of the second color includes a third virtual symmetry axis ax3 extending along the first direction X. The light-emitting element also includes an anode, and the anode includes an anode body portion 221. The display panel also includes a pixel definition layer 30 and multiple pixel openings 31 in the pixel definition layer 30, and along the thickness direction of the display panel, the anode body portion 221 overlaps with a pixel opening 31. The anode body portion 221 of the light-emitting element R of the first color or the light-emitting element B of the second color is symmetrically arranged with respect to the third virtual symmetry axis ax3. The display panel also includes a substrate 40, and the orthographic projections of two first auxiliary segments FIAA1 overlapping with the same anode body portion 221 on the plane of the substrate 40 are symmetric with respect to the orthographic projection of the third virtual symmetry axis ax3 on the plane of the substrate 40.

As shown in FIG. 18 to FIG. 28 and FIG. 47, the data auxiliary line FIAA may include a first auxiliary segment FIAA1 and a second auxiliary segment FIAA2. The first auxiliary segment FIAA1 extends along the first direction X, and the second auxiliary segment FIAA2 extends along the second direction Y. The first auxiliary segment FIAA1 may be disposed in the first display region AA1. A first end of the first auxiliary segment FIAA1 is connected to the fan-out line 23, a second end of the first auxiliary segment FIAA1 is connected to a first end of the second auxiliary segment FIAA2, and a second end of the second auxiliary segment FIAA2 extends toward the second display region AA2 and is electrically connected to the data signal lines Data in the second display region AA2.

The first auxiliary segment FIAA1 and the second auxiliary segment FIAA2 extend in different directions and may be disposed in different layers. The electrical connection between the FIAA1 and FIAA2 is implemented through vias. Exemplarily, the first auxiliary segment FIAA1 may be located on the side of the second auxiliary segment FIAA2 away from the substrate. For example, as shown in FIG. 18 to FIG. 28, the first auxiliary segment FIAA1 may be located in the fourth metal layer M3, and the second auxiliary segment FIAA2 may be located in the third metal layer M2.

With continued reference to FIG. 18 to FIG. 28, the f light-emitting element R of the first color or the light-emitting element B of the second color includes a third virtual symmetry axis ax3 extending along the first direction X. The anode body portion 221 of the light-emitting element R of the first color is symmetric with respect to the third virtual symmetry axis ax3, or the anode body portion 221 of the light-emitting element B of the second color is symmetric with respect to the third virtual symmetry axis ax3. Both the anode body portion 221 of the light-emitting element R of the first color and the anode body portion 221 of the light-emitting element B of the second color are symmetric with respect to the third virtual symmetry axis ax3 as shown in the figures, for example, but the actual implementation is not limited thereto.

As shown in FIG. 18 to FIG. 28, along the thickness direction of the display panel, at least part of the first auxiliary segment FIAA1 may overlap with the anode body portion 221 of the light-emitting element R of the first color and/or the anode body portion 221 of the light-emitting element B of the second color, and at least two first auxiliary segments FIAA1 overlap with the same anode body portion 221. When orthographically projected on the plane of the substrate 40, the two first auxiliary segments FIAA1 overlapping with the same anode body portion 221 are symmetric with respect to the third virtual symmetry axis ax3. As shown in FIG. 18 to FIG. 28, the data auxiliary line FIAA may be disposed on the side of the anode layer RE close to the substrate 40, and the first auxiliary segment FIAA1 is located in a layer below the anode body portion 221. Two first auxiliary segments FIAA1 are arranged symmetrically with respect to the third virtual symmetry axis ax3 and approximately divide the anode body portion 221 into three equal parts, ensuring that the three parts of the anode body portion 221 divided by the two first auxiliary segments FIAA1 have substantially the same area and avoiding four-direction color shift of the display panel. Additionally, the anode body portion 221 can cover part of the first auxiliary segment FIAA1, preventing the metallic first auxiliary segment FIAA1 from altering the transmission direction of light, and ensuring the display effect of the display panel.

Optionally, with continued reference to FIG. 28, along the thickness direction of the display panel, among the two first auxiliary segments FIAA1 and two data signal lines Data overlapping with the same anode body portion 221, for a first auxiliary segment FIAA1 and a data signal line Data located on the same side of the third virtual symmetry axis ax3, the data signal line Data is located on the side of the first auxiliary segment FIAA1 away from the third virtual symmetry axis ax3.

Along the thickness direction of the display panel, at least two data signal lines Data overlap with the anode body portion 221 of the light-emitting element R of the first color or the light-emitting element B of the second color. That is, along the thickness direction of the display panel, two first auxiliary segments FIAA1 and two data signal lines Data overlap with the same anode body portion 221, where the anode body portion 221 is the anode body portion 221 of the light-emitting element R of the first color or the light-emitting element B of the second color. The orthographic projections of the two data signal lines Data overlapping with the same anode body portion 221 on the plane of the substrate are symmetric with respect to the orthographic projection of the third virtual symmetry axis ax3 on the plane of the substrate. When orthographically projected on the plane of the substrate, there are one first auxiliary segment FIAA1 and one data signal line Data on each of the left and right sides of the third virtual symmetry axis ax3 along the second direction Y.

In the embodiment shown in FIG. 28, for the first auxiliary segment FIAA1 and the data signal line Data located on the same side of the third virtual symmetry axis ax3, the data signal line Data is located on the side of the first auxiliary segment FIAA1 away from the third virtual symmetry axis ax3. In other words, the first auxiliary segment FIAA1 is located between the third virtual symmetry axis ax3 and the data signal line Data, and the data signal line Data, along the second direction Y, is closer to the light-emitting element in an adjacent column.

Optionally, in other embodiments not shown in the figures of the present application, along the thickness direction of the display panel, among the two first auxiliary segments FIAA1 and two data signal lines Data overlapping with the same anode body portion 221, for a first auxiliary segment FIAA1 and a data signal line Data located on the same side of the third virtual symmetry axis ax3, the data signal line Data is located on the side of the first auxiliary segment FIAA1 close to the third virtual symmetry axis ax3.

For the first auxiliary segment FIAA1 and the data signal line Data located on the same side of the third virtual symmetry axis ax3, the data signal line Data is located on the side of the first auxiliary segment FIAA1 close to the third virtual symmetry axis ax3. In other words, the data signal line Data is located between the third virtual symmetry axis ax3 and the first auxiliary segment FIAA1, and the first auxiliary segment FIAA1, along the second direction Y, is closer to the light-emitting element in an adjacent column.

In summary, by properly configuring how the anode body portion 221 overlaps with the first auxiliary segment FIAA1 and the data signal line Data, the influence of the first auxiliary segment FIAA1 and the data signal line Data at different positions in the display panel on the anode body portion 221 is the same or approximately the same, ensuring display uniformity.

Optionally, with continued reference to FIG. 47, in feasible embodiments, the display panel also includes a dummy auxiliary line DF, and the dummy auxiliary line DF includes a first dummy auxiliary line DF1 and a second dummy auxiliary line DF2. As shown in FIG. 47, both the first dummy auxiliary line DF1 and the second dummy auxiliary line DF2 are insulated from the data auxiliary line FIAA. The arrangement of the dummy auxiliary line DF can compensate for the length of the data auxiliary line FIAA. For example, the first dummy auxiliary line DF1 may be configured to compensate for the first auxiliary FIAA1, and the second dummy auxiliary line DF2 may be configured to compensate for the second auxiliary segment FIAA2. That is, by the arrangement of the dummy auxiliary line DF, the overall wiring uniformity in the configured region of the data auxiliary lines FIAA is achieved, to ensure that the density of the wiring in different regions is uniform. In this way, the difference in light reflectivity between different regions of the display panel caused by non-uniform wiring arrangements can be avoided, thereby avoiding uneven display effect of the display panel.

The dummy auxiliary line DF may be electrically connected to a fixed potential terminal. On one hand, this prevents interference with the display due to coupling with other signals caused by a floating potential of the dummy auxiliary line DF. On the other hand, a parallel connection with the fixed potential terminal can reduce the resistance on the fixed signal terminal or fixed potential signal line, ensuring less loss of the fixed potential signal during transmission.

Based on the same idea, an embodiment of the present application also provides a display device. FIG. 48 is a diagram illustrating the structure of a display device according to an embodiment of the present application. As shown in FIG. 48, the display device includes the display panel 1000 according to any embodiment of the present application, which is not elaborated herein. Exemplarily, the display device may be an electronic device such as a mobile phone, a computer, a smart wearable device (for example, a smart watch), or an in-vehicle display device, which is not limited in this embodiments of the present application.

## Claims

1. A display panel, comprising:
a plurality of data signal lines extending along a first direction and arranged along a second direction, wherein the first direction intersects the second direction;
a plurality of first pixel circuits, wherein first pixel circuits of the plurality of first pixel circuits that are arranged in each column along the first direction are electrically connected to a same data signal line of the plurality of data signal lines; and
a plurality of first pixel circuit columns and a plurality of first light-emitting element columns; wherein a first pixel circuit column of the plurality of first pixel circuit columns comprises a plurality of the first pixel circuits arranged along the first direction, a first light-emitting element column of the plurality of first light-emitting element columns comprises two types of light-emitting elements with different emission colors arranged along the first direction, the two types of light-emitting elements with different emission colors are electrically connected to the first pixel circuits located in different first pixel circuit columns respectively, and the plurality of the first pixel circuits in a same first pixel circuit column are electrically connected to a plurality of the light-emitting elements of a same emission color.

2. The display panel according to claim 1, further comprising a plurality of first pixel circuit rows and a plurality of first light-emitting element rows, wherein
a first pixel circuit row of the plurality of first pixel circuit rows comprises a plurality of the first pixel circuits arranged along the second direction, the first light-emitting element column comprises a light-emitting element of a first color and a light-emitting element of a second color alternately arranged along the first direction, a first light-emitting element row of the plurality of first light-emitting element rows comprises the light-emitting element of the first color and the light-emitting element of the second color alternately arranged along the second direction, and the light-emitting element of the first color and the light-emitting element of the second color have different emission colors; and
the plurality of the first pixel circuits in the same first pixel circuit column are electrically connected to light-emitting elements of the first color in at least two first light-emitting element columns adjacent to each other along the second direction or are electrically connected to light-emitting elements of the second color in at least two first light-emitting element columns adjacent to each other along the second direction, and a plurality of the first pixel circuits in a same first pixel circuit row are electrically connected to a plurality of the light-emitting elements in a same first light-emitting element row.

3. The display panel according to claim 2, wherein at least a subset of adjacent first pixel circuit columns comprise an i-th first pixel circuit column and an (i+1)-th first pixel circuit column;
at least one pair of adjacent first pixel circuits in the i-th first pixel circuit column comprise an iⱼ-th first pixel circuit and an i₍ⱼ₊₁₎-th first pixel circuit, and at least one pair of adjacent first pixel circuits in the (i+1)-th first pixel circuit column comprise an (i+1)ⱼ-th first pixel circuit and an (i+1)₍ⱼ₊₁₎-th first pixel circuit;
at least one pair of adjacent first light-emitting element columns comprise a p-th first light-emitting element column and a (p+1)-th first light-emitting element column;
at least one pair of adjacent light-emitting elements in the p-th first light-emitting element column comprise a p_{q}-th light-emitting element and a p_{(q+1)}-th light-emitting element, and at least one pair of adjacent light-emitting elements in the (p+1)-th first light-emitting element column comprise a (p+1)_{q}-th light-emitting element and a (p+1)_{(q+1)}-th light-emitting element; wherein i, j, p, and q are all positive integers;
the iⱼ-th first pixel circuit is electrically connected to the p_{q}-th light-emitting element;
the i₍ⱼ₊₁₎-th first pixel circuit is electrically connected to the (p+1)_{(q+1)}-th light-emitting element; the (i+1)ⱼ-th first pixel circuit is electrically connected to the (p+1)_{q}-th light-emitting element; and
the (i+1)₍ⱼ₊₁₎-th first pixel circuit is electrically connected to the p_{(q+1)}-th light-emitting element.

4. The display panel according to claim 3, wherein the light-emitting element comprises an anode, the anode comprises an anode body portion and an anode connection portion connected to each other,
the display panel further comprises a pixel definition layer and a plurality of pixel openings in the pixel definition layer, and along a thickness direction of the display panel, the anode body portion overlaps with a pixel opening of the plurality of pixel openings, and the anode connection portion does not overlap with the pixel opening;
the i₍ⱼ₊₁₎-th first pixel circuit is electrically connected to the anode connection portion of the (p+1)_{(q+1)}-th light-emitting element; and
the (i+1)₍ⱼ₊₁₎-th first pixel circuit is electrically connected to the anode connection portion of the p_{(q+1)}-th light-emitting element.

5. The display panel according to claim 4, wherein the anode connection portion of the (p+1)_{q}-th light-emitting element is located on a side of the anode body portion of the (p+1)_{q}-th light-emitting element close to the (i+1)-th first pixel circuit column; and
the anode connection portion of the p_{(q+1)}-th light-emitting element is located on a side of the anode body portion of the p_{(q+1)}-th light-emitting element close to the (i+1)-th first pixel circuit column.

6. The display panel according to claim 4, wherein the anode connection portion of the (p+1)_{(q+1)}-th light-emitting element is located on a side of the anode body portion of the (p+1)_{(q+1)}-th light-emitting element close to the i-th first pixel circuit column; and
the anode connection portion of the p_{(q+1)}-th light-emitting element is located on a side of the anode body portion of the p_{(q+1)}-th light-emitting element close to the (i+1)-th first pixel circuit column.

7. The display panel according to claim 4, wherein the anode connection portion of the (p+1)_{(q+1)}-th light-emitting element comprises a first end portion connected to an anode body portion of the (p+1)_{(q+1)}-th light-emitting element and a second end portion connected to the i₍ⱼ₊₁₎-th first pixel circuit, the first end portion is located on a side of the anode body portion of the (p+1)_{(q+1)}-th light-emitting element away from the i-th first pixel circuit column, the (i+1)₍ⱼ₊₁₎-th first pixel circuit is electrically connected to the anode connection portion of the p_{(q+1)}-th light-emitting element, the anode connection portion of the p_{(q+1)}-th light-emitting element comprises a third end portion connected to the anode body portion of the p_{(q+1)}-th light-emitting element and a fourth end portion connected to the (i+1)₍ⱼ₊₁₎-th first pixel circuit, and the third end portion is located on a side of the anode body portion of the p_{(q+1)}-th light-emitting element close to the (i+1)-th first pixel circuit column; or
the anode connection portion of the (p+1)_{(q+1)}-th light-emitting element comprises a fifth end portion connected to the anode body portion of the (p+1)_{(q+1)}-th light-emitting element and a sixth end portion connected to the i₍ⱼ₊₁₎-th first pixel circuit, the fifth end portion is located on a side of the anode body portion of the (p+1)_{(q+1)}-th light-emitting element close to the i-th first pixel circuit column, the (i+1)₍ⱼ₊₁₎-th first pixel circuit is electrically connected to the anode connection portion of the p_{(q+1)}-th light-emitting element, the anode connection portion of the p_{(q+1)}-th light-emitting element comprises a seventh end portion connected to the anode body portion of the p_{(q+1)}-th light-emitting element and an eighth end portion connected to the (i+1)₍ⱼ₊₁₎-th first pixel circuit, and the seventh end portion is located on a side of the anode body portion of the p_{(q+1)}-th light-emitting element away from the (i+1)-th first pixel circuit column.

8. The display panel according to claim 4, further comprising a substrate and a dummy connection structure; wherein
an orthographic projection of the dummy connection structure on a plane of the substrate is located on a side of an orthographic projection of an anode body portion of the p_{q}-th light-emitting element on the plane of the substrate; or
an orthographic projection of the dummy connection structure on a plane of the substrate is located on a side of an orthographic projection of an anode body portion of the (p+1)_{q}-th light-emitting element on the plane of the substrate; or
an orthographic projection of the dummy connection structure on a plane of the substrate is located on a side of an orthographic projection of the anode body portion of the p_{q}-th light-emitting element on the plane of the substrate, and the orthographic projection of the dummy connection structure on the plane of the substrate is located on a side of an orthographic projection of the anode body portion of the (p+1)_{q}-th light-emitting element on the plane of the substrate.

9. The display panel according to claim 8, wherein the dummy connection structure and the anode connection portion are staggered with each other in at least one of the first direction and the second direction.

10. The display panel according to claim 8, wherein the dummy connection structure and the anode connection portion are disposed in a same layer.

11. The display panel according to claim 8, wherein
there is a gap between the orthographic projection of the anode body portion of the p_{q}-th light-emitting element on the plane of the substrate and the orthographic projection of the dummy connection structure on the plane of the substrate; or
there is a gap between the orthographic projection of the anode body portion of the (p+1)_{q}-th light-emitting element on the plane of the substrate and the orthographic projection of the dummy connection structure on the plane of the substrate; or
there is a gap between the orthographic projection of the anode body portion of the p_{q}-th light-emitting element on the plane of the substrate and the orthographic projection of the dummy connection structure on the plane of the substrate, and there is a gap between the orthographic projection of the anode body portion of the (p+1)_{q}-th light-emitting element on the plane of the substrate and the orthographic projection of the dummy connection structure on the plane of the substrate.

12. The display panel according to claim 8, wherein
at least one of the anode body portion of the p_{q}-th light-emitting element and the anode body portion of the (p+1)_{q}-th light-emitting element is electrically connected to the dummy connection structure.

13. The display panel according to claim 2, wherein at least a subset of adjacent first pixel circuit columns comprise an h-th first pixel circuit column, an (h+1)-th first pixel circuit column, an (h+2)-th first pixel circuit column, and an (h+3)-th first pixel circuit column;
at least one pair of adjacent first pixel circuits in the h-th first pixel circuit column comprise an hₖ-th first pixel circuit and an h₍ₖ₊₁₎-th first pixel circuit, at least one pair of adjacent first pixel circuits in the (h+1)-th first pixel circuit column comprise an (h+1)ₖ-th first pixel circuit and an (h+1)₍ₖ₊₁₎-th first pixel circuit, at least one pair of adjacent first pixel circuits in the (h+2)-th first pixel circuit column comprise an (h+2)ₖ-th first pixel circuit and an (h+2)₍ₖ₊₁₎-th first pixel circuit, and at least one pair of adjacent first pixel circuits in the (h+3)-th first pixel circuit column comprise an (h+3)ₖ-th first pixel circuit and an (h+3)₍ₖ₊₁₎-th first pixel circuit;
at least one group of adjacent four first light-emitting element columns comprise an m-th first light-emitting element column, an (m+1)-th first light-emitting element column, an (m+2)-th first light-emitting element column, and an (m+3)-th first light-emitting element column;
at least one pair of adjacent light-emitting elements in the m-th first light-emitting element column comprise an mₙ-th light-emitting element and an m₍ₙ₊₁₎-th light-emitting element, at least one pair of adjacent light-emitting elements in the (m+1)-th first light-emitting element column comprise an (m+1)ₙ-th light-emitting element and an (m+1)₍ₙ₊₁₎-th light-emitting element, at least one pair of adjacent light-emitting elements in the (m+2)-th first light-emitting element column comprise an (m+2)ₙ-th light-emitting element and an (m+2)₍ₙ₊₁₎-th light-emitting element, and at least one pair of adjacent light-emitting elements in the (m+3)-th first light-emitting element column comprise an (m+3)ₙ-th light-emitting element and an (m+3)₍ₙ₊₁₎-th light-emitting element; wherein h, k, m, and n are all positive integers;
the hₖ-th first pixel circuit is electrically connected to the mₙ-th light-emitting element;
the h₍ₖ₊₁₎-th first pixel circuit is electrically connected to the (m+1)₍ₙ₊₁₎-th light-emitting element;
the (h+1)ₖ-th first pixel circuit is electrically connected to the (m+1)ₙ-th light-emitting element; the (h+1)₍ₖ₊₁₎-th first pixel circuit is electrically connected to the m₍ₙ₊₁₎-th light-emitting element;
the (h+2)ₖ-th first pixel circuit is electrically connected to the (m+3)ₙ-th light-emitting element; and
the (h+2)₍ₖ₊₁₎-th first pixel circuit is electrically connected to the (m+2)₍ₙ₊₁₎-th light-emitting element;
the (h+3)ₖ-th first pixel circuit is electrically connected to the (m+2)ₙ-th light-emitting element; and
the (h+3)₍ₖ₊₁₎-th first pixel circuit is electrically connected to the (m+3)₍ₙ₊₁₎-th light-emitting element.

14. The display panel according to claim 13, wherein the light-emitting element comprises an anode, the anode comprises an anode body portion and an anode connection portion connected to each other, the display panel further comprises a pixel definition layer and a plurality of pixel openings in the pixel definition layer, and along a thickness direction of the display panel, the anode body portion overlaps with a pixel opening of the plurality of pixel openings, and the anode connection portion does not overlap with the pixel opening;
the h₍ₖ₊₁₎-th first pixel circuit is electrically connected to an anode connection portion of the (m+1)₍ₙ₊₁₎-th light-emitting element; and
the (h+2)ₖ-th first pixel circuit is electrically connected to an anode connection portion of the (m+3)ₙ-th light-emitting element.

15. The display panel according to claim 7 or 14, wherein the anode connection portion and the anode body portion are disposed in a same layer; or
the display panel further comprises a substrate, and a layer where the anode connection portion is located is between a layer where the anode body portion is located and a layer where the substrate is located.

16. The display panel according to claim 15, wherein the layer where the anode connection portion is located is between the layer where the anode body portion is located and the layer where the substrate is located; and
along the thickness direction of the display panel, at least part of the anode connection portion overlaps with the anode body portion.

17. The display panel according to claim 16, wherein in the thickness direction of the display panel, the anode body portion overlapping with the anode connection portion comprises a first anode body portion;
the first anode body portion comprises a first virtual symmetry axis, and the first anode body portion is symmetrically arranged with respect to the first virtual symmetry axis; and
along the thickness direction of the display panel, one anode connection portion overlaps with the first anode body portion, and the anode connection portion overlaps with the first virtual symmetry axis.

18. The display panel according to claim 16, wherein in the thickness direction of the display panel, the anode body portion overlapping with the anode connection portion comprises a second anode body portion;
along the thickness direction of the display panel, two anode connection portions overlap with the second anode body portion; and
the second anode body portion comprises a second virtual symmetry axis, and portions of the two anode connection portions overlapping with the second anode body portion have orthographic projections on a plane of the substrate that are symmetric with respect to an orthographic projection of the second virtual symmetry axis on the plane of the substrate.

19. The display panel according to claim 7 or 14, further comprising a light-transmissive hole, wherein the light-transmissive hole penetrates at least a subset of layers of the display panel and is configured to allow external light to reach a photosensitive element; and
along the thickness direction of the display panel, the anode connection portion does not overlap with the light-transmissive hole.

20. The display panel according to claim 15, wherein the anode connection portion is located between the layer where the anode body portion is located and the layer where the substrate is located;
a first pixel circuit of the plurality of first pixel circuits comprises at least one transistor, and the at least one transistor comprises a first active layer;
the first pixel circuit further comprises a storage capacitor, the storage capacitor comprises a first plate and a second plate disposed opposite each other, and the second plate is located on a side of the first plate away from the first active layer;
the display panel further comprises a first semiconductor layer, a first metal layer, a second metal layer, and a third metal layer, the first active layer is located in the first semiconductor layer, the first plate is located in the first metal layer, the second plate is located in the second metal layer, and the third metal layer is located on a side of the second metal layer away from the first active layer; and
the anode connection portion is located in at least one of the first metal layer, the second metal layer, and the third metal layer.

21. The display panel according to claim 15, wherein the anode connection portion is located between the layer where the anode body portion is located and the layer where the substrate is located;
the pixel circuit comprises at least one transistor, and the at least one transistor comprises a first active layer;
the pixel circuit further comprises a storage capacitor, the storage capacitor comprises a first plate and a second plate disposed opposite each other, and the second plate is located on a side of the first plate away from the first active layer;
the display panel further comprises a first semiconductor layer, a first metal layer, a second metal layer, a third metal layer, and a fourth metal layer, the first active layer is located in the first semiconductor layer, the first plate is located in the first metal layer, the second plate is located in the second metal layer, the third metal layer is located on a side of the second metal layer away from the first active layer, and the fourth metal layer is located on a side of the third metal layer away from the first active layer; and
the anode connection portion is located in at least one of the first metal layer, the second metal layer, the third metal layer, and the fourth metal layer.

22. The display panel according to claim 15, wherein the anode connection portion is located between the layer where the anode body portion is located and the layer where the substrate is located;
a first pixel circuit of the plurality of first pixel circuits comprises at least one first-type transistor and at least one second-type transistor, the at least one first-type transistor comprises a first active layer, the at least one second-type transistor comprises a second active layer and a top gate, and the top gate is located on a side of the second active layer away from the first active layer;
the first pixel circuit further comprises a storage capacitor, the storage capacitor comprises a first plate and a second plate disposed opposite each other, and the second plate is located on a side of the first plate away from the first active layer;
the display panel further comprises a first semiconductor layer, a first metal layer, a second metal layer, a second semiconductor layer, a fifth metal layer, a third metal layer, and a fourth metal layer, the first active layer is located in the first semiconductor layer, the first plate is located in the first metal layer, the second plate is located in the second metal layer, the second active layer is located in the second semiconductor layer, the top gate is located in the fifth metal layer, the third metal layer is located on a side of the fifth metal layer away from the first active layer, and the fourth metal layer is located on a side of the third metal layer away from the first active layer; and
the anode connection portion is located in at least one of the first metal layer, the second metal layer, the second semiconductor layer, the fifth metal layer, the third metal layer, and the fourth metal layer.

23. The display panel according to claim 2, further comprising a plurality of second pixel circuit columns and a plurality of second pixel circuit rows, wherein a second pixel circuit column of the plurality of second pixel circuit columns comprises a plurality of second pixel circuits arranged along the first direction, a second pixel circuit row of the plurality of second pixel circuit rows comprises a plurality of second pixel circuits arranged along the second direction, and the second pixel circuit column is electrically connected to a same data signal line;
the display panel further comprises a plurality of second light-emitting element columns and a plurality of second light-emitting element rows, a second light-emitting element column of the plurality of second light-emitting element columns comprises a plurality of light-emitting elements of a third color arranged along the first direction, a second light-emitting element row of the plurality of second light-emitting element rows comprises a plurality of light-emitting elements of the third color arranged along the second direction, and an emission color of a light-emitting element of the third color of the plurality of light-emitting elements of the third color is different from the emission color of the light-emitting element of the first color and the emission color of the light-emitting element of the second color; and
the plurality of second pixel circuits in a same second pixel circuit column are electrically connected to the plurality of light-emitting elements of the third color in a same second light-emitting element column, and the plurality of second pixel circuits in a same second pixel circuit row are electrically connected to the plurality of light-emitting elements of the third color in a same second light-emitting element row.

24. The display panel according to claim 23, wherein
along the first direction, the plurality of first light-emitting element rows and the plurality of second light-emitting element rows are alternately arranged; and
along the second direction, the plurality of first light-emitting element columns and the plurality of second light-emitting element columns are alternately arranged.

25. The display panel according to claim 23, wherein a plurality of the light-emitting elements of the first color and a plurality of the light-emitting elements of the second color form a first virtual quadrilateral, the light-emitting element of the first color is located at a first vertex of the first virtual quadrilateral, the light-emitting element of the second color is located at a second vertex of the first virtual quadrilateral, and the light-emitting element of the third color is located inside the first virtual quadrilateral;
a plurality of the light-emitting elements of the third color form a second virtual quadrilateral, the plurality of the light-emitting elements are located at vertices of the second virtual quadrilateral, respectively, and the light-emitting element of the first color or the light-emitting element of the second color is located inside the second virtual quadrilateral;
the light-emitting element of the first color comprises one of a red light-emitting element and a blue light-emitting element, and the light-emitting element of the second color comprises the other of the red light-emitting element and the blue light-emitting element; and
the light-emitting element of the third color comprises a green light-emitting element.

26. The display panel according to claim 1, further comprising a display region and a non-display region at least partially surrounding the display region, wherein the display region comprises a first display region and a second display region, the second display region is located on at least one side of the first display region along the second direction, the first display region and the second display region each comprise a plurality of the data signal lines, the non-display region comprises a fan-out region located on a side of the display region along the first direction, and the fan-out region comprises a plurality of fan-out lines; and
the display panel further comprises a data auxiliary line at least located in the display region, and the data signal line located in the second display region is electrically connected to the fan-out line through the data auxiliary line.

27. The display panel according to claim 26, wherein the data auxiliary line comprises a first auxiliary segment, and the first auxiliary segment extends along the first direction and is electrically connected to the fan-out line;
the light-emitting element comprises a light-emitting element of a first color and a light-emitting element of a second color with different emission colors, and the light-emitting element of the first color or the light-emitting element of the second color comprises a third virtual symmetry axis extending along the first direction;
the light-emitting element further comprises an anode, the anode comprises an anode body portion, the display panel further comprises a pixel definition layer and a plurality of pixel openings in the pixel definition layer; along a thickness direction of the display panel, the anode body portion overlaps with a pixel opening of the plurality of pixel openings, and an anode body portion of the light-emitting element of the first color or an anode body portion of the light-emitting element of the second color is symmetrically arranged with respect to the third virtual symmetry axis of the light-emitting element of the first color including the anode body portion or the light-emitting element of the second color including the anode body portion; and
the display panel further comprises a substrate, and orthographic projections of two first auxiliary segments overlapping with a same anode body portion on a plane of the substrate are symmetric with respect to an orthographic projection of the third virtual symmetry axis of the light-emitting element of the first color or the light-emitting element of the second color including the same anode body portion on the plane of the substrate.

28. The display panel according to claim 27, wherein along the thickness direction of the display panel, among two first auxiliary segments and two data signal lines overlapping with a same anode body portion, for a first auxiliary segment and a data signal line located on a same side of the third virtual symmetry axis, the data signal line is located on a side of the first auxiliary segment close to the third virtual symmetry axis.

29. The display panel according to claim 27, wherein along the thickness direction of the display panel, among two first auxiliary segments and two data signal lines overlapping with a same anode body portion, for a first auxiliary segment and a data signal line located on a same side of the third virtual symmetry axis, the data signal line is located on a side of the first auxiliary segment away from the third virtual symmetry axis.

30. A display device, comprising the display panel according to any one of claims 1 to 29.
